# EUROPEAN PATENT SPECIFICATION

(11) **EP 4 514 100 B1**
(45) Date of publication and mention of the grant of the patent: **24.12.2025**
(21) Application number: 24194525.2
(22) Date of filing: 14.08.2024
(51) Int. Cl.: H10K 50/11, H10K 85/40, H10K 85/60

(54) **ORGANIC COMPOUNDS AND ORGANIC LIGHT-EMITTING DEVICE COMPRISING THE SAME**
ORGANISCHE VERBINDUNGEN UND ORGANISCHE LICHTEMITTIERENDE VORRICHTUNG DAMIT
COMPOSÉS ORGANIQUES ET DISPOSITIF ÉLECTROLUMINESCENT ORGANIQUE LES COMPRENANT

(30) Priority: 21.08.2023 KR 20230109103; 26.04.2024 KR 20240055882
(43) Date of publication of application: 26.02.2025
(73) Proprietor: SFC Co., Ltd., Cheongju-si, Chungcheongbuk-do 28122 (KR)
(72) Inventor: KIM, Kyeong-hyeon, 28122 Cheongju-si (KR); KIM, Si-in, 28122 Cheongju-si (KR); JANG, Hyuk-woo, 28122 Cheongju-si (KR); CHOI, Do-yeong, 28122 Cheongju-si (KR); PARK, Seo-youn, 28122 Cheongju-si (KR); CHOI, Yeon-jae, 28122 Cheongju-si (KR); KIM, Kyeong-wan, 28122 Cheongju-si (KR); LEE, Se-jin, 28122 Cheongju-si (KR)
(74) Representative: Grosse, Felix Christopher

(56) References cited:
- WO-A1-2023/277645
- US-A1- 2021 210 696

## Description

### [ Technical Field ]

The present invention relates to an organic compound employed in a light emitting layer of an organic light emitting device and an organic light emitting device including the organic compound.

### [ Background Art ]

Organic light emitting devices are self-luminous devices in which electrons injected from an electron injecting electrode (cathode) recombine with holes injected from a hole injecting electrode (anode) in a light emitting layer to form excitons, which emit light while releasing energy. Such organic light emitting devices have the advantages of low driving voltage, high luminance, large viewing angle, and short response time and can be applied to full-color light emitting flat panel displays. Due to these advantages, organic light emitting devices have received attention as next-generation light sources.

The above characteristics of organic light emitting devices are achieved by structural optimization of organic layers of the devices and are supported by stable and efficient materials for the organic layers, such as hole injecting materials, hole transport materials, light emitting materials, electron transport materials, electron injecting materials, and electron blocking materials. However, more research still needs to be done to develop structurally optimized structures of organic layers for organic light emitting devices and stable and efficient materials for organic layers of organic light emitting devices.

Particularly, for maximum efficiency in a light emitting layer, an appropriate combination of energy band gaps of a host and a dopant is required such that holes and electrons migrate to the dopant through stable electrochemical paths to form excitons.

The documents WO 2023/277645 A1 and US 2021/210696 A1 are concerning organic light emitting diodes comprising a triazine derivative substituted with at least two carbazole moieties in the emission layer.

### [ Detailed Description of the Invention ]

### [ Problems to be Solved by the Invention ]

Therefore, the present invention is intended to provide a light emitting layer host material having a characteristic structure, and a high-efficiency and long-lifetime organic light emitting device enabling low voltage driving and having significantly improved lifetime and luminous efficiency by including the same.

### [ Means for Solving the Problems ]

One aspect of the present invention provides an organic compound represented by the following [Formula 1], and an organic light emitting device including the same as a host in a light emitting layer.

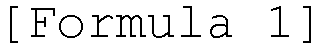

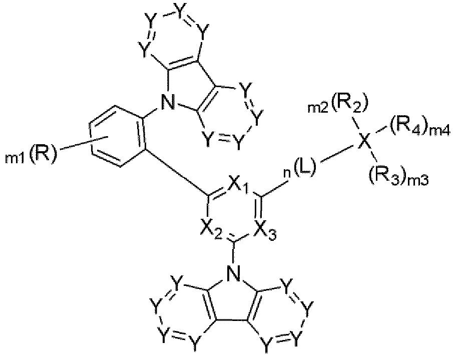

Specific structures of [Formula 1], specific compounds according to the present invention obtained therefrom, and a definition of each substituent will be described later.

### [ Means for Solving the Problems ]

The present invention relates to an organic compound employed in a light emitting layer in an organic light emitting device, and an organic light emitting device including the same. When the compound according to the present invention is employed as a host of a light emitting layer, an organic light emitting device enabling low voltage driving, and having high efficiency and long lifetime can be obtained, which is useful for not only lighting devices but also a variety of display devices such as flat panel displays, flexible displays, wearable displays, and displays for virtual or augmented reality.

### [ Best Mode for Carrying out the Invention ]

Hereinafter, the present invention will be described in more detail.

One aspect of the present invention relates to a compound represented by the following [Formula 1].

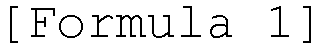

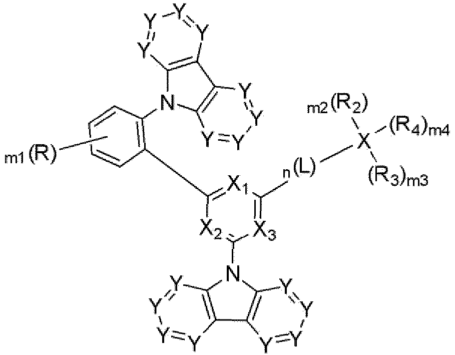

In [Formula 1],
X is Si or Ge, and according to one embodiment of the present invention, X may be Ge.

X₁ to X₃ are the same as or different from each other, and each independently N or CR₁, and at least one of X₁ to X₃ is N.

According to one embodiment of the present invention, all of X₁ to X₃ may each be N.

Ys are the same as or different from each other, and each independently N or CR₅, and according to one embodiment of the present invention, all of Ys may each be CR₅, and each of R₅s may be deuterium.

R₂ to R₄ are the same as or different from each other, and each independently selected from substituted or unsubstituted C₁-C₃₀ alkyl, substituted or unsubstituted C₂-C₃₀ alkynyl, substituted or unsubstituted C₂-C₃₀ alkenyl, substituted or unsubstituted C₆-C₅₀ aryl, substituted or unsubstituted C₃-C₅₀ cycloalkyl, substituted or unsubstituted C₂-C₅₀ heterocycloalkyl, substituted or unsubstituted C₂-C₅₀ heteroaryl, and substituted or unsubstituted cyclic groups in which a C₃-C₃₀ aliphatic ring and a C₅-C₃₀ aromatic ring are fused together.

According to one embodiment of the present invention, R₂ to R₄ are the same as or different from each other, and may be each independently selected from C₆-C₂₀ aryl unsubstituted or substituted with deuterium, C₅-C₂₀ heteroaryl unsubstituted or substituted with deuterium, and cyclic groups unsubstituted or substituted with deuterium in which a C₃-C₁₈ aliphatic ring and a C₅-C₁₈ aromatic ring are fused together.

R, R₁ and R₅ are the same as or different from each other, and each independently selected from hydrogen, deuterium, substituted or unsubstituted C₁-C₃₀ alkyl, substituted or unsubstituted C₂-C₃₀ alkynyl, substituted or unsubstituted C₂-C₃₀ alkenyl, substituted or unsubstituted C₆-C₅₀ aryl, substituted or unsubstituted C₃-C₅₀ cycloalkyl, substituted or unsubstituted C₂-C₅₀ heterocycloalkyl, substituted or unsubstituted C₂-C₅₀ heteroaryl, substituted or unsubstituted cyclic groups in which a C₃-C₃₀ aliphatic ring and a C₅-C₃₀ aromatic ring are fused together, substituted or unsubstituted C₁-C₃₀ alkoxy, substituted or unsubstituted C₆-C₃₀ aryloxy, substituted or unsubstituted C₁-C₃₀ alkylthioxy, substituted or unsubstituted C₅-C₃₀ arylthioxy, substituted or unsubstituted amine, substituted or unsubstituted silyl, substituted or unsubstituted germanium, nitro, cyano and halogen.

According to one embodiment of the present invention, Rs are the same as or different from each other, and may be each independently hydrogen or deuterium.

Ls are the same as or different from each other, and each independently a single bond, or selected from substituted or unsubstituted C₆-C₃₀ arylene, substituted or unsubstituted C₂-C₃₀ heteroarylene, and substituted or unsubstituted divalent cyclic groups in which a C₃-C₂₄ aliphatic ring and a C₅-C₂₄ aromatic ring are fused together.

n is an integer of 1 to 3**,** and when n is an integer of 2 or greater, Ls are the same as or different from each other.

According to one embodiment of the present invention, n is an integer of 1, and L may be C₆-C₂₀ arylene unsubstituted or substituted with deuterium.

m₁ is an integer of 4**,** and Rs are the same as or different from each other.

m₂ to m₄ are the same as or different from each other and each an integer of 1 to 3, and when m₂ to m₄ are each an integer of 2 or greater, R₂s to R₄s are the same as or different from each other.

The plurality of adjacent Rs and R₅s are optionally linked to each other to further form an alicyclic or aromatic monocyclic or polycyclic ring.

In addition, the term 'substituted' in the 'substituted or unsubstituted' in [Formula 1] means being substituted with one or more substituents selected from the group consisting of deuterium, C₁-C₂₄ alkyl, C₁-C₂₄ haloalkyl, C₂-C₂₄ alkenyl, C₂-C₂₄ alkynyl, C₃-C₃₀ cycloalkyl, C₁-C₂₄ heteroalkyl, C₆-C₃₀ aryl, C₇-C₃₀ arylalkyl, C₇-C₃₀ alkylaryl, C₂-C₃₀ heteroaryl, C₂-C₃₀ heteroarylalkyl, cyclic groups in which a C₃-C₂₄ aliphatic ring and a C₅-C₂₄ aromatic ring are fused together, C₁-C₂₄ alkoxy, C₁-C₃₀ amine, C₁-C₃₀ silyl, C₁-C₃₀ germanium, C₆-C₂₄ aryloxy, C₆-C₂₄ arylthionyl, cyano, halogen, hydroxyl and nitro, and when there are two or more substituents, they are the same as or different from each other, and one or more hydrogen atoms in each of the substituents are optionally substituted with deuterium atoms.

In addition, the term 'substituted' in the 'substituted or unsubstituted' means being substituted with one or more substituents, which are the same as or different from each other, selected from the group consisting of deuterium, cyano, halogen, hydroxyl, nitro, C₁-C₂₄ alkyl, C₁-C₂₄ haloalkyl, C₁-C₂₄ alkenyl, C₁-C₂₄ alkynyl, C₃-C₃₀ cycloalkyl, C₁-C₂₄ heteroalkyl, C₆-C₂₄ aryl, C₆-C₃₀ arylalkyl, C₇-C₃₀ alkylaryl, C₂-C₃₀ heteroaryl, C₂-C₃₀ heteroarylalkyl, cyclic groups in which a C₃-C₃₀ aliphatic ring and a C₅-C₃₀ aromatic ring are fused together, C₁-C₂₄ alkoxy, C₁-C₃₀ amine, C₁-C₃₀ silyl, C₁-C₃₀ germanium, C₁-C₂₄ aryloxy and C₆-C₂₄ arylthionyl, and one or more hydrogen atoms in each of the substituents are optionally substituted with deuterium atoms.

Another aspect of the present invention relates to an organic light emitting device including: a first electrode; a second electrode; and one or more organic layers interposed between the first electrode and the second electrode, wherein the compound represented by [Formula 1] defined above is included in the organic layer, preferably as a host of a light emitting layer including a host and a dopant.

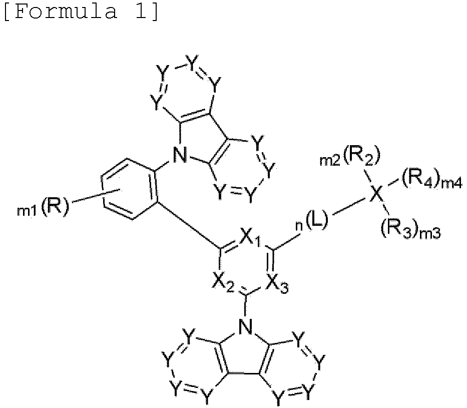

In addition, the light emitting layer has a structure formed with a host and a dopant, and the light emitting layer may further include a dopant material. Herein, the content of the dopant may be typically selected in a range of about 0.01 parts by weight to about 20 parts by weight based on about 100 parts by weight of the host, however, the content is not limited thereto.

In the present invention, the dopant compound included in the light emitting layer is not a fluorescent dopant material transferred only to a singlet state using a Forster energy transfer method in an existing host-dopant system, but includes a phosphorescent dopant material of a metal complex including at least one metal selected from Ir, Pt, Os, Ti, Zr, Hf, Eu, Tb, Tm, Fe, Co, Ni, Ru, Rh, Re, Pd and the like using a Dexter energy transfer method transferred to singlet and triplet states without distinguishing the states, and known dopant materials may be used without particular limit as long as they emit light from triplet excitons.

Ir, Pt, Pd and the like may be preferably selected as the metal complex, and specific examples thereof include, but are not limited to, Ir(ppy)₃, Ir(ppy)₂acac, Ir(Bt)₂acac, Ir(MDQ)₂acac, Ir(mppy)₃, Ir(piq)₃, Ir(piq)₂acac, Ir(pq)₂acac, Ir(mpp)₂acac, F₂Irpic, (F₂ppy)₂Ir(tmd), Ir(ppy)₂tmd, Ir(pmi)₃, Ir(pmb)₃, FCNIr, FCNIrpic, FIr₆, FIrN₄, FIrpic, PtOEP, Ir(chpy)₃, P0-01(C₃₁H₂₃IrN₂O₂S₂), Ir(ppz)₃, Ir(dfppz)₃, PtNON, Pt-10, Pt-11 and the like.

In addition, the light emitting layer may further include various host and dopant materials in addition to the host and dopant compounds according to the present invention, and accordingly, in the light emitting layer, one or more types of compounds different from each other may be mixed or stacked and used as the dopant material as well as the host.

In the organic light emitting device according to one embodiment of the present invention, the organic layer interposed between the first electrode and the second electrode includes a light emitting layer, and, by the host in the light emitting layer further including one or more types of additional host compounds in addition to one type of the compound represented by [Formula 1], two or more types of host compounds may be mixed or stacked and used.

Herein, when two or more types of host compounds are mixed or stacked and used by further including one or more types of additional host compounds in addition to one type of the compound represented by [Formula 1], a compound having an electron donor moiety may be used as the additional host. High HOMO/LUMO levels of hole injection and electron injection barriers obtained by mixing or stacking the additional host with the compound represented by [Formula 1] having an azine moiety that is a nitrogen-containing aromatic heterocyclic ring, an electron acceptor moiety, limit the recombination zone to the interface between the two hosts, and due to the resulting advantage of minimizing a current loss, and the like, an organic light emitting device having high efficiency and long lifetime may be obtained.

Herein, the compound having an electron donor moiety is a compound having a moiety provided with an environment in which electrons are readily donated from the outside, such as a compound having an amine group in the molecule and a compound substituted with carbazole, and the compound having an electron donor moiety may preferably include a compound including an aromatic hydrocarbon ring including tertiary amine in the molecule; or an aromatic hydrocarbon ring including carbazole and bicarbazole in the molecule.

More specifically, as the host in the light emitting layer of the organic light emitting device according to the present invention, one or more types of organic compounds represented by the following [Formula 3] may be mixed in addition to the compound represented by [Formula 1], or a compound represented by the following [Formula 3] may be stacked above or below the layer including the compound represented by [Formula 1].

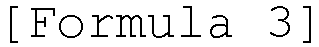

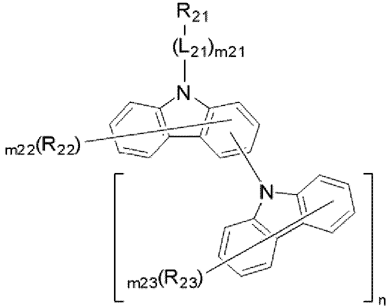

In [Formula 3],
L₂₁s are each independently a single bond, or any one selected from substituted or unsubstituted C₆-C₃₀ arylene, substituted or unsubstituted C₂-C₃₀ heteroarylene, and substituted or unsubstituted divalent cyclic groups in which a C₃-C₂₄ aliphatic ring and a C₅-C₂₄ aromatic ring are fused together.

R₂₁ to R₂₃ are the same as or different from each other, and each independently any one selected from hydrogen, deuterium, substituted or unsubstituted C₁-C₃₀ alkyl, substituted or unsubstituted C₂-C₃₀ alkynyl, substituted or unsubstituted C₂-C₃₀ alkenyl, substituted or unsubstituted C₆-C₅₀ aryl, substituted or unsubstituted C₃-C₅₀ cycloalkyl, substituted or unsubstituted C₂-C₅₀ heterocycloalkyl, substituted or unsubstituted C₂-C₅₀ heteroaryl, substituted or unsubstituted cyclic groups in which a C₃-C₃₀ aliphatic ring and a C₅-C₃₀ aromatic ring are fused together, substituted or unsubstituted C₁-C₃₀ alkoxy, substituted or unsubstituted C₆-C₃₀ aryloxy, substituted or unsubstituted C₁-C₃₀ alkylthioxy, substituted or unsubstituted C₅-C₃₀ arylthioxy, substituted or unsubstituted amine, substituted or unsubstituted silyl, substituted or unsubstituted germanium, nitro, cyano and halogen.

m₂₁ is an integer of 1 or 2, and when m₂₁ is an integer of 2, L₂₁s are the same as or different from each other.

m₂₂ is an integer of 7 or 8, and R₂₂s are the same as or different from each other.

m₂₃ is an integer of 8, and R₂₃s are the same as or different from each other.

n is an integer of 0 or 1.

The term 'substituted' in the 'substituted or unsubstituted' in [Formula 3] means being substituted with one or more substituents selected from the group consisting of deuterium, C₁-C₂₄ alkyl, C₁-C₂₄ haloalkyl, C₂-C₂₄ alkenyl, C₂-C₂₄ alkynyl, C₃-C₃₀ cycloalkyl, C₁-C₂₄ heteroalkyl, C₆-C₃₀ aryl, C₇-C₃₀ arylalkyl, C₇-C₃₀ alkylaryl, C₂-C₃₀ heteroaryl, C₂-C₃₀ heteroarylalkyl, cyclic groups in which a C₃-C₂₄ aliphatic ring and a C₅-C₂₄ aromatic ring are fused together, C₁-C₂₄ alkoxy, C₁-C₃₀ amine, C₁-C₃₀ silyl, C₁-C₃₀ germanium, C₆-C₂₄ aryloxy, C₃-C₂₄ arylthionyl, cyano, halogen, hydroxyl and nitro, and when there are two or more substituents, they are the same as or different from each other, and one or more hydrogen atoms in each of the substituents are optionally substituted with deuterium atoms.

In addition, the light emitting layer may further include various host and dopant materials in addition to the dopant and the host.

In addition, the organic layer of the organic light emitting device according to the present invention may be formed in a single layer structure, but may be formed in a multilayer structure in which two or more organic layers are stacked. For example, the organic layer may have a structure including a hole injecting layer, a hole transport layer, a hole blocking layer, a light emitting layer, an electron blocking layer, an electron transport layer, an electron injecting layer and the like. However, the structure is not limited thereto, and may also include a smaller or larger number of organic layers, and a preferred organic layer structure of the organic light emitting device according to the present invention will be described in more detail in examples to be described later.

In addition, according to one embodiment of the present invention, the dopant may include at least one organometallic compound, and a polycyclic compound represented by the following [Formula 2] may be mixed or stacked and used in addition to the organometallic compound.

Accordingly, in the organic light emitting device according to one embodiment of the present invention, the light emitting layer may be formed by including a first host, a second host, an organometallic compound and a polycyclic compound of the following [Formula 2] (thermally activated delayed boron-based fluorescent material).

The organometallic compound functions as a sensitizer and the polycyclic compound functions as a light emitting dopant. The sensitizer compound receives excitons from the first host and the second host and transfers the excitons to the light emitting dopant.

Accordingly, excitons are transferred from the sensitizer to the light emitting dopant compound through the Dexter energy transfer (DET) or Forster resonance transfer (FRET) mechanism, and the exciton energy delivered to the light emitting dopant compound is transferred to the ground state. In this process, the energy is emitted as light. The excitons can be transferred from the first and second hosts to the sensitizer through the FRET or DET mechanism.

In conclusion, the FRET or DET mechanism facilitates energy transfer between the sensitizer and the light emitting dopant and suppresses triplet-triplet annihilation, ensuring high efficiency of the organic light emitting device.

Forster energy transfer from the triplet of the phosphorescence sensitizer to the singlet of the polycyclic compound (thermally activated delayed boron-based fluorescent material) represented by Formula 2, contributes to a reduction in the number of long-lived triplet excitons involved in the degradation of the device, ensuring long lifetime of the device.

In addition, the high molar extinction coefficient of the polycyclic compound ensures fast fluorescence resonance energy transfer from the phosphorescence sensitizer to the fluorescent material and the multiple resonance effect of the polycyclic compound narrows the emission spectrum to increase the color purity of the device, achieving improved efficiency and lifetime of the device.

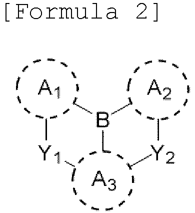

In [Formula 2],
Y₁ and Y₂ are the same as or different from each other, and each independently any one selected from O, S, NR₁₁, CR₁₂R₁₃, SiR₁₄R₁₅ and GeR₁₆R₁₇.

A₁ to A₃ are the same as or different from each other, and each independently any one selected from substituted or unsubstituted C₆-C₃₀ aromatic hydrocarbon rings, substituted or unsubstituted C₃-C₃₀ aliphatic hydrocarbon rings, substituted or unsubstituted C₂-C₃₀ aromatic heterocyclic rings, substituted or unsubstituted C₂-C₃₀ aliphatic heterocyclic rings, and substituted or unsubstituted cyclic groups in which a C₃-C₂₄ aliphatic ring and a C₅-C₂₄ aromatic ring are fused together.

R₁₁ to R₁₇ are the same as or different from each other, and each independently any one selected from hydrogen, deuterium, substituted or unsubstituted C₁-C₃₀ alkyl, substituted or unsubstituted C₂-C₃₀ alkynyl, substituted or unsubstituted C₂-C₃₀ alkenyl, substituted or unsubstituted C₆-C₅₀ aryl, substituted or unsubstituted C₃-C₅₀ cycloalkyl, substituted or unsubstituted C₂-C₅₀ heterocycloalkyl, substituted or unsubstituted C₂-C₅₀ heteroaryl, substituted or unsubstituted cyclic groups in which a C₃-C₃₀ aliphatic ring and a C₅-C₃₀ aromatic ring are fused together, substituted or unsubstituted C₁-C₃₀ alkoxy, substituted or unsubstituted C₆-C₃₀ aryloxy, substituted or unsubstituted C₁-C₃₀ alkylthioxy, substituted or unsubstituted C₅-C₃₀ arylthioxy, substituted or unsubstituted amine, substituted or unsubstituted silyl, substituted or unsubstituted germanium, nitro, cyano and halogen.

R₁₁ to R₁₇ are optionally linked to the rings A₁ to A₃ to further form an alicyclic or aromatic monocyclic or polycyclic ring.

R₁₂ and R₁₃, R₁₄ and R₁₅, and R₁₆ and R₁₇ are optionally linked to each other to further form an alicyclic or aromatic monocyclic or polycyclic ring.

The term 'substituted' in the 'substituted or unsubstituted' in [Formula 2] means being substituted with one or more substituents selected from the group consisting of deuterium, C₁-C₂₄ alkyl, C₁-C₂₄ haloalkyl, C₂-C₂₄ alkenyl, C₂-C₂₄ alkynyl, C₃-C₃₀ cycloalkyl, C₁-C₂₄ heteroalkyl, C₆-C₃₀ aryl, C₇-C₃₀ arylalkyl, C₇-C₃₀ alkylaryl, C₂-C₃₀ heteroaryl, C₂-C₃₀ heteroarylalkyl, cyclic groups in which a C₃-C₂₄ aliphatic ring and a C₅-C₂₄ aromatic ring are fused together, C₁-C₂₄ alkoxy, C₁-C₃₀ amine, C₁-C₃₀ silyl, C₁-C₃₀ germanium, C₆-C₂₄ aryloxy, C₅-C₂₄ arylthionyl, cyano, halogen, hydroxyl and nitro, and when there are two or more substituents, they are the same as or different from each other, and one or more hydrogen atoms in each of the substituents are optionally substituted with deuterium atoms.

In the "substituted or unsubstituted C₁-C₃₀ alkyl", "substituted or unsubstituted C₆-C₅₀ aryl" and the like in the present invention, the number of carbon atoms in the alkyl or aryl group indicates the number of carbon atoms constituting the unsubstituted alkyl or aryl moiety without considering the number of carbon atoms in the substituent(s). For example, a phenyl group substituted with a butyl group at the para-position corresponds to a C₆ aryl group substituted with a C₄ butyl group.

As used herein, the expression "optionally linked to each other or an adjacent group to form a ring" means that the corresponding adjacent substituents are bonded to each other or each of the corresponding substituents is bonded to an adjacent group to form a substituted or unsubstituted alicyclic or aromatic ring. The term "adjacent group" may mean a substituent on an atom directly attached to an atom substituted with the corresponding substituent, a substituent disposed sterically closest to the corresponding substituent or another substituent on an atom substituted with the corresponding substituent. For example, two substituents substituted at the ortho position of a benzene ring or two substituents on the same carbon in an aliphatic ring may be considered "adjacent" to each other. Optionally, the paired substituents each lose one hydrogen radical and are linked to each other to form a ring. The carbon atoms in the resulting alicyclic, aromatic mono- or polycyclic ring may be replaced by one or more heteroatoms such as O, S, N, P, Si, and Ge.

In the present invention, the alkyl groups may be straight or branched. Specific examples of the alkyl groups include, but are not limited to, methyl, ethyl, propyl, n-propyl, isopropyl, butyl, n-butyl, isobutyl, tert-butyl, sec-butyl, 1-methylbutyl, 1-ethylbutyl, pentyl, n-pentyl, isopentyl, neopentyl, tert-pentyl, hexyl, n-hexyl, 1-methylpentyl, 2-methylpentyl, 4-methyl-2-pentyl, 3,3-dimethylbutyl, 2-ethylbutyl, heptyl, n-heptyl, 1-methylhexyl, cyclopentylmethyl, cyclohexylmethyl, octyl, n-octyl, tert-octyl, 1-methylheptyl, 2-ethylhexyl, 2-propylpentyl, n-nonyl, 2,2-dimethylheptyl, 1-ethylpropyl, 1,1-dimethylpropyl, isohexyl, 2-methylpentyl, 4-methylhexyl, and 5-methylhexyl groups.

In the present invention, specific examples of the arylalkyl groups include, but are not limited to, phenylmethyl(benzyl), phenylethyl, phenylpropyl, naphthylmethyl, and naphthylethyl.

In the present invention, specific examples of the alkylaryl groups include, but are not limited to, tolyl, xylenyl, dimethylnaphthyl, t-butylphenyl, t-butylnaphthyl, and t-butylphenanthryl.

The alkenyl group is intended to include straight and branched ones and may be optionally substituted with one or more other substituents. The alkenyl group may be specifically a vinyl, 1-propenyl, isopropenyl, 1-butenyl, 2-butenyl, 3-butenyl, 1-pentenyl, 2-pentenyl, 3-pentenyl, 3-methyl-1-butenyl, 1,3-butadienyl, allyl, 1-phenylvinyl-1-yl, 2-phenylvinyl-1-yl, 2,2-diphenylvinyl-1-yl, 2-phenyl-2-(naphthyl-1-yl)vinyl-1-yl, 2,2-bis(diphenyl-1-yl)vinyl-1-yl, stilbenyl or styrenyl group but is not limited thereto.

The alkynyl group is intended to include straight and branched ones and may be optionally substituted with one or more other substituents. The alkynyl group may be, for example, ethynyl or 2-propynyl but is not limited thereto.

The cycloalkenyl group is a non-aromatic cyclic unsaturated hydrocarbon group having one or more carbon-carbon double bonds. The cycloalkenyl group may be, for example, cyclopropenyl, cyclobutenyl, cyclopentenyl, cyclohexenyl, cycloheptenyl, 1,3-cyclohexadienyl, 1,4-cyclohexadienyl, 2,4-cycloheptadienyl or 1,5-cyclooctadienyl but is not limited thereto.

The aromatic hydrocarbon rings or aryl groups may be monocyclic or polycyclic ones. As used herein, the term "polycyclic" means that the aromatic hydrocarbon ring may be directly attached or fused to one or more other cyclic groups. The other cyclic groups may be aromatic hydrocarbon rings and other examples thereof include aliphatic heterocyclic rings, aliphatic hydrocarbon rings, and aromatic heterocyclic rings. Examples of the monocyclic aryl groups include, but are not limited to, phenyl, biphenyl, and terphenyl. Examples of the polycyclic aryl groups include naphthyl, anthracenyl, phenanthrenyl, pyrenyl, perylenyl, tetracenyl, chrysenyl, fluorenyl, acenaphathcenyl, triphenylene, and fluoranthrene groups but the scope of the present invention is not limited thereto.

The aromatic heterocyclic rings or heteroaryl groups refer to aromatic groups containing one or more heteroatoms such as O, S, N, P, Si, and Ge. Examples of the aromatic heterocyclic rings or heteroaryl groups include, but are not limited to, thiophene, furan, pyrrole, imidazole, thiazole, oxazole, oxadiazole, triazole, pyridyl, bipyridyl, pyrimidyl, triazine, triazole, acridyl, pyridazine, pyrazinyl, quinolinyl, quinazoline, quinoxalinyl, phthalazinyl, pyridopyrimidinyl, pyridopyrazinyl, pyrazinopyrazinyl, isoquinoline, indole, carbazole, benzoxazole, benzimidazole, benzothiazole, benzocarbazole, benzothiophene, dibenzothiophene, benzofuranyl, dibenzofuranyl, phenanthroline, thiazolyl, isoxazolyl, oxadiazolyl, thiadiazolyl, benzothiazolyl, and phenothiazinyl groups.

The aliphatic hydrocarbon rings or cycloalkyl groups refer to non-aromatic rings consisting only of carbon and hydrogen atoms. The aliphatic hydrocarbon ring is intended to include monocyclic and polycyclic ones and may be optionally substituted with one or more other substituents. As used herein, the term "polycyclic" means that the aliphatic hydrocarbon ring may be directly attached or fused to one or more other cyclic groups. The other cyclic groups may be aliphatic hydrocarbon rings and other examples thereof include aliphatic heterocyclic, aryl, and heteroaryl groups. Specific examples of the aliphatic hydrocarbon rings include, but are not limited to, cycloalkyl groups such as cyclopropyl, cyclobutyl, cyclopentyl, adamantyl, 3-methylcyclopentyl, 2,3-dimethylcyclopentyl, cyclohexyl, 3-methylcyclohexyl, 4-methylcyclohexyl, 2,3-dimethylcyclohexyl, 3,4,5-trimethylcyclohexyl, 4-tert-butylcyclohexyl, cycloheptyl, and cyclooctyl, cycloalkanes such as cyclohexane and cyclopentane, and cycloalkenes such as cyclohexene and cyclobutene.

The aliphatic heterocyclic rings or heterocycloalkyl groups refer to aliphatic rings containing one or more heteroatoms such as O, S, Se, N, Si and Ge. The aliphatic heterocyclic ring is intended to include monocyclic or polycyclic ones and may be optionally substituted with one or more other substituents. As used herein, the term "polycyclic" means that the aliphatic heterocyclic ring such as heterocycloalkyl, heterocycloalkane or heterocycloalkene may be directly attached or fused to one or more other cyclic groups. The other cyclic groups may be aliphatic heterocyclic rings and other examples thereof include aliphatic hydrocarbon rings, aryl groups, and heteroaryl groups.

The cyclic groups in which an aliphatic ring and an aromatic ring are fused together refers to mixed aliphatic-aromatic cyclic groups in which at least one aliphatic ring and at least one aromatic ring are linked and fused together and which are overall non-aromatic. More specifically, the cyclic groups in which an aliphatic ring and an aromatic ring are fused together may be an aromatic hydrocarbon cyclic group fused with an aliphatic hydrocarbon ring, an aromatic hydrocarbon cyclic group fused with an aliphatic heterocyclic ring, an aromatic heterocyclic group fused with an aliphatic hydrocarbon ring, an aromatic heterocyclic group fused with an aliphatic heterocyclic ring, an aliphatic hydrocarbon cyclic group fused with an aromatic hydrocarbon ring, an aliphatic hydrocarbon cyclic group fused with an aromatic hydrocarbon ring, an aliphatic heterocyclic group fused with an aromatic hydrocarbon ring, and an aliphatic heterocyclic group fused with an aromatic heterocyclic ring. Specific examples of the cyclic groups in which an aliphatic ring and an aromatic ring are fused together include tetrahydronaphthyl, tetrahydrobenzocycloheptene, tetrahydrophenanthrene, tetrahydroanthracenyl, octahydrotriphenylene, tetrahydrobenzothiophene, tetrahydrobenzofuranyl, tetrahydrocarbazole, and tetrahydroquinoline. The cyclic groups in which an aliphatic ring and an aromatic ring are fused together may be interrupted by at least one heteroatom other than carbon. The heteroatom may be, for example, O, S, N, P, Si or Ge.

The alkoxy group may be specifically a methoxy, ethoxy, propoxy, isobutyloxy, sec-butyloxy, pentyloxy, iso-amyloxy or hexyloxy group but is not limited thereto.

The silyl group is intended to include -SiH₃, alkylsilyl, arylsilyl, alkylarylsilyl, arylheteroarylsilyl, and heteroarylsilyl. The arylsilyl refers to a silyl group obtained by substituting one, two or three of the hydrogen atoms in -SiH₃ with aryl groups. The alkylsilyl refers to a silyl group obtained by substituting one, two or three of the hydrogen atoms in -SiH₃ with alkyl groups. The alkylarylsilyl refers to a silyl group obtained by substituting one of the hydrogen atoms in -SiH₃ with an alkyl group and the other two hydrogen atoms with aryl groups or substituting two of the hydrogen atoms in -SiH₃ with alkyl groups and the remaining hydrogen atom with an aryl group. The arylheteroarylsilyl refers to a silyl group obtained by substituting one of the hydrogen atoms in -SiH₃ with an aryl group and the other two hydrogen atoms with heteroaryl groups or substituting two of the hydrogen atoms in -SiH₃ with aryl groups and the remaining hydrogen atom with a heteroaryl group. The heteroarylsilyl refers to a silyl group obtained by substituting one, two or three of the hydrogen atoms in -SiH₃ with heteroaryl groups. The arylsilyl group may be, for example, substituted or unsubstituted monoarylsilyl, substituted or unsubstituted diarylsilyl, or substituted or unsubstituted triarylsilyl. The same applies to the alkylsilyl and heteroarylsilyl groups.

Each of the aryl groups in the arylsilyl, heteroarylsilyl, and arylheteroarylsilyl groups may be a monocyclic or polycyclic one. Each of the heteroaryl groups in the arylsilyl, heteroarylsilyl, and arylheteroarylsilyl groups may be a monocyclic or polycyclic one.

Specific examples of the silyl groups include trimethylsilyl, triethylsilyl, triphenylsilyl, trimethoxysilyl, dimethoxyphenylsilyl, diphenylmethylsilyl, diphenylvinylsilyl, methylcyclobutylsilyl, and dimethylfurylsilyl. One or more of the hydrogen atoms in each of the silyl groups may be substituted with the substituents mentioned in the aryl groups.

The amine group is intended to include -NH₂, alkylamine, arylamine, arylheteroarylamine, and heteroarylamine. The arylamine refers to an amine group obtained by substituting one or two of the hydrogen atoms in -NH₂ with aryl groups. The alkylamine refers to an amine group obtained by substituting one or two of the hydrogen atoms in -NH₂ with alkyl groups. The alkylarylamine refers to an amine group obtained by substituting one of the hydrogen atoms in -NH₂ with an alkyl group and the other hydrogen atom with an aryl group. The arylheteroarylamine refers to an amine group obtained by substituting one of the hydrogen atoms in -NH₂ with an aryl group and the other hydrogen atom with a heteroaryl group. The heteroarylamine refers to an amine group obtained by substituting one or two of the hydrogen atoms in -NH₂ with heteroaryl groups. The arylamine may be, for example, substituted or unsubstituted monoarylamine, substituted or unsubstituted diarylamine, or substituted or unsubstituted triarylamine. The same applies to the alkylamine and heteroarylamine groups.

Each of the aryl groups in the arylamine, heteroarylamine, and arylheteroarylamine groups may be a monocyclic or polycyclic one. Each of the heteroaryl groups in the arylamine, heteroarylamine, and arylheteroarylamine groups may be a monocyclic or polycyclic one.

The germanium group is intended to include -GeH₃, alkylgermanium, arylgermanium, heteroarylgermanium, alkylarylgermanium, alkylheteroarylgermanium, and arylheteroarylgermanium. The definitions of the substituents in the germanium groups follow those described for the silyl groups, except that the silicon (Si) atom in each silyl group is changed to a germanium (Ge) atom.

Specific examples of the germanium groups include trimethylgermane, triethylgermane, triphenylgermane, trimethoxygermane, dimethoxyphenylgermane, diphenylmethylgermane, diphenylvinylgermane, methylcyclobutylgermane, and dimethylfurylgermane. One or more of the hydrogen atoms in each of the germanium groups may be substituted with the substituents mentioned in the aryl groups.

The cycloalkyl, aryl, and heteroaryl groups in the cycloalkyloxy, aryloxy, heteroaryloxy, cycloalkylthioxy, arylthioxy, and heteroarylthioxy groups are the same as those exemplified above. Specific examples of the aryloxy groups include, but are not limited to, phenoxy, p-tolyloxy, m-tolyloxy, 3,5-dimethylphenoxy, 2,4,6-trimethylphenoxy, p-tert-butylphenoxy, 3-biphenyloxy, 4-biphenyloxy, 1-naphthyloxy, 2-naphthyloxy, 4-methyl-1-naphthyloxy, 5-methyl-2-naphthyloxy, 1-anthryloxy, 2-anthryloxy, 9-anthryloxy, 1-phenanthryloxy, 3-phenanthryloxy, and 9-phenanthryloxy groups. Specific examples of the arylthioxy groups include, but are not limited to, phenylthioxy, 2-methylphenylthioxy, and 4-tert-butylphenylthioxy groups.

The halogen group may be, for example, fluorine, chlorine, bromine or iodine.

According to one embodiment of the present invention, the anthracene derivative represented by Formula 1 may be selected from the following compounds.

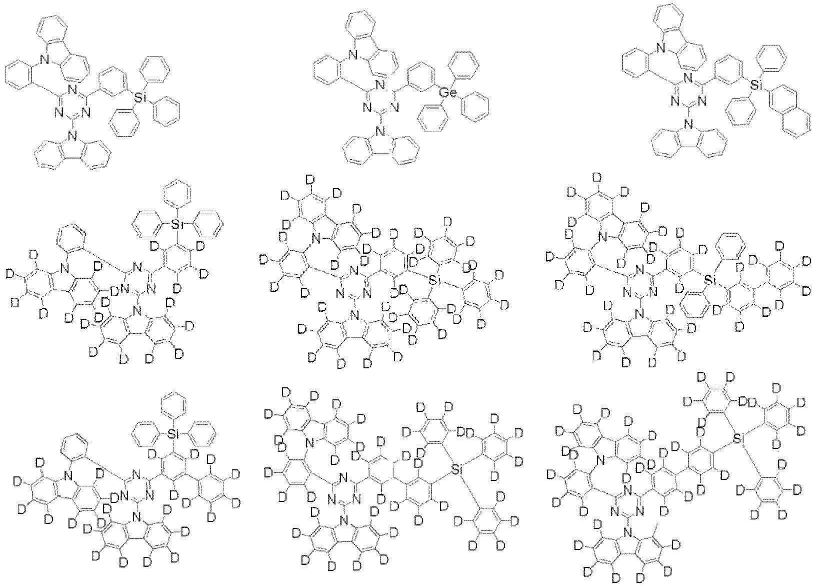

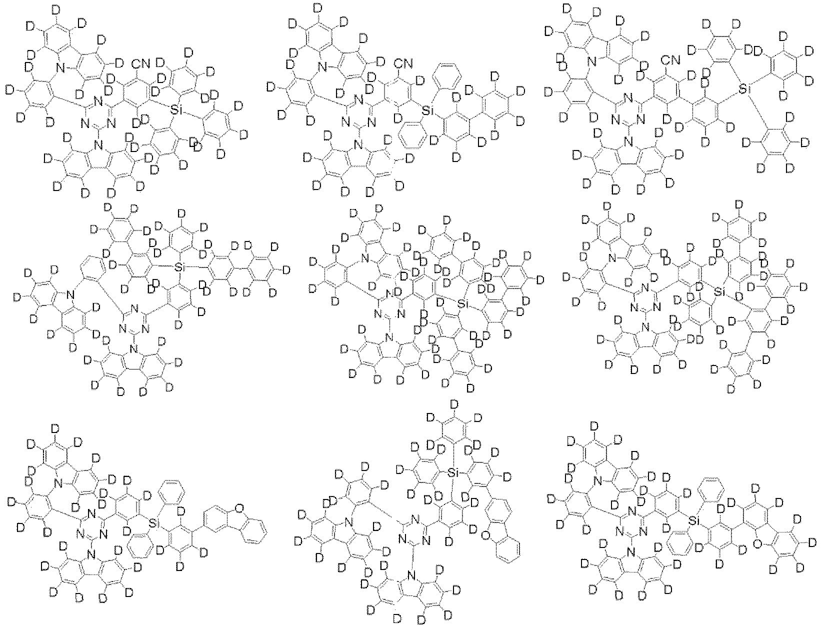

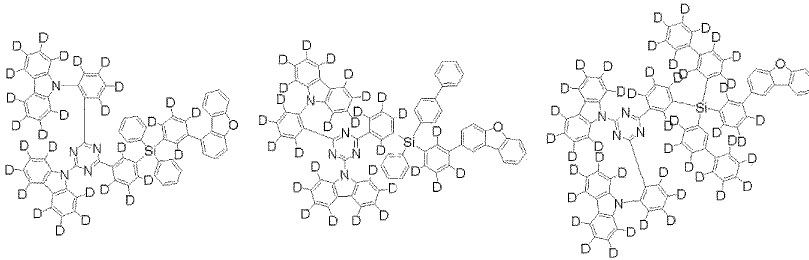

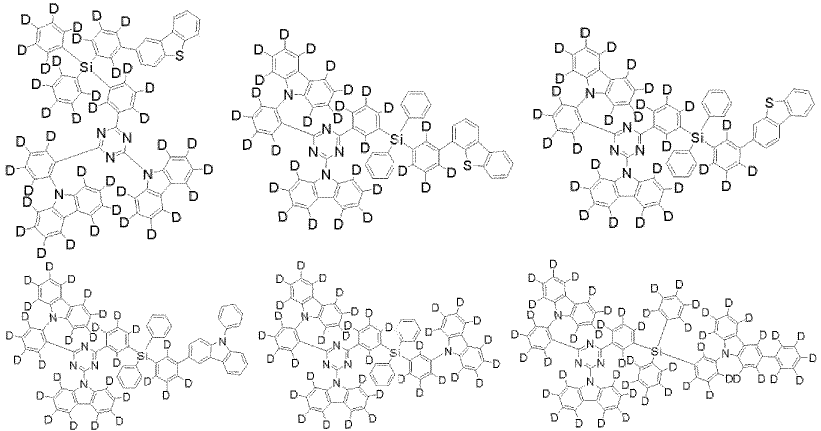

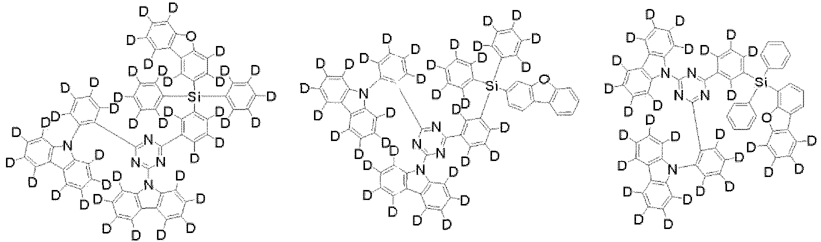

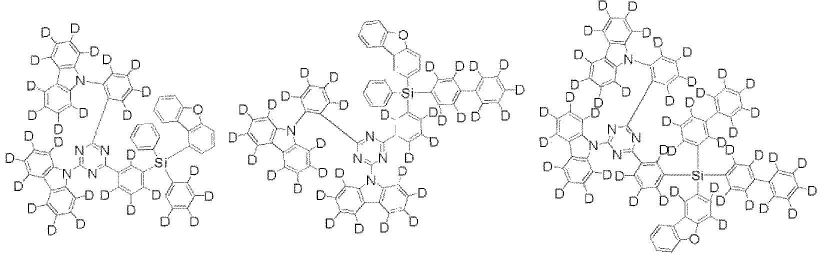

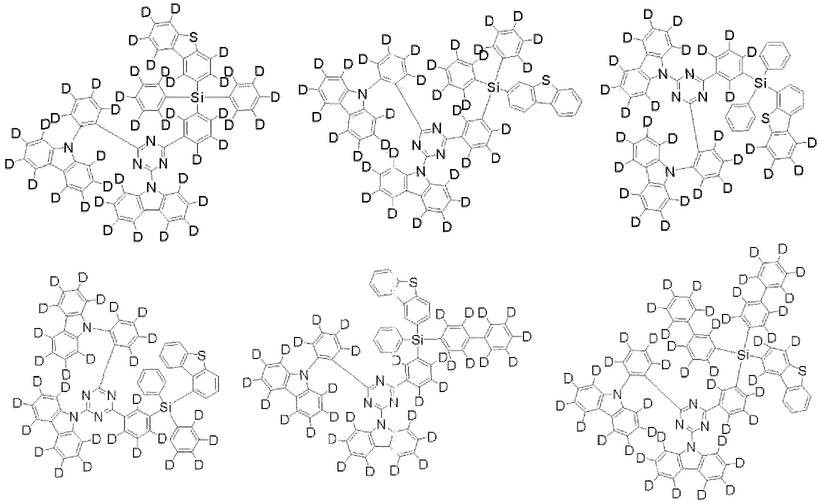

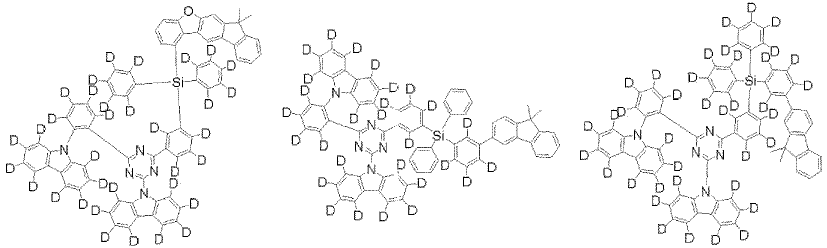

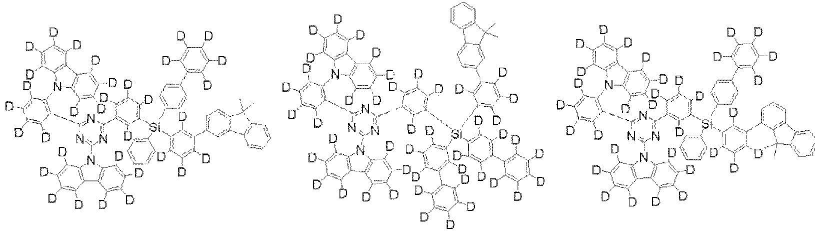

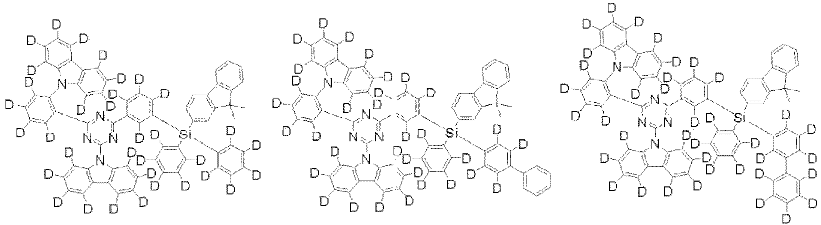

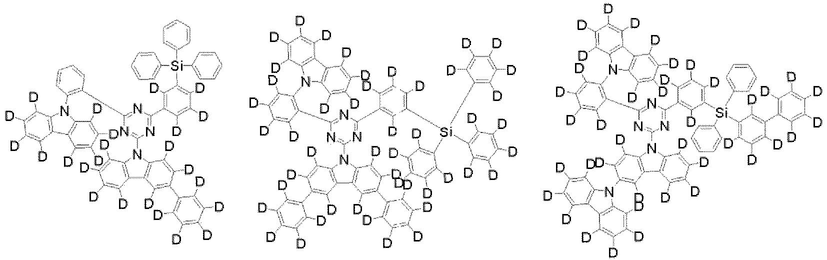

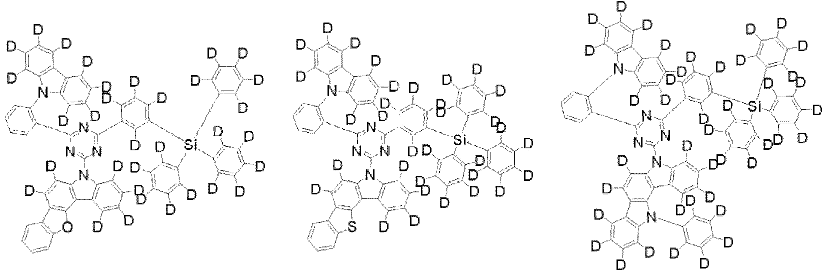

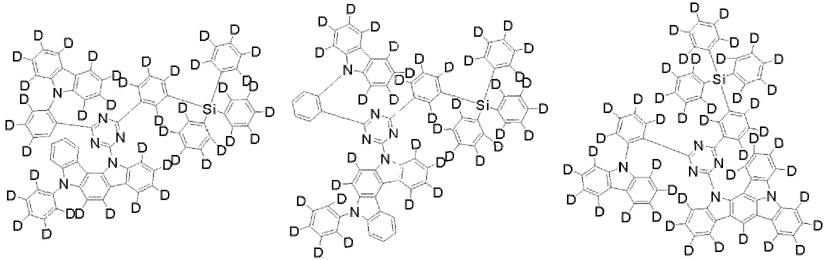

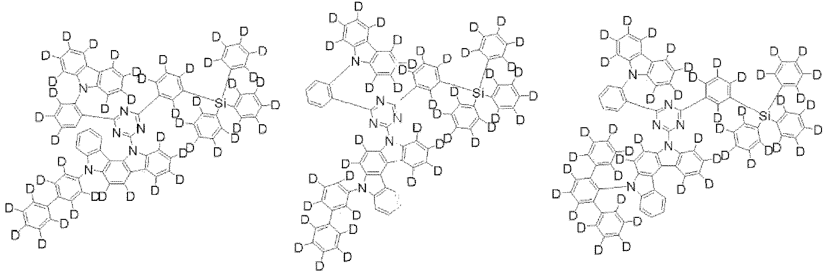

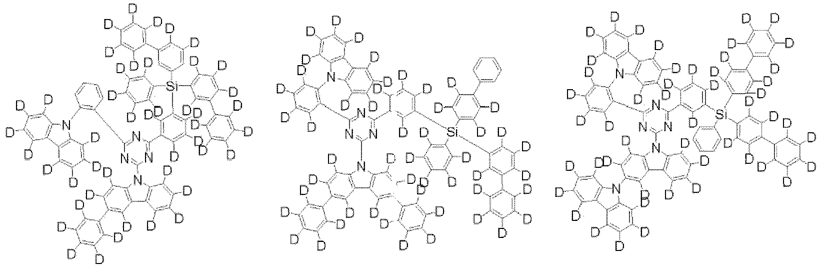

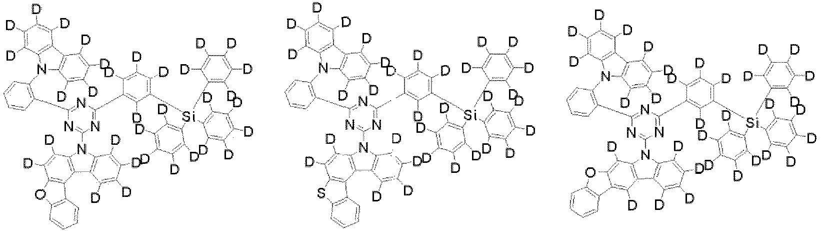

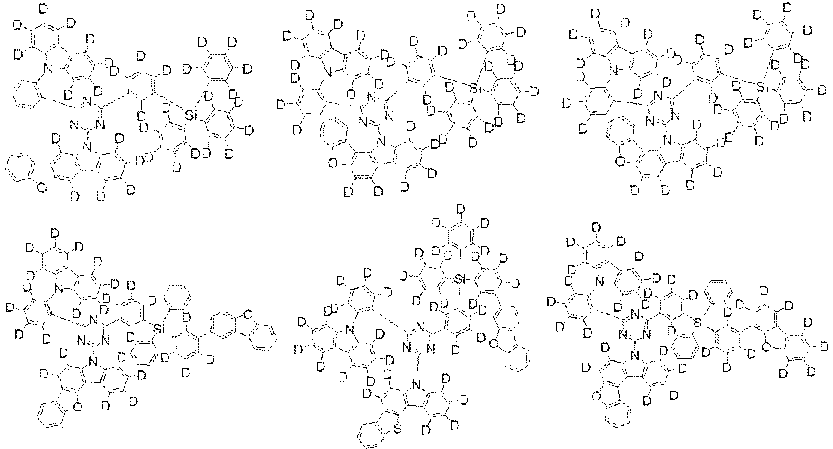

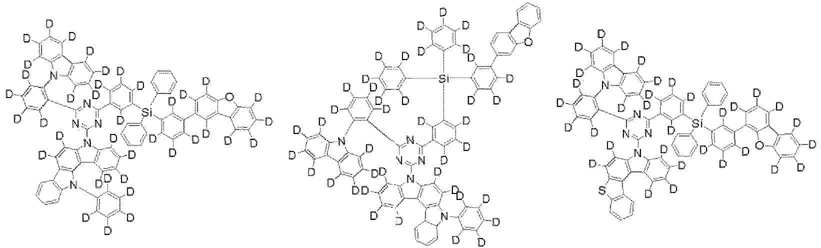

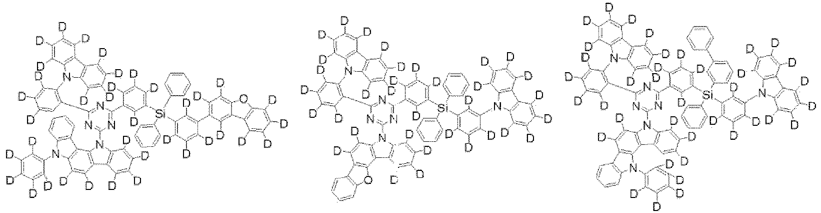

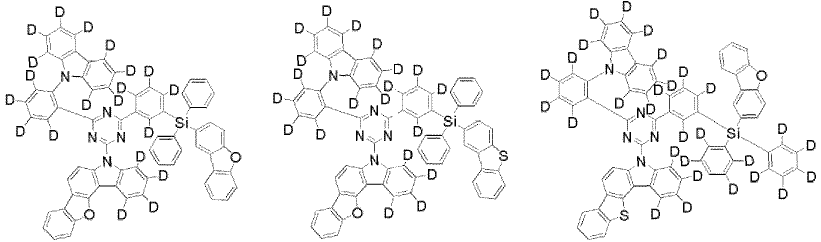

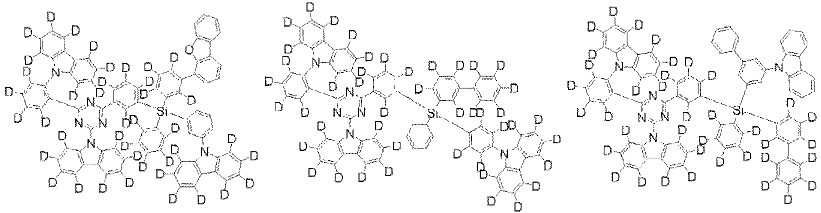

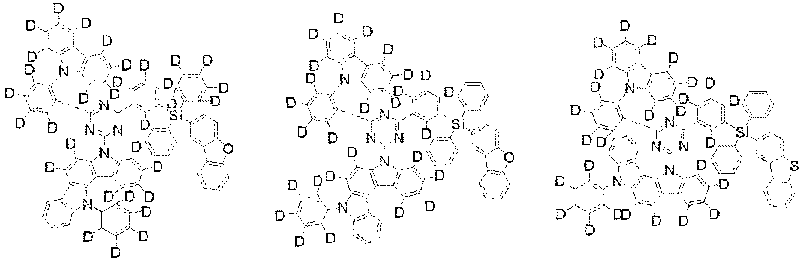

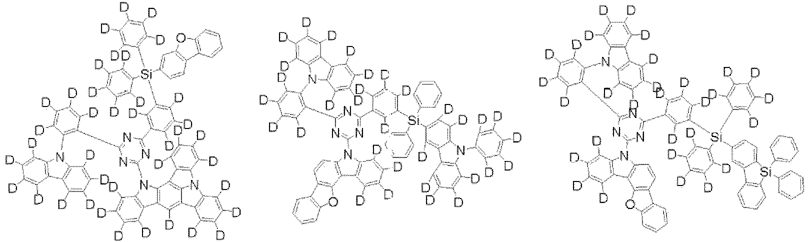

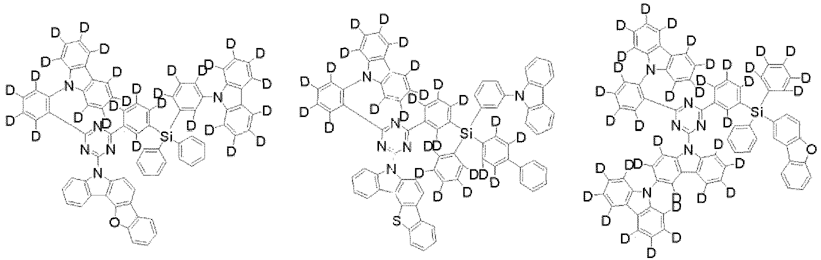

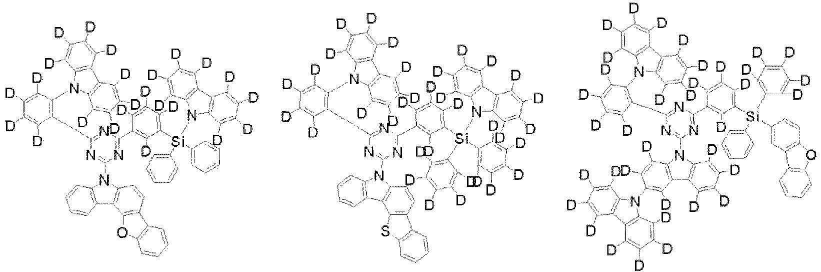

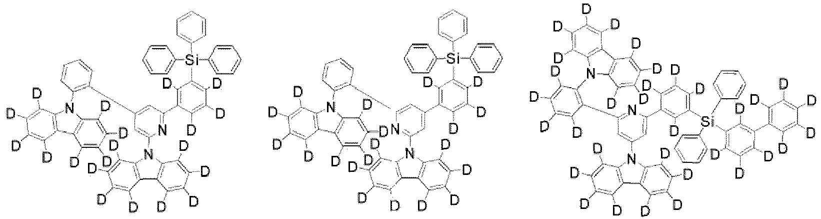

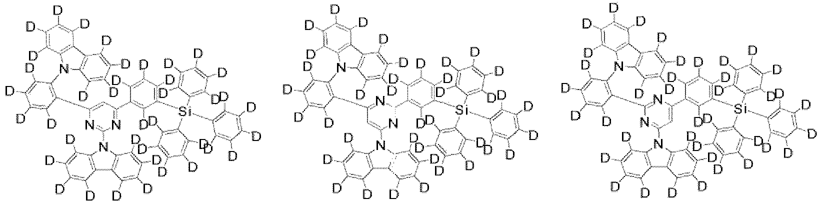

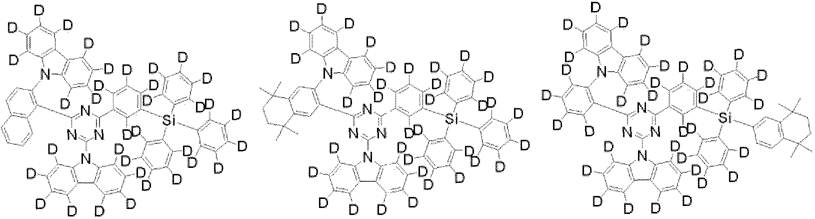

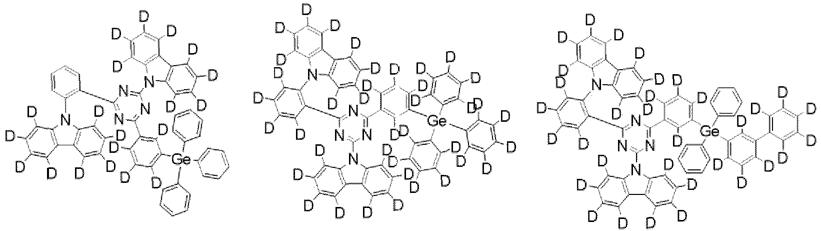

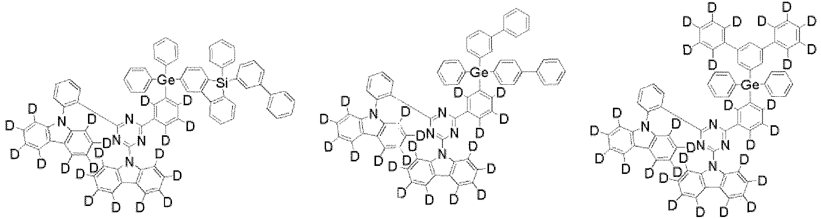

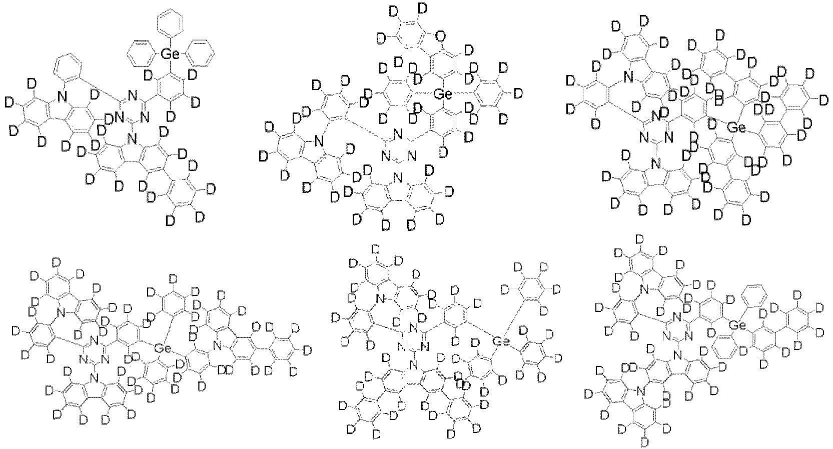

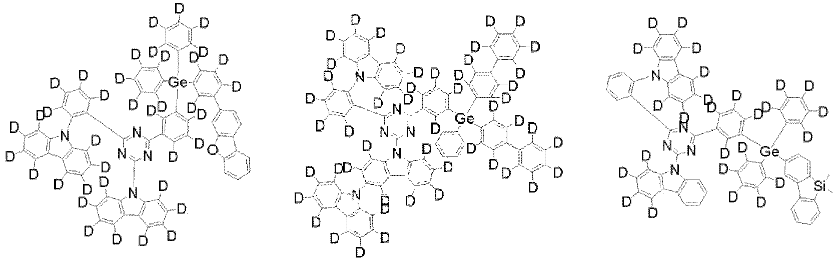

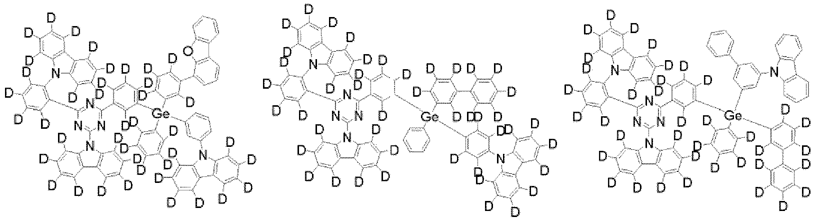

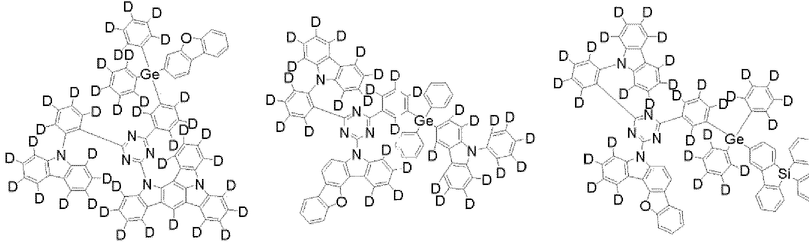

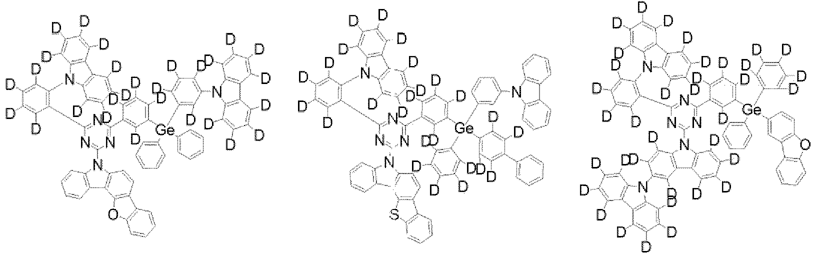

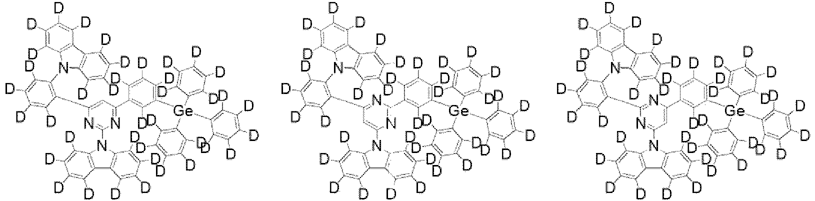

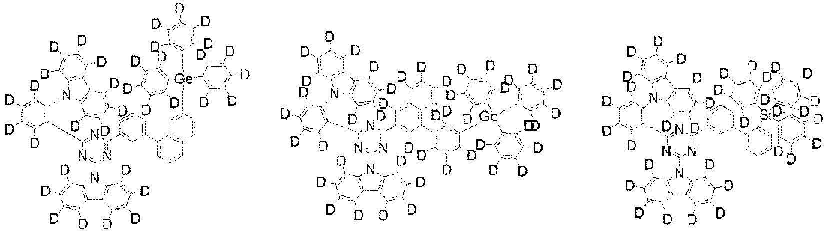

A more detailed description will be given concerning exemplary embodiments of the organic light emitting device according to the present invention.

The organic light emitting device of the present invention includes an anode, a hole transport layer, a light emitting layer, an electron transport layer, and a cathode. The organic light emitting device of the present invention may optionally further include a hole injecting layer between the anode and the hole transport layer and an electron injecting layer between the electron transport layer and the cathode. If necessary, the organic light emitting device of the present invention may further include one or two intermediate layers such as a hole blocking layer or an electron blocking layer. The organic light emitting device of the present invention may further include one or more organic layers such as a capping layer that have various functions depending on the desired characteristics of the device.

A specific structure of the organic light emitting device according to one embodiment of the present invention, a method for fabricating the device, and materials for the organic layers are as follows.

First, an anode material is coated on a substrate to form an anode. The substrate may be any of those used in general organic light emitting devices. The substrate is preferably an organic substrate or a transparent plastic substrate that is excellent in transparency, surface smoothness, ease of handling, and waterproofness. A highly transparent and conductive metal oxide such as indium tin oxide (ITO), indium zinc oxide (IZO), tin oxide (SnO₂) or zinc oxide (ZnO) is used as the anode material.

The hole injecting material is not specially limited so long as it is usually used in the art. Specific examples of such materials include 1,4,5,8,9,11-hexaazatriphenylenehexacarbonitrile (HAT-CN), 4,4',4"-tris (2-naphthylphenyl-phenylamino)triphenylamine (2-TNATA), N,N'-di(1-naphthyl)-N,N'-diphenylbenzidine (NPD), N,N'-diphenyl-N,N'-bis(3-methylphenyl)-1,1'-biphenyl-4,4'-diamine (TPD), and N,N'-diphenyl-N,N'-bis(4-(phenyl-m-tolylamino)phenyl)biphenyl-4,4'-diamine (DNTPD).

The hole transport material is not specially limited so long as it is commonly used in the art. Examples of such materials include N,N'-bis(3-methylphenyl)-N,N'-diphenyl-(1,1-biphenyl)-4,4'-diamine (TPD) and N,N'-di(naphthalen-1-yl)-N,N'-diphenylbenzidine (α-NPD).

Subsequently, a hole auxiliary layer and a light emitting layer are sequentially stacked on the hole transport layer. A hole blocking layer may be optionally formed on the light emitting layer by vacuum thermal evaporation or spin coating. The hole blocking layer is formed as a thin film and blocks holes from entering a cathode through the organic light emitting layer. This role of the hole blocking layer prevents the lifetime and efficiency of the device from deteriorating. A material having a very low highest occupied molecular orbital (HOMO) energy level is used for the hole blocking layer. The hole blocking material is not particularly limited so long as it can transport electrons and has a higher ionization potential than the light emitting compound. Representative examples of suitable hole blocking materials include BAlq, BCP, and TPBI.

Examples of materials for the hole blocking layer include, but are not limited to, BAlq, BCP, Bphen, TPBI, TAZ, BeBq₂, OXD-7, and Liq.

An electron transport layer is deposited on the hole blocking layer by vacuum thermal evaporation or spin coating, and an electron injecting layer is formed thereon. A cathode metal is deposited on the electron injecting layer by vacuum thermal evaporation to form a cathode, completing the fabrication of the organic light emitting device.

For example, lithium (Li), magnesium (Mg), aluminum (Al), aluminum-lithium (Al-Li), calcium (Ca), magnesium-indium (Mg-In) or magnesium-silver (Mg-Ag) may be used as the metal for the formation of the cathode. The organic light emitting device may be of top emission type. In this case, a transmissive material such as ITO or IZO may be used to form the cathode.

A material for the electron transport layer functions to stably transport electrons injected from the cathode. The electron transport material may be any of those known in the art and examples thereof include, but are not limited to, quinoline derivatives, particularly tris(8-quinolinolato)aluminum (Alq₃), TAZ, BAlq, beryllium bis(benzoquinolin-10-olate) (Bebq₂), and oxadiazole derivatives such as PBD, BMD, and BND.

The organic light emitting device of the present invention may further include a light emitting layer composed of a material that emits blue, green or red light in the wavelength range of 380 nm to 800 nm. That is, the organic light emitting device of the present invention may include a plurality of light emitting layers. The blue, green or red light emitting material for the additional light emitting layer may be a fluorescent or phosphorescent material.

Each of the organic layers can be formed by a monomolecular deposition or solution process. According to the monomolecular deposition process, the material for each layer is evaporated into a thin film under heat and vacuum or reduced pressure. According to the solution process, the material for each layer is mixed with a suitable solvent and the mixture is then formed into a thin film by a suitable method such as ink-jet printing, roll-to-roll coating, screen printing, spray coating, dip coating or spin coating.

The organic light emitting device of the present invention can be used in a display or lighting system selected from flat panel displays, flexible displays, monochromatic flat panel lighting systems, white flat panel lighting systems, flexible monochromatic lighting systems, flexible white lighting systems, displays for automotive applications, displays for virtual reality, and displays for augmented reality.

The present invention will be more specifically explained with reference to the following synthesis examples and fabrication examples. However, these examples are provided to assist in understanding the invention and are not intended to limit the scope of the present invention.

### Synthesis Example 1: Synthesis of [ET-1]

### Synthesis Example 1-1: Synthesis of A-1

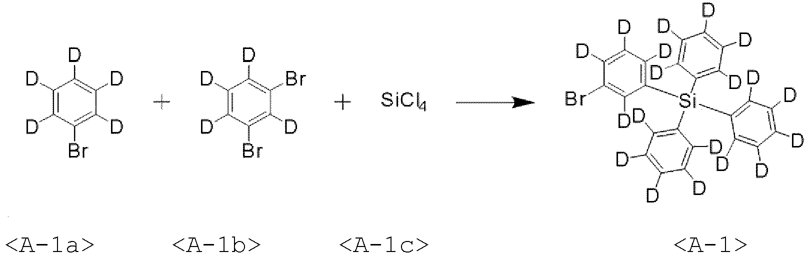

In a round bottom flask, <A-1a> (17.2 g) and diethyl ether (170 mL) were cooled to -78°C under a nitrogen condition, and 1.6 M n-butyllithium (72.8 mL) was slowly added dropwise thereto. In another round bottom flask, <A-1b> (9.32 g) and diethyl ether (90 mL) were cooled to -78°C under a nitrogen condition, and 1.6 M n-butyllithium (25.49 mL) was slowly added dropwise thereto. The mixtures in both flasks were stirred for 1 hour. The two reaction solutions were sequentially added dropwise to a round bottom flask containing a solution in which <A-1c> (6 g) was dissolved in diethyl ether (100 mL) cooled to -78°C, and then the mixture was stirred for 12 hours at room temperature. After the reaction was finished, water and ethyl acetate were introduced thereto to separate the layers, and the layers were dried with MgSO₄. The organic layer was concentrated under reduced pressure, and then separated and purified by column chromatography to obtain <A-1>. (24.4 g, 53%)

### Synthesis Example 1-2: Synthesis of A-2

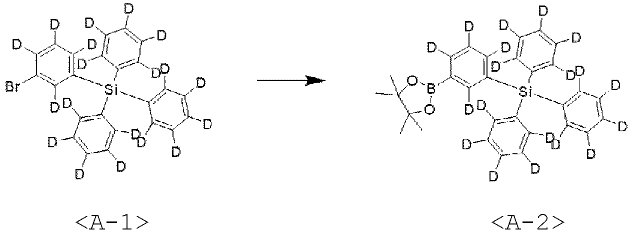

To a round bottom flask, <A-1> (24.4 g), bis(pinacolato)diboron (18.5 g), [1,1'-bis(diphenylphosphino)ferrocene]dichloropalladium(II) (4.11 g), potassium acetate (16.53 g) and 1,4-dioxane (250 mL) were introduced under a nitrogen condition, and the mixture was refluxed for 12 hours. After the reaction was finished, the layers were separated, and dried with MgSO₄. The organic layer was concentrated under reduced pressure, and then separated and purified by column chromatography to obtain <A-2>. (20.6 g, 76%)

### Synthesis Example 1-3: Synthesis of A-3

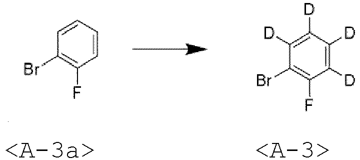

To a round bottom flask, <A-3a> (40 g), silver carbonate (13.1 g), cyclohexyldiphenylphosphine (30.67 g), potassium carbonate (31.6 g), heavy water (91.4 g) and toluene (2.3 mL) were introduced under a nitrogen condition, and the mixture was refluxed for 12 hours. After the reaction was finished, the layers were separated, and dried with MgSO₄. The organic layer was concentrated under reduced pressure, and then separated and purified by column chromatography to obtain <A-3>. (32.8 g, 80%)

### Synthesis Example 1-4: Synthesis of A-4

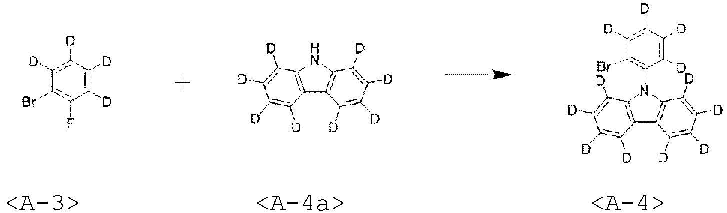

To a round bottom flask, <A-3> (32.5 g), <A-4a> (24.5 g), cesium carbonate (91.1 g) and dimethylformamide (300 mL) were introduced under a nitrogen condition, and the mixture was refluxed for 12 hours. After the reaction was finished, the layers were separated, and dried with MgSO₄. The organic layer was concentrated under reduced pressure, and then separated and purified by column chromatography to obtain <A-4>. (32.7 g, 70%)

### Synthesis Example 1-5: Synthesis of A-5

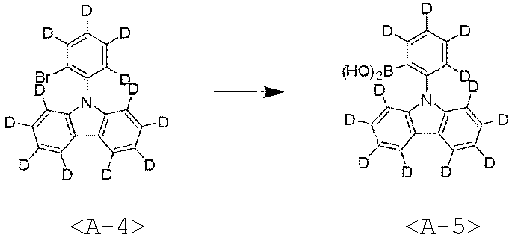

In a round bottom flask, <A-4> (32.7 g) and tetrahydrofuran (320 mL) were cooled to -78°C under a nitrogen condition, and after slowly adding 1.6 M n-butyllithium (73.4 mL) dropwise thereto, the mixture was stirred for 1 hour. Trimethyl borate (12.2 g) was slowly added dropwise thereto, and the mixture was stirred for 12 hours at room temperature. After the reaction was finished, the layers were separated, and dried with MgSO₄. The organic layer was concentrated under reduced pressure, and then crystallized and purified with hexane to obtain <A-5>. (23.4 g, 80%)

### Synthesis Example 1-6: Synthesis of A-6

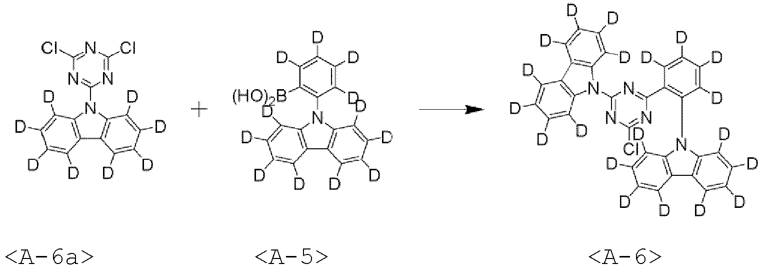

To a round bottom flask, <A-6a> (23 g), <A-5> (23.4 g), potassium carbonate (19.7 g), bis(triphenylphosphine)palladium(II) dichloride (0.05 g) and toluene (234 mL) were introduced under a nitrogen condition, and the mixture was refluxed for 12 hours. After the reaction was finished, the layers were separated, and dried with MgSO₄. The organic layer was concentrated under reduced pressure, and then separated and purified by column chromatography to obtain <A-6>. (27 g, 70%)

### Synthesis Example 1-7: Synthesis of [ET-1]

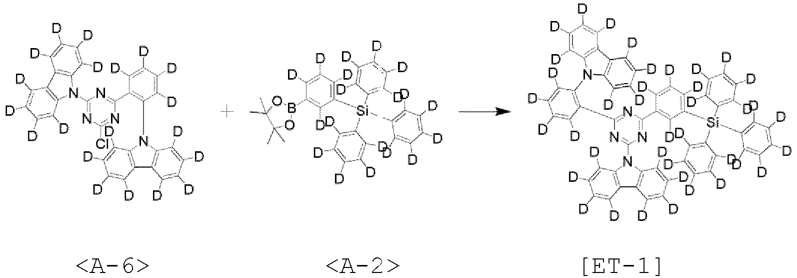

To a round bottom flask, <A-6> (19.3 g), <A-2> (20.6 g), tetrakis(triphenylphosphine)palladium(0) (2.06 g), potassium carbonate (12.3 g), 1,4-dioxane (190 mL) and water (37 mL) were introduced under a nitrogen condition, and the mixture was refluxed for 12 hours. After the reaction was finished, the layers were separated, and dried with MgSO₄. The organic layer was concentrated under reduced pressure, and then separated and purified by column chromatography to obtain [ET-1]. (18.4 g, 60%)
MS (MALDI-TOF): m/z 860.54 [M⁺]

### Synthesis Example 2: Synthesis of [ET-2]

### Synthesis Example 2-1: Synthesis of B-1

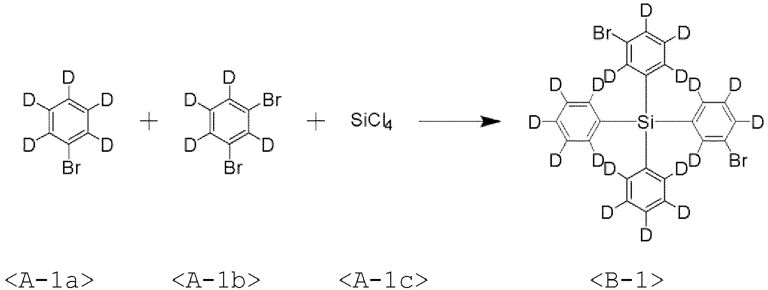

<B-1> was obtained in the same manner as in Synthesis Example 1-1, except that the equivalent numbers of <A-1a> and <A-1b> were adjusted. (Yield 62%)

### Synthesis Example 2-2: Synthesis of B-2

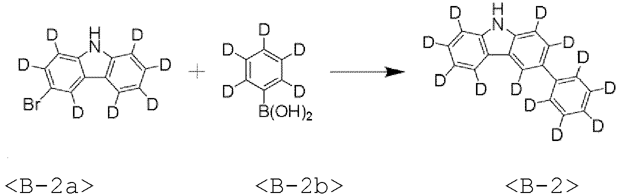

<B-2> was obtained in the same manner as in Synthesis Example 1-7, except that <B-2a> was used instead of <A-6>, and <B-2b> was used instead of <A-2>. (Yield 81%)

### Synthesis Example 2-3: Synthesis of B-3

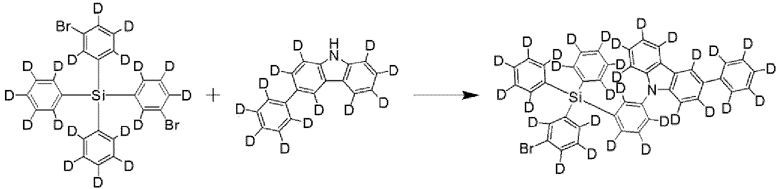

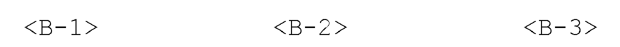

To a round bottom flask, <B-1> (39.13 g), <B-2> (15 g), tris(dibenzylideneacetone)dipalladium(0) (1.1 g), 2,2'-bis(diphenylphosphino)-1,1'-binaphthyl (1.5 g), sodium tert-butoxide (11.3 g) and toluene (400 mL) were introduced under a nitrogen condition, and the mixture was refluxed for 12 hours. After the reaction was finished, the layers were separated, and dried with MgSO₄. The organic layer was concentrated under reduced pressure, and then separated and purified by column chromatography to obtain <B-3>. (22.2 g, 55%)

### Synthesis Example 2-4: Synthesis of B-4

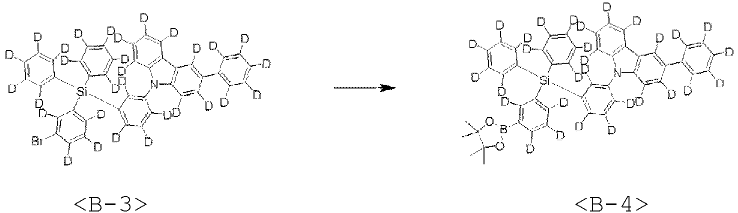

<B-4> was obtained in the same manner as in Synthesis Example 1-2, except that <B-3> was used instead of <A-1>. (Yield 70%)

### Synthesis Example 2-5: Synthesis of [ET-2]

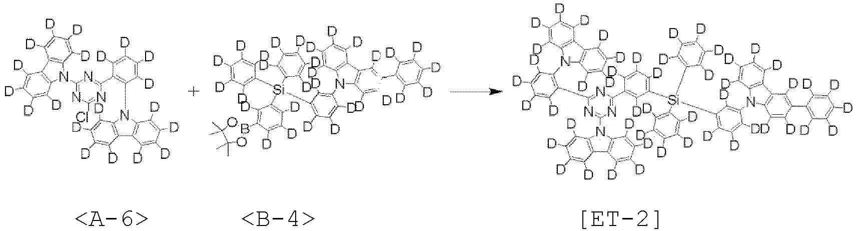

[ET-2] was obtained in the same manner as in Synthesis Example 1-7, except that <B-4> was used instead of <A-2>. (Yield 66%)
MS (MALDI-TOF): m/z 1112.70 [M⁺]

### Synthesis Example 3: Synthesis of [ET-3]

### Synthesis Example 3-1: Synthesis of C-1

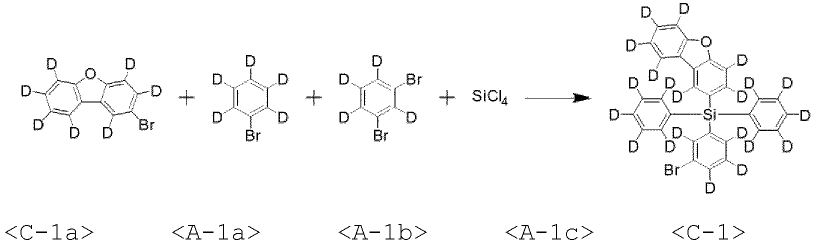

In a round bottom flask, <C-1a> (22.4 g) and diethyl ether (220 mL) were cooled to -78°C under a nitrogen condition, and 1.6 M n-butyllithium (60.7 mL) was slowly added dropwise thereto. In another round bottom flask, <A-1a> (28.61 g) and diethyl ether (280 mL) were cooled to -78°C under a nitrogen condition, and 1.6 M n-butyllithium (121.4 mL) was slowly added dropwise thereto. In still another round bottom flask, <A-1b> (23.3 g) and diethyl ether (230 mL) were cooled to -78°C under a nitrogen condition, and 1.6 M n-butyllithium (66.77 mL) was slowly added dropwise thereto. The mixtures in all flasks were stirred for 1 hour. The three reaction solutions were sequentially added dropwise to a round bottom flask containing a solution in which <A-1c> (15 g) was dissolved in diethyl ether (75 mL) cooled to - 78°C, and then the mixture was stirred for 12 hours at room temperature. After the reaction was finished, the layers were separated. The organic layer was concentrated under reduced pressure, and then separated and purified by column chromatography to obtain <C-1>. (25.57 g, 55%)

### Synthesis Example 3-2: Synthesis of C-2

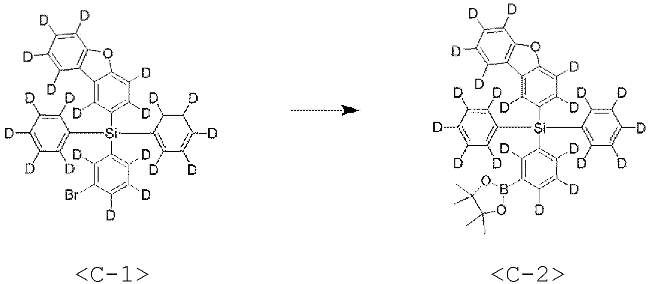

<C-2> was obtained in the same manner as in Synthesis Example 1-2, except that <C-1> was used instead of <A-1>. (Yield 75%)

### Synthesis Example 3-3: Synthesis of [ET-3]

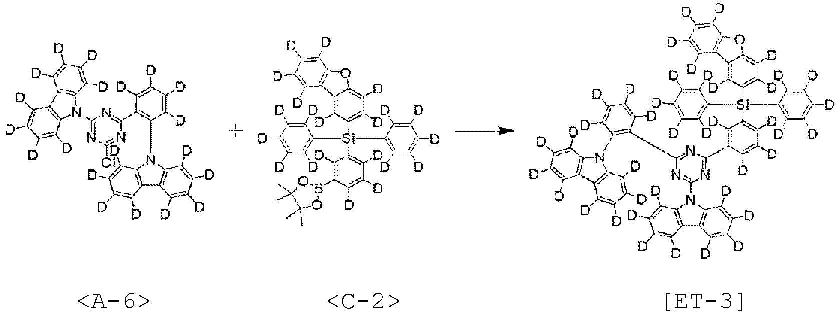

[ET-3] was obtained in the same manner as in Synthesis Example 1-7, except that <C-2> was used instead of <A-2>. (Yield 63%)
MS (MALDI-TOF): m/z 952.57 [M⁺]

### Synthesis Example 4: Synthesis of [ET-4]

### Synthesis Example 4-1: Synthesis of D-1

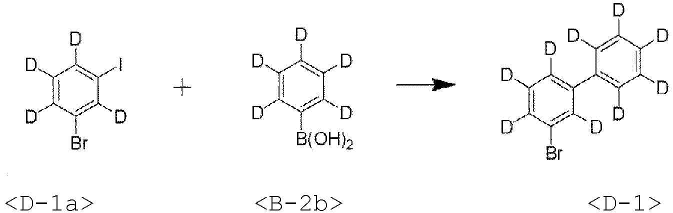

<D-1> was obtained in the same manner as in Synthesis Example 1-7, except that <D-1a> was used instead of <A-6>, and <B-2b> was used instead of <A-2>. (Yield 73%)

### Synthesis Example 4-2: Synthesis of D-2

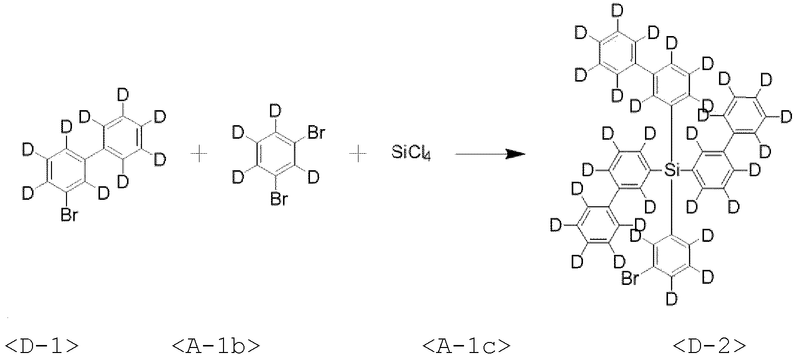

<D-2> was obtained in the same manner as in Synthesis Example 1-1, except that <D-1> was used instead of <A-1a>. (Yield 53%)

### Synthesis Example 4-3: Synthesis of D-3

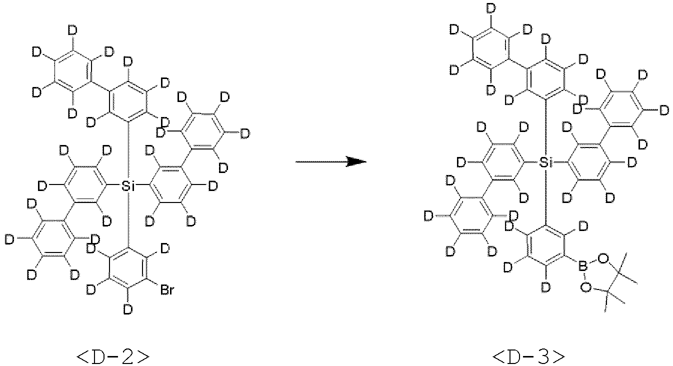

<D-3> was obtained in the same manner as in Synthesis Example 1-2, except that <D-2> was used instead of <A-1>. (Yield 71%)

### Synthesis Example 4-4: Synthesis of [ET-4]

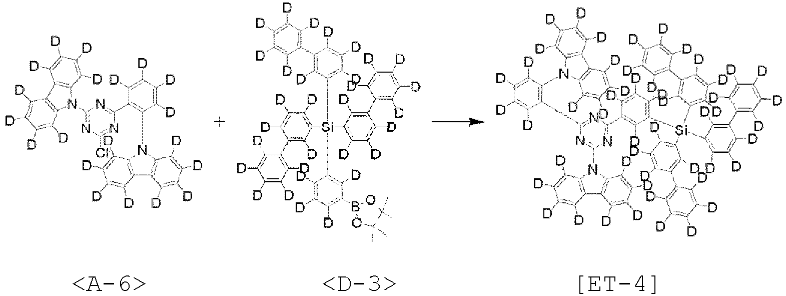

[ET-4] was obtained in the same manner as in Synthesis Example 1-7, except that <D-3> was used instead of <A-2>. (Yield 64%)
MS (MALDI-TOF): m/z 1100.71 [M⁺]

### Synthesis Example 5: Synthesis of [ET-5]

### Synthesis Example 5-1: Synthesis of E-1

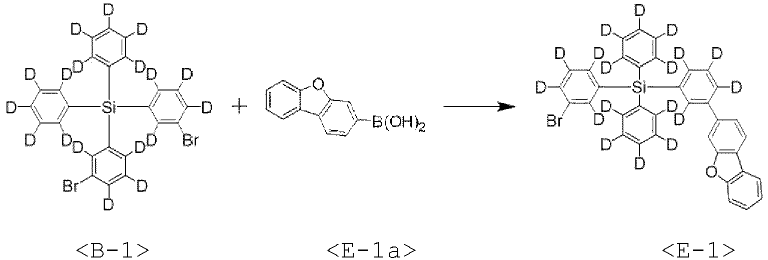

<E-1> was obtained in the same manner as in Synthesis Example 1-7, except that <B-1> was used instead of <A-6>, <E-1a> was used instead of <A-2>, and tetrahydrofuran was used instead of 1,4-dioxane. (Yield 58%)

### Synthesis Example 5-2: Synthesis of E-2

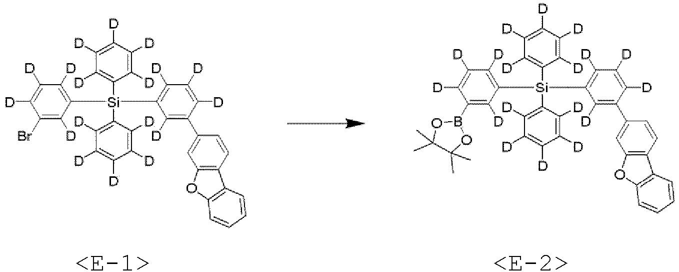

<E-2> was obtained in the same manner as in Synthesis Example 1-2, except that <E-1> was used instead of <A-1>. (Yield 75%)

### Synthesis Example 5-3: Synthesis of [ET-5]

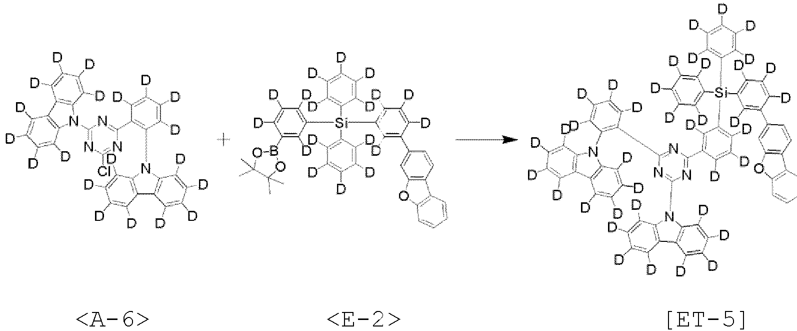

[ET-5] was obtained in the same manner as in Synthesis Example 1-7, except that <E-2> was used instead of <A-2>. (Yield 64%)
MS (MALDI-TOF): m/z 1025.58 [M⁺]

### Synthesis Example 6: Synthesis of [ET-6]

### Synthesis Example 6-1: Synthesis of F-1

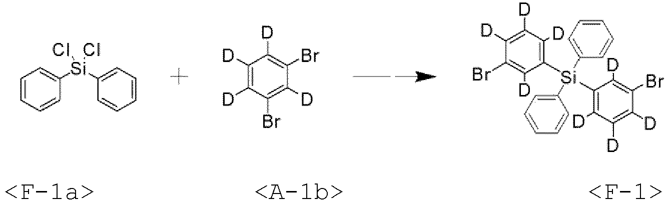

To a round bottom flask, <A-1b> (49.7 g) and diethyl ether (500 mL) were introduced under a nitrogen condition, and cooled to -78°C. Then, 1.6 M n-butyllithium (129.6 mL) was slowly added dropwise thereto, and the mixture was stirred for 1 hour. <F-1a> (25 g) was added dropwise thereto, and then the mixture was stirred for 12 hours at room temperature. After the reaction was finished, the layers were separated, dried with MgSO₄, then concentrated under reduced pressure, and separated and purified by column chromatography to obtain <F-1>. (35.2 g, 71%)

### Synthesis Example 6-2: Synthesis of F-2

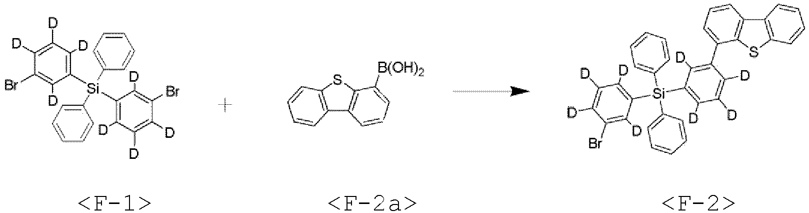

<F-2> was obtained in the same manner as in Synthesis Example 1-7, except that <F-1> was used instead of <A-6>, and <F-2a> was used instead of <A-2>. (Yield 55%)

### Synthesis Example 6-3: Synthesis of F-3

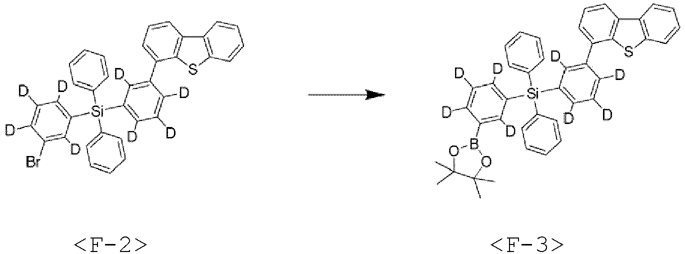

<F-3> was obtained in the same manner as in Synthesis Example 1-2, except that <F-2> was used instead of <A-1>. (Yield 71%)

### Synthesis Example 6-4: Synthesis of [ET-6]

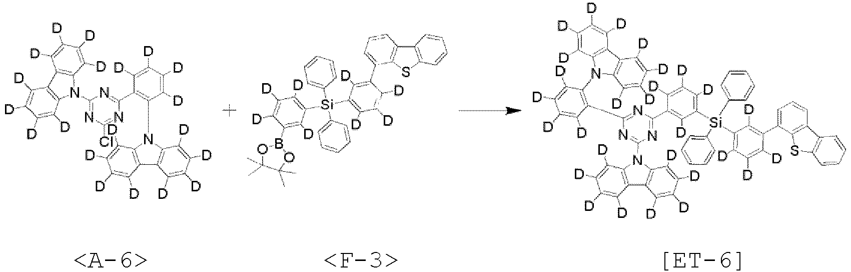

[ET-6] was obtained in the same manner as in Synthesis Example 1-7, except that <F-3> was used instead of <A-2>. (Yield 64%)
MS (MALDI-TOF): m/z 1031.49 [M⁺]

### Synthesis Example 7: Synthesis of [ET-7]

### Synthesis Example 7-1: Synthesis of G-1

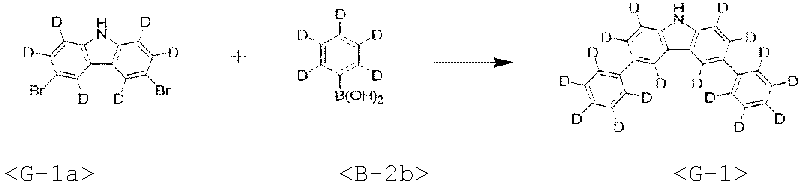

<G-1> was obtained in the same manner as in Synthesis Example 1-7, except that <G-1a> was used instead of <A-6>, and <B-2b> was used instead of <A-2>. (Yield 81%)

### Synthesis Example 7-2: Synthesis of G-2

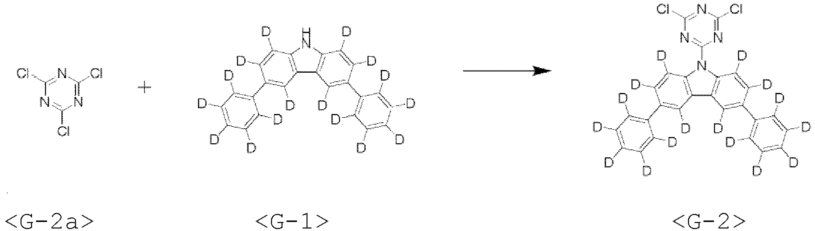

To a round bottom flask, <G-1> (30 g) and tetrahydrofuran (300 mL) were introduced under a nitrogen condition, and cooled to 0°C. Then, 1.6 M n-butyllithium (67.1 mL) was slowly added dropwise thereto, and the mixture was stirred for 1 hour at room temperature. To the resulting reaction solution, <G-2a> (24.7 g) and tetrahydrofuran (125 mL) were introduced under a nitrogen condition, and the mixture was slowly added dropwise to another reactor cooled to 0°C, and refluxed for 12 hours. After the reaction was finished, the layers were separated, dried with MgSO₄, concentrated under reduced pressure, and separated and purified by column chromatography to obtain <G-2>. (29.4 g, 68%)

### Synthesis Example 7-3: Synthesis of G-3

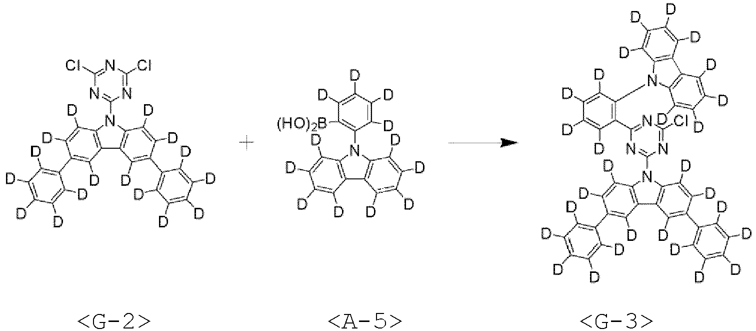

<G-3> was obtained in the same manner as in Synthesis Example 1-6, except that <G-2> was used instead of <A-6a>. (Yield 65%)

### Synthesis Example 7-4: Synthesis of [ET-7]

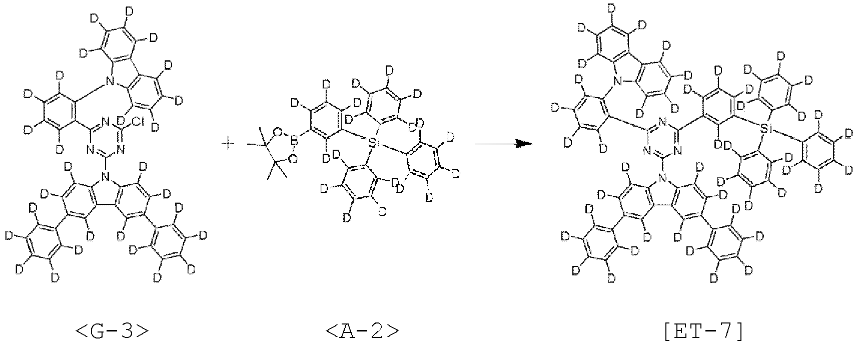

[ET-7] was obtained in the same manner as in Synthesis Example 1-7, except that <G-3> was used instead of <A-6>. (Yield 66%)
MS (MALDI-TOF): m/z 1020.66 [M⁺]

### Synthesis Example 8: Synthesis of [ET-8]

### Synthesis Example 8-1: Synthesis of H-1

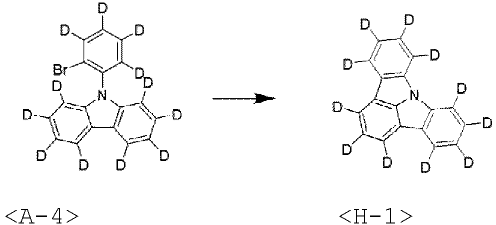

To a round bottom flask, <A-4> (50 g), palladium acetate (3.4 g), tricyclohexylphosphine (8.4 g) and dimethylacetamide (500 mL) were introduced under a nitrogen condition, and the mixture was refluxed for 12 hours. After the reaction was finished, the layers were separated, dried with MgSO₄, then concentrated under reduced pressure, and separated and purified by column chromatography to obtain <H-1>. (26.4 g, 70%)

### Synthesis Example 8-2: Synthesis of H-2

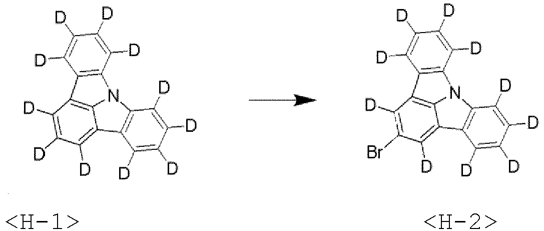

To a round bottom flask, <H-1> (26.4 g) and dimethylformamide (270 mL) were introduced under a nitrogen condition, and cooled to -10°C. Then, a solution obtained by dissolving N-bromosuccinimide (17.69 g) in dimethylformamide (100 mL) was slowly added dropwise thereto, and the mixture was stirred for 12 hours at room temperature. After the reaction was finished, the layers were separated, dried with MgSO₄, then concentrated under reduced pressure, and separated and purified by column chromatography to obtain <H-2>. (29.4 g, 85%)

### Synthesis Example 8-3: Synthesis of H-3

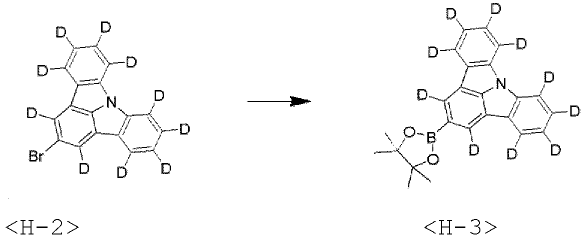

<H-3> was obtained in the same manner as in Synthesis Example 1-2, except that <H-2> was used instead of <A-1>. (Yield 74%)

### Synthesis Example 8-4: Synthesis of H-4

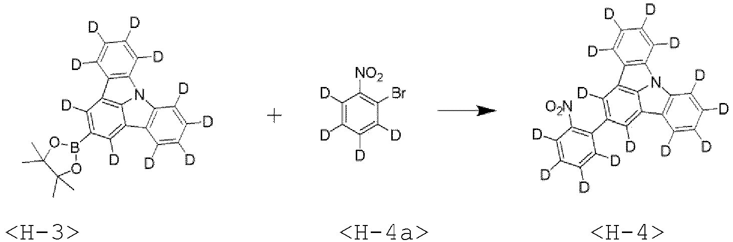

<H-4> was obtained in the same manner as in Synthesis Example 1-7, except that <H-4a> was used instead of <A-6>, and <H-3> was used instead of <A-2>. (Yield 76%)

### Synthesis Example 8-5: Synthesis of H-5

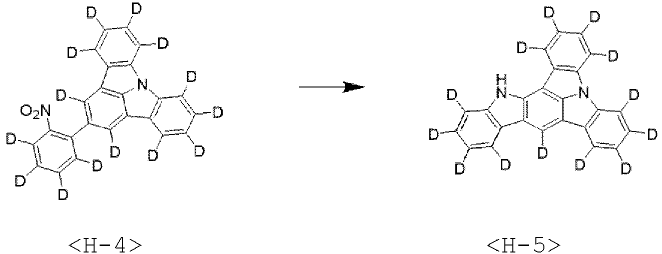

To a round bottom flask, <H-4> (27.3 g), triphenylphosphine (57.1 g) and 1,2-dichlorobenzene (280 mL) were introduced under a nitrogen condition, and the mixture was refluxed for 12 hours. After the reaction was finished, the layers were separated, dried with MgSO₄, then concentrated under reduced pressure, and separated and purified by column chromatography to obtain <H-5>. (22.7 g, 91%)

### Synthesis Example 8-6: Synthesis of H-6

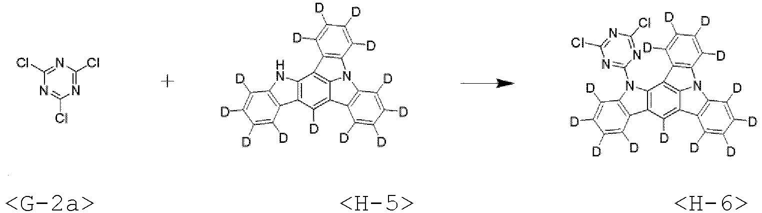

<H-6> was obtained in the same manner as in Synthesis Example 7-2, except that <H-5> was used instead of <G-1>. (Yield 62%)

### Synthesis Example 8-7: Synthesis of H-7

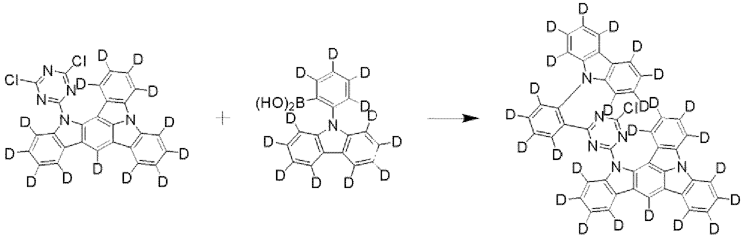

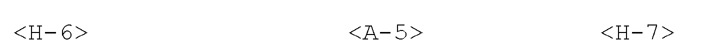

<H-7> was obtained in the same manner as in Synthesis Example 1-6, except that <H-6> was used instead of <A-6a>. (Yield 65%)

### Synthesis Example 8-8: Synthesis of [ET-8]

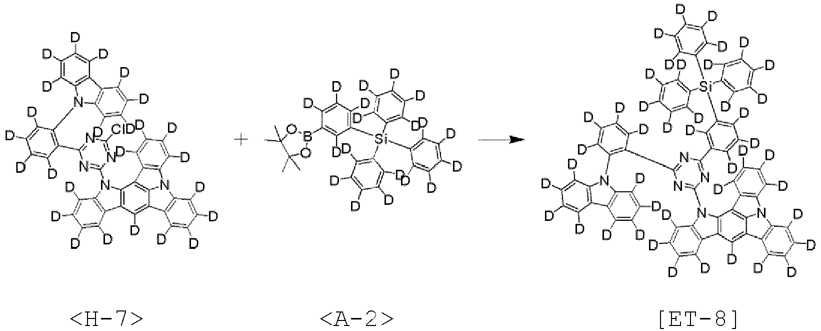

[ET-8] was obtained in the same manner as in Synthesis Example 1-7, except that <H-7> was used instead of <A-6>. (Yield 66%)
MS (MALDI-TOF): m/z 1028.62 [M⁺]

### Synthesis Example 9: Synthesis of [ET-9]

### Synthesis Example 9-1: Synthesis of I-1

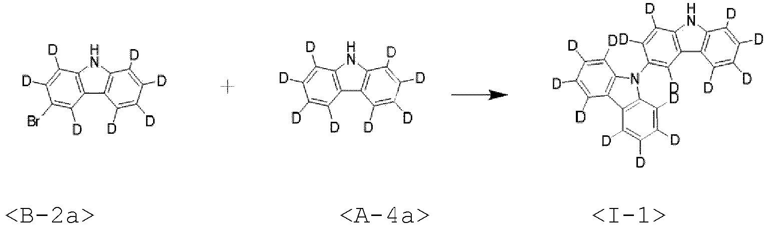

<I-1> was obtained in the same manner as in Synthesis Example 2-3, except that <B-2a> was used instead of <B-1>, and <A-4a> was used instead of <B-2>. (Yield 79%)

### Synthesis Example 9-2: Synthesis of I-2

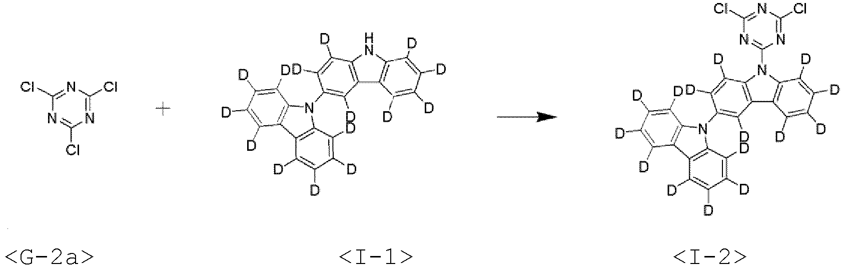

<I-2> was obtained in the same manner as in Synthesis Example 7-2, except that <I-1> was used instead of <G-1>. (Yield 64%)

### Synthesis Example 9-3: Synthesis of I-3

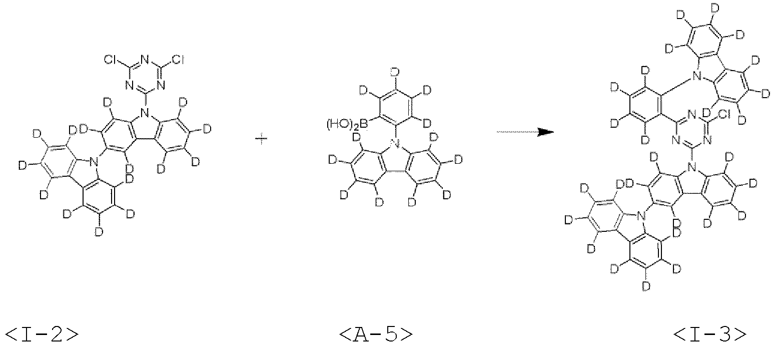

<I-3> was obtained in the same manner as in Synthesis Example 1-6, except that <I-2> was used instead of <A-6a>. (Yield 60%)

### Synthesis Example 9-4: Synthesis of I-4

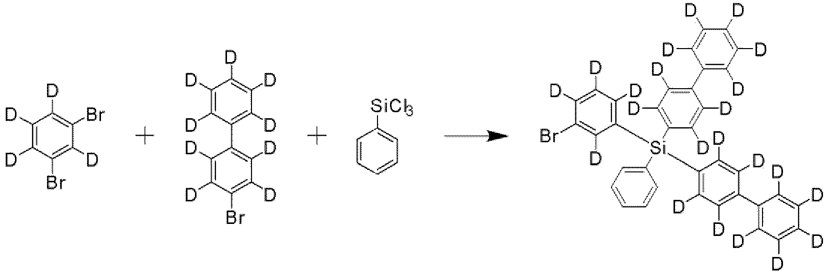

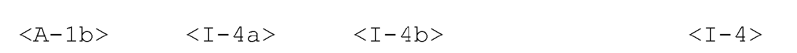

<I-4> was obtained in the same manner as in Synthesis Example 1-1, except that <I-4a> was used instead of <A-1a>, and <I-4b> was used instead of <A-1c>. (Yield 63%)

### Synthesis Example 9-5: Synthesis of I-5

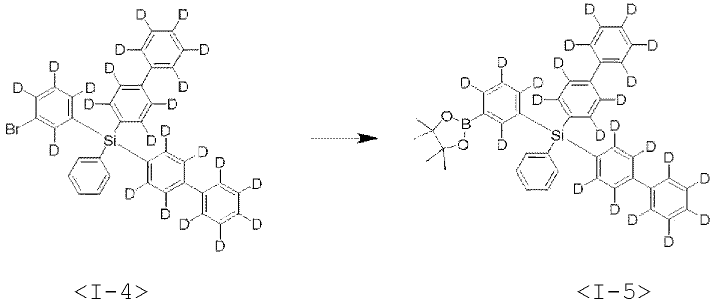

<I-5> was obtained in the same manner as in Synthesis Example 1-2, except that <I-4> was used instead of <A-1>. (Yield 78%)

### Synthesis Example 9-6: Synthesis of [ET-9]

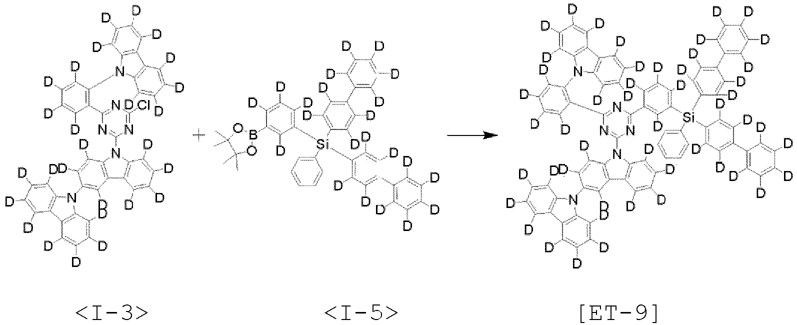

[ET-9] was obtained in the same manner as in Synthesis Example 1-7, except that <I-3> was used instead of <A-6>, and <I-5> was used instead of <A-2>. (Yield 64%)
MS (MALDI-TOF): m/z 1187.73 [M⁺]

### Synthesis Example 10: Synthesis of [ET-10]

### Synthesis Example 10-1: Synthesis of J-1

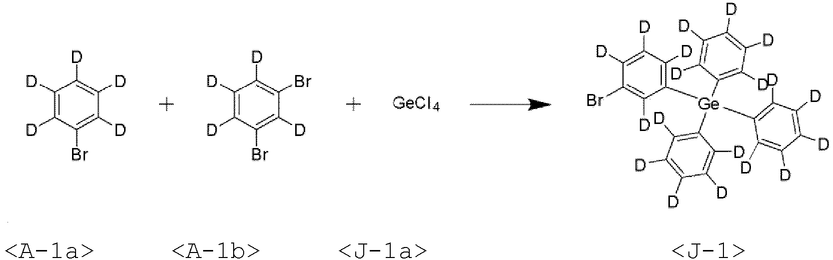

<J-1> was obtained in the same manner as in Synthesis Example 1-1, except that <J-la> was used instead of <A-1c>. (Yield 62%)

### Synthesis Example 10-2: Synthesis of J-2

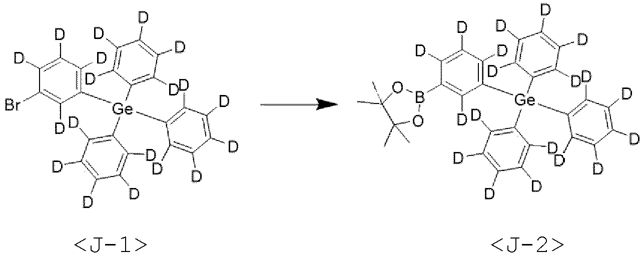

<J-2> was obtained in the same manner as in Synthesis Example 1-2, except that <J-1> was used instead of <A-1>. (Yield 70%)

### Synthesis Example 10-3: Synthesis of [ET-10]

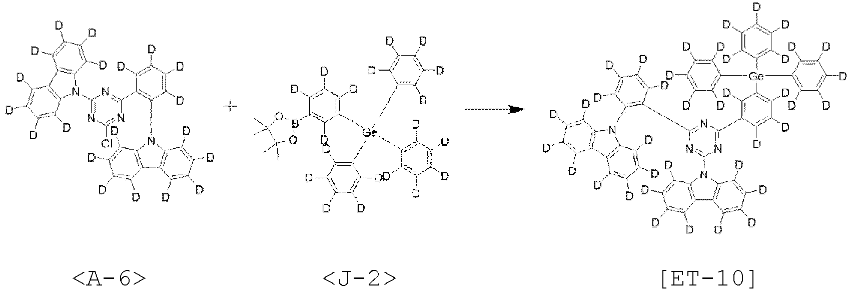

[ET-10] was obtained in the same manner as in Synthesis Example 1-7, except that <J-2> was used instead of <A-2>. (Yield 58%)
MS (MALDI-TOF): m/z 906.49 [M⁺]

### Synthesis Example 11: Synthesis of [ET-11]

### Synthesis Example 11-1: Synthesis of K-1

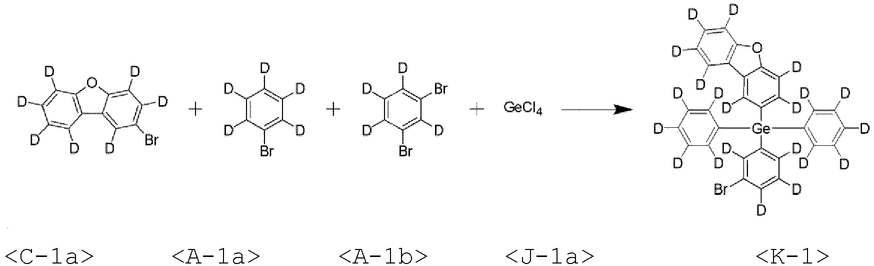

<K-1> was obtained in the same manner as in Synthesis Example 3-1, except that <J-la> was used instead of <A-1c>. (Yield 55%)

### Synthesis Example 11-2: Synthesis of K-2

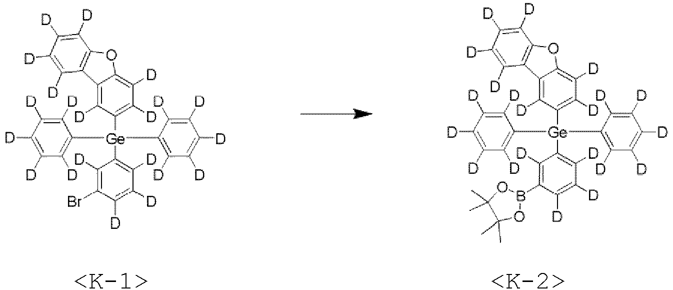

<K-2> was obtained in the same manner as in Synthesis Example 1-2, except that <K-1> was used instead of <A-1>. (Yield 78%)

### Synthesis Example 11-3: Synthesis of [ET-11]

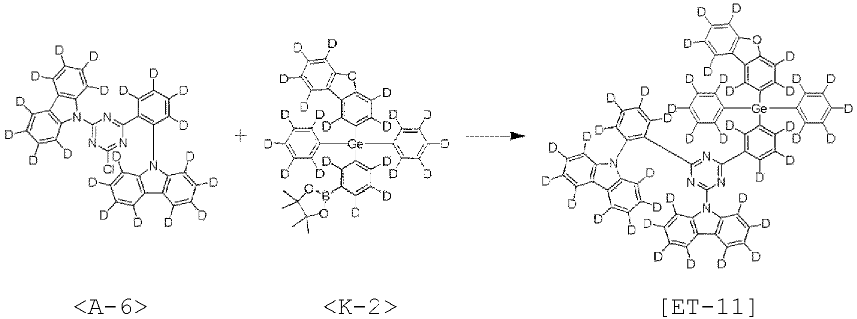

[ET-11] was obtained in the same manner as in Synthesis Example 1-7, except that <K-2> was used instead of <A-2>. (Yield 51%)
MS (MALDI-TOF): m/z 998.51 [M⁺]

### Synthesis Example 12: Synthesis of [ET-12]

### Synthesis Example 12-1: Synthesis of L-1

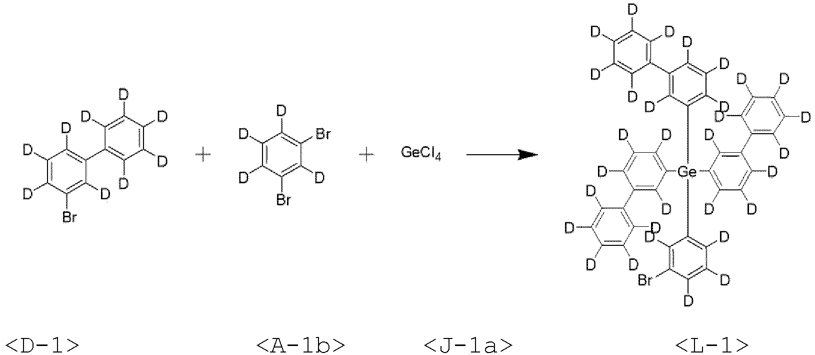

<L-1> was obtained in the same manner as in Synthesis Example 4-2, except that <J-la> was used instead of <A-1c>. (Yield 51%)

### Synthesis Example 12-2: Synthesis of L-2

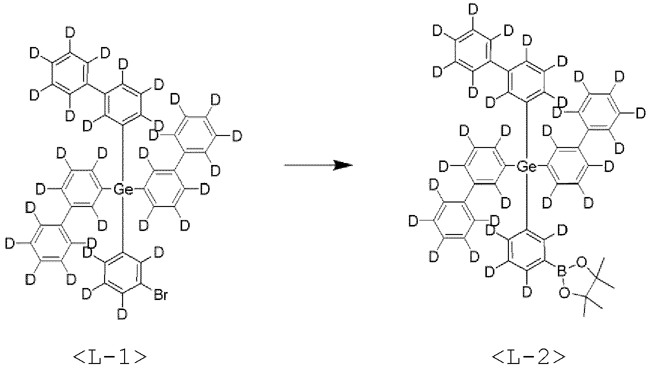

<L-2> was obtained in the same manner as in Synthesis Example 1-2, except that <L-1> was used instead of <A-1>. (Yield 73%)

### Synthesis Example 12-3: Synthesis of [ET-12]

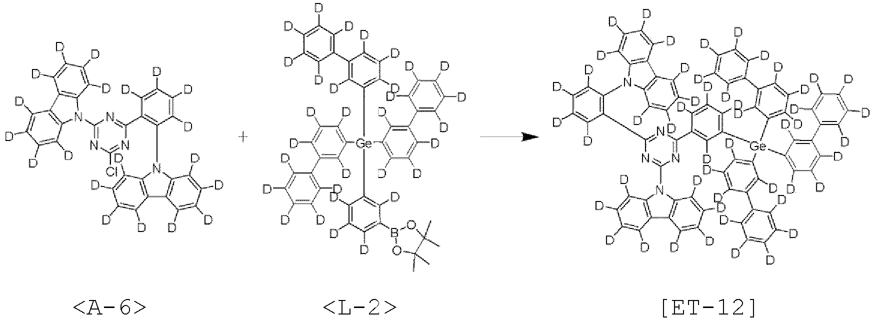

[ET-12] was obtained in the same manner as in Synthesis Example 1-7, except that <L-2> was used instead of <A-2>. (Yield 55%)
MS (MALDI-TOF): m/z 1146.66 [M⁺]

### Synthesis Example 13: Synthesis of [ET-13]

### Synthesis Example 13-1: Synthesis of M-1

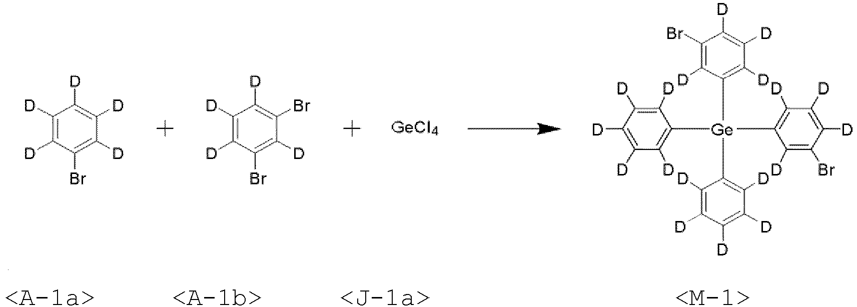

<M-1> was obtained in the same manner as in Synthesis Example 2-1, except that <J-la> was used instead of <A-1c>. (Yield 59%)

### Synthesis Example 13-2: Synthesis of M-2

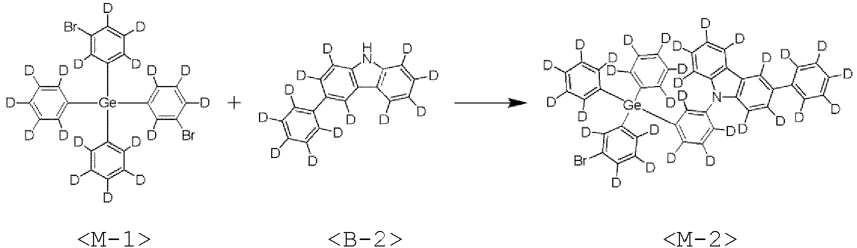

<M-2> was obtained in the same manner as in Synthesis Example 2-3, except that <M-1> was used instead of <B-1>. (Yield 62%)

### Synthesis Example 13-3: Synthesis of M-3

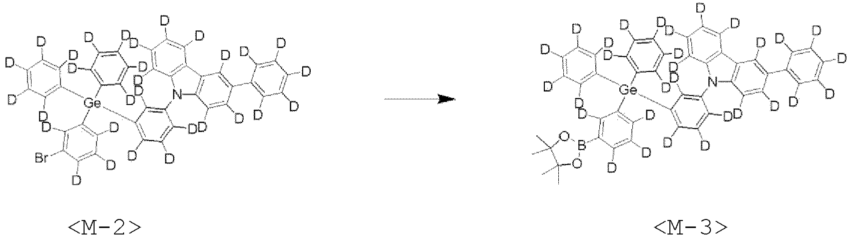

<M-3> was obtained in the same manner as in Synthesis Example 1-2, except that <M-2> was used instead of <A-1>. (Yield 72%)

### Synthesis Example 13-4: Synthesis of [ET-13]

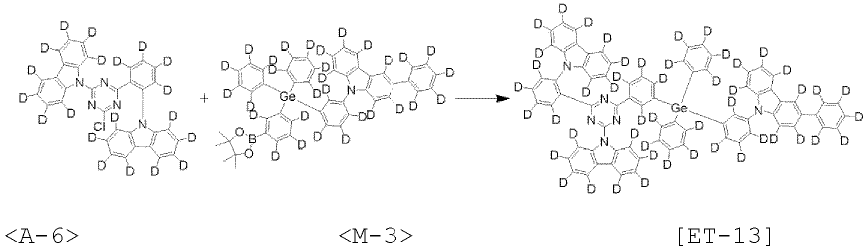

[ET-13] was obtained in the same manner as in Synthesis Example 1-7, except that <M-3> was used instead of <A-2>. (Yield 64%)
MS (MALDI-TOF): m/z 1158.64 [M⁺]

### Synthesis Example 14: Synthesis of [ET-14]

### Synthesis Example 14-1: Synthesis of N-1

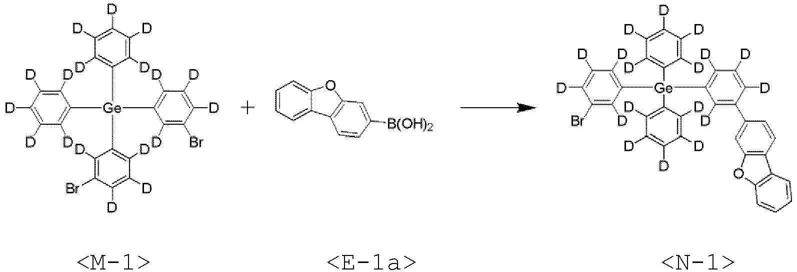

<N-1> was obtained in the same manner as in Synthesis Example 5-1, except that <M-1> was used instead of <B-1>. (Yield 58%)

### Synthesis Example 14-2: Synthesis of N-2

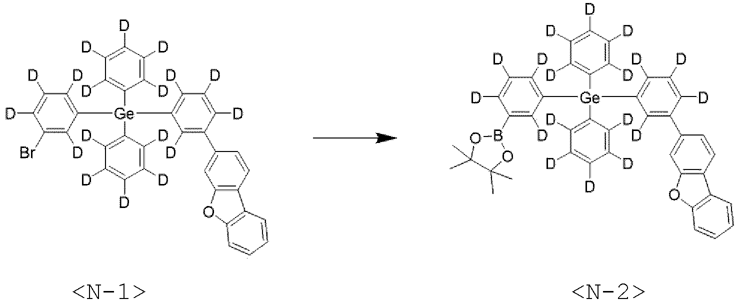

<N-2> was obtained in the same manner as in Synthesis Example 1-2, except that <N-1> was used instead of <A-1>. (Yield 75%)

### Synthesis Example 14-3: Synthesis of [ET-14]

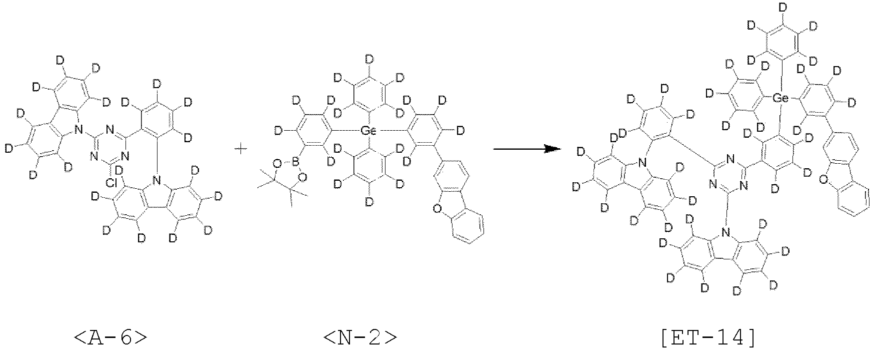

[ET-14] was obtained in the same manner as in Synthesis Example 1-7, except that <N-2> was used instead of <A-2>. (Yield 66%)
MS (MALDI-TOF): m/z 1071.52 [M⁺]

### Synthesis Example 15: Synthesis of [ET-15]

### Synthesis Example 15-1: Synthesis of [ET-15]

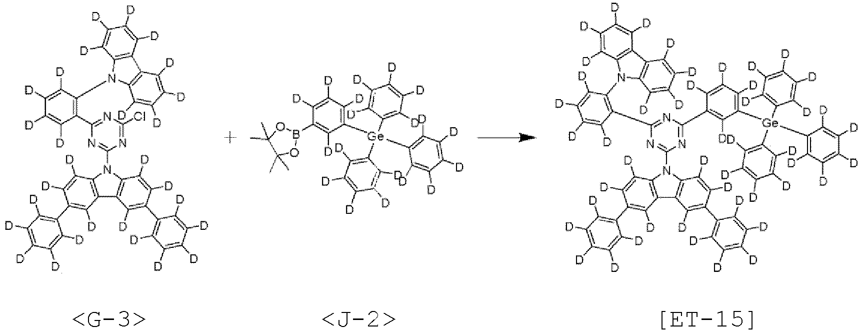

[ET-15] was obtained in the same manner as in Synthesis Example 7-4, except that <J-2> was used instead of <A-2>. (Yield 62%)
MS (MALDI-TOF): m/z 1066.60 [M⁺]

### Examples 1 to 28: Manufacture of Organic Light Emitting Device

An ITO glass was patterned to have a light emitting area of 2 mm×2 mm, and then cleaned. The ITO glass was installed in a vacuum chamber, and after setting the base pressure at 1×10⁻⁶ torr, HATCN (50 Å) was deposited as a hole injecting layer, BCFN (600 Å) was deposited as a hole transport layer, and then PBCz (50 Å) was deposited as an electron blocking layer on the ITO glass. As a light emitting layer, the first host compound and the second host compound according to the present invention, and 12 wt% of a dopant compound PBD were mixed, and deposited (350 Å). Then, mSiTrz (50 Å) was deposited as a hole blocking layer, mSiTrz:Liq (300 Å) in a ratio of 1:1 were deposited as an electron injecting and transport layer, and then Liq (10 Å) was deposited as an electron injecting layer sequentially, and Al (1000 Å) was deposited as a cathode to manufacture an organic light emitting device. Luminous characteristics of the organic light emitting device were measured at 0.4 mA.

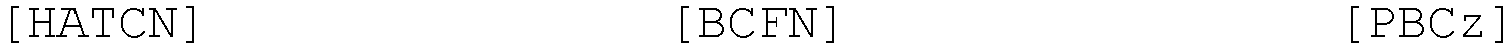

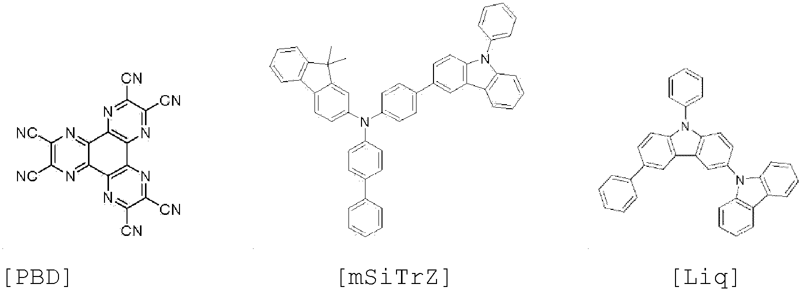

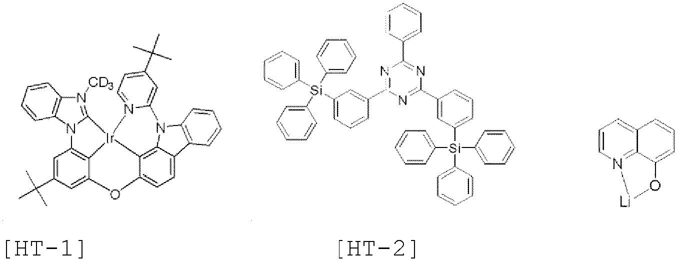

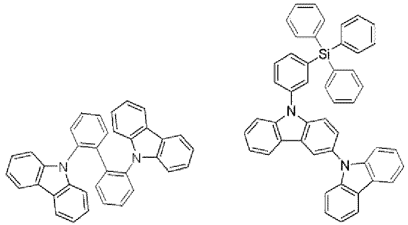

### Comparative Examples 1 to 14

Organic light emitting devices for Comparative Examples were manufactured in the same manner as in Examples, except that the following [RH-1] to [RH-7] were used as the host compound instead of the compound according to the present invention in the device structures of Examples, and luminous characteristics of the organic light emitting devices were measured at 0.4 mA. The structures of [RH-1] to [RH-7] are as follows.

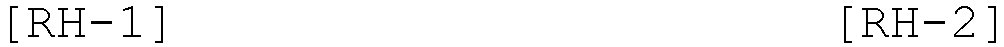

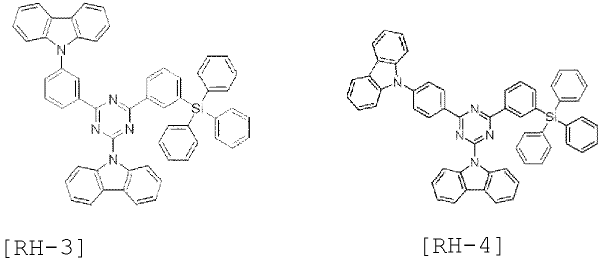

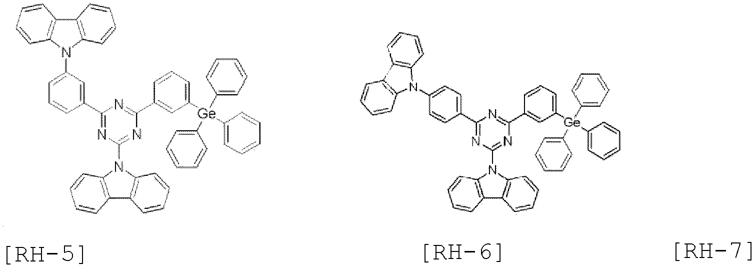

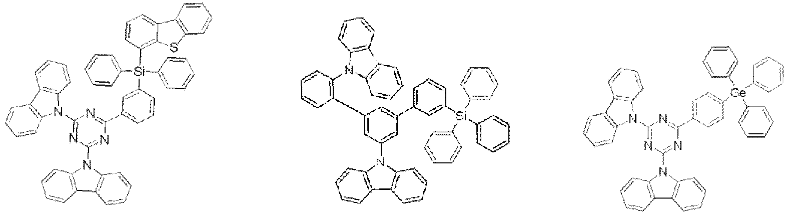

**[Table 1]**

| Category | First Host | Second Host | Drivin g Voltag e (V) | External Quantum Efficiency (%) | Light Emitti ng Color | Lifet ime (LT95 , hr) |
|---|---|---|---|---|---|---|
| Example 1 | ET-1 | HT-1 | 4.4 | 16.8 | Blue | 162 |
| Example 2 | ET-2 | HT-1 | 4.5 | 17.0 | Blue | 143 |
| Example 3 | ET-3 | HT-1 | 4.4 | 16.6 | Blue | 136 |
| Example 4 | ET-4 | HT-1 | 4.5 | 17.1 | Blue | 168 |
| Example 5 | ET-5 | HT-1 | 4.6 | 16.7 | Blue | 130 |
| Example 6 | ET-6 | HT-1 | 4.6 | 16.5 | Blue | 134 |
| Example 7 | ET-7 | HT-1 | 4.6 | 17.3 | Blue | 155 |
| Example 8 | ET-8 | HT-1 | 4.5 | 17.4 | Blue | 156 |
| Example 9 | ET-9 | HT-1 | 4.6 | 17.2 | Blue | 154 |
| Example 10 | ET-10 | HT-1 | 4.7 | 17.3 | Blue | 160 |
| Example 11 | ET-11 | HT-1 | 4.8 | 17.2 | Blue | 158 |
| Example 12 | ET-12 | HT-1 | 4.7 | 17.4 | Blue | 161 |
| Example 13 | ET-13 | HT-1 | 4.8 | 17.4 | Blue | 158 |
| Example 14 | ET-14 | HT-1 | 4.8 | 17.6 | Blue | 157 |
| Example 15 | ET-15 | HT-1 | 4.8 | 17.3 | Blue | 156 |
| Example 16 | ET-1 | HT-2 | 4.5 | 16.9 | Blue | 148 |
| Example 17 | ET-2 | HT-2 | 4.5 | 17.2 | Blue | 146 |
| Example 18 | ET-4 | HT-2 | 4.6 | 17.3 | Blue | 161 |
| Example 19 | ET-5 | HT-2 | 4.5 | 16.8 | Blue | 134 |
| Example 20 | ET-7 | HT-2 | 4.6 | 17.4 | Blue | 160 |
| Example 21 | ET-8 | HT-2 | 4.6 | 17.5 | Blue | 159 |
| Example 22 | ET-9 | HT-2 | 4.6 | 17.4 | Blue | 158 |
| Example 23 | ET-10 | HT-2 | 4.7 | 17.3 | Blue | 156 |
| Example 24 | ET-11 | HT-2 | 4.7 | 17.3 | Blue | 157 |
| Example 25 | ET-12 | HT-2 | 4.8 | 17.5 | Blue | 156 |
| Example 26 | ET-13 | HT-2 | 4.7 | 17.4 | Blue | 158 |
| Example 27 | ET-14 | HT-2 | 4.8 | 17.6 | Blue | 156 |
| Example 28 | ET-15 | HT-2 | 4.8 | 17.4 | Blue | 155 |
| Comparative Example 1 | RH-1 | HT-1 | 5.1 | 14.2 | Blue | 85 |
| Comparative Example 2 | RH-2 | HT-1 | 5.2 | 13.8 | Blue | 74 |
| Comparative Example 3 | RH-3 | HT-1 | 5.3 | 14.3 | Blue | 87 |
| Comparative Example 4 | RH-4 | HT-1 | 5.4 | 14.0 | Blue | 79 |
| Comparative Example 5 | RH-5 | HT-1 | 5.3 | 13.6 | Blue | 64 |
| Comparative Example 6 | RH-6 | HT-1 | 5.9 | 8.3 | Blue | 21 |
| Comparative Example 7 | RH-7 | HT-1 | 5.3 | 13.6 | Blue | 65 |
| Comparative Example 8 | RH-1 | HT-2 | 5.3 | 14.0 | Blue | 82 |
| Comparative Example 9 | RH-2 | HT-2 | 5.4 | 13.5 | Blue | 71 |
| Comparative Example 10 | RH-3 | HT-2 | 5.5 | 14.3 | Blue | 84 |
| Comparative Example 11 | RH-4 | HT-2 | 5.5 | 13.8 | Blue | 75 |
| Comparative Example 12 | RH-5 | HT-2 | 5.4 | 13.8 | Blue | 68 |
| Comparative Example 13 | RH-6 | HT-2 | 6.0 | 8.2 | Blue | 20 |
| Comparative Example 14 | RH-7 | HT-2 | 5.5 | 13.7 | Blue | 69 |

As shown in [Table 1], the device employing the compound according to the present invention as a light emitting layer host compound in the organic light emitting device may be embodied as a high-efficiency and long-lifetime organic light emitting device with excellent external quantum efficiency and lifetime properties at a low driving voltage compared to the devices (Comparative Examples 1 to 14) employing compounds widely used in the related art having structures in contrast to the characteristic structures of the compound according to the present invention.

### Examples 29 to 56: Manufacture of Organic Light Emitting Device

Organic light emitting devices were manufactured in the same manner as in Examples Example 1 to 28, except that 0.5 wt% of a dopant compound BD-1 according to the present invention was further mixed. Luminous characteristics of the organic light emitting devices were measured at 0.4 mA.

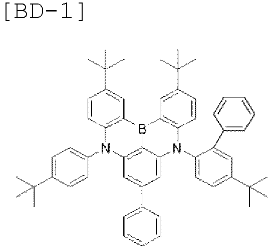

### Comparative Examples 15 to 28

Organic light emitting devices for Comparative Examples were manufactured in the same manner as in Examples, except that [RH-1] to [RH-7] were used as the host compound instead of the compound according to the present invention in the device structures of Examples. Luminous characteristics of the organic light emitting devices were measured at 0.4 mA.

**[Table 2]**

| Category | First Host | Second Host | Driving Voltage (V) | External Quantum Efficien cy (%) | Light Emitti ng Color | Lifeti me (LT95, hr) |
|---|---|---|---|---|---|---|
| Example 29 | ET-1 | HT-1 | 4.4 | 17.3 | Blue | 195 |
| Example 30 | ET-2 | HT-1 | 4.5 | 17.5 | Blue | 148 |
| Example 31 | ET-3 | HT-1 | 4.4 | 17.1 | Blue | 142 |
| Example 32 | ET-4 | HT-1 | 4.4 | 17.6 | Blue | 220 |
| Example 33 | ET-5 | HT-1 | 4.5 | 17.2 | Blue | 137 |
| Example 34 | ET-6 | HT-1 | 4.5 | 17.0 | Blue | 138 |
| Example 35 | ET-7 | HT-1 | 4.6 | 17.7 | Blue | 160 |
| Example 36 | ET-8 | HT-1 | 4.5 | 17.8 | Blue | 161 |
| Example 37 | ET-9 | HT-1 | 4.6 | 17.7 | Blue | 163 |
| Example 38 | ET-10 | HT-1 | 4.5 | 17.4 | Blue | 188 |
| Example 39 | ET-11 | HT-1 | 4.6 | 17.5 | Blue | 145 |
| Example 40 | ET-12 | HT-1 | 4.6 | 17.8 | Blue | 203 |
| Example 41 | ET-13 | HT-1 | 4.5 | 17.6 | Blue | 160 |
| Example 42 | ET-14 | HT-1 | 4.7 | 17.8 | Blue | 165 |
| Example 43 | ET-15 | HT-1 | 4.6 | 17.8 | Blue | 163 |
| Example 44 | ET-1 | HT-2 | 4.5 | 17.3 | Blue | 154 |
| Example 45 | ET-2 | HT-2 | 4.5 | 17.7 | Blue | 152 |
| Example 46 | ET-4 | HT-2 | 4.6 | 17.8 | Blue | 170 |
| Example 47 | ET-5 | HT-2 | 4.5 | 17.3 | Blue | 137 |
| Example 48 | ET-7 | HT-2 | 4.5 | 17.9 | Blue | 170 |
| Example 49 | ET-8 | HT-2 | 4.6 | 17.9 | Blue | 164 |
| Example 50 | ET-9 | HT-2 | 4.5 | 17.8 | Blue | 165 |
| Example 51 | ET-10 | HT-2 | 4.4 | 17.3 | Blue | 170 |
| Example 52 | ET-11 | HT-2 | 4.5 | 17.4 | Blue | 142 |
| Example 53 | ET-12 | HT-2 | 4.5 | 17.7 | Blue | 171 |
| Example 54 | ET-13 | HT-2 | 4.5 | 17.4 | Blue | 165 |
| Example 55 | ET-14 | HT-2 | 4.6 | 17.6 | Blue | 165 |
| Example 56 | ET-15 | HT-2 | 4.5 | 17.7 | Blue | 146 |
| Comparative Example 15 | RH-1 | HT-1 | 5.0 | 14.4 | Blue | 88 |
| Comparative Example 16 | RH-2 | HT-1 | 5.1 | 14.0 | Blue | 76 |
| Comparative Example 17 | RH-3 | HT-1 | 5.2 | 14.5 | Blue | 87 |
| Comparative Example 18 | RH-4 | HT-1 | 5.2 | 14.2 | Blue | 78 |
| Comparative Example 19 | RH-5 | HT-1 | 5.3 | 13.9 | Blue | 66 |
| Comparative Example 20 | RH-6 | HT-1 | 5.9 | 8.2 | Blue | 21 |
| Comparative Example 21 | RH-7 | HT-1 | 5.4 | 13.9 | Blue | 67 |
| Comparative Example 22 | RH-1 | HT-2 | 5.2 | 13.9 | Blue | 84 |
| Comparative Example 23 | RH-2 | HT-2 | 5.3 | 13.3 | Blue | 73 |
| Comparative Example 24 | RH-3 | HT-2 | 5.4 | 14.1 | Blue | 87 |
| Comparative Example 25 | RH-4 | HT-2 | 5.4 | 13.4 | Blue | 71 |
| Comparative Example 26 | RH-5 | HT-2 | 5.4 | 14.1 | Blue | 73 |
| Comparative Example 27 | RH-6 | HT-2 | 5.9 | 8.1 | Blue | 19 |
| Comparative Example 28 | RH-7 | HT-2 | 5.4 | 14.0 | Blue | 74 |

As shown in [Table 2], the device employing the compound according to the present invention as a host compound of a light emitting layer in the organic light emitting device may be embodied as a high-efficiency and long-lifetime organic light emitting device with excellent external quantum efficiency and lifetime properties at a low driving voltage compared to the devices (Comparative Examples 15 to 28) employing compounds widely used in the related art having structures in contrast to the characteristic structures of the compound according to the present invention.

### Evaluation Example 1: Measurements of HOMO, LUMO, Singlet and Triplet Levels

HOMO and LUMO energy levels and energies of the lowest triplet state (T₁) and the lowest excited singlet state (S₁) are determined through quantum chemistry calculations, and for this purpose, a "Gaussian09W" software package was used to conduct the measurements on the compounds according to the present invention using a "6-31G(d)" base set method. The results are shown in the following [Table 3].

### [Compound 1 of Present Invention] [Compound 2 of Present Invention]

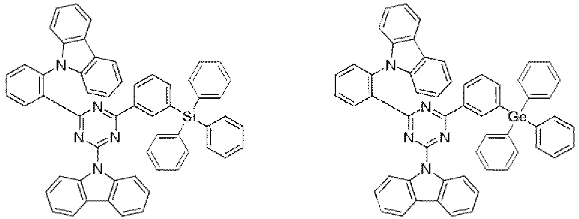

In addition, as may be identified above, the compound according to the present invention is characterized in that carbazole substitutes at the ortho position based on the phenyl group, a linking group between triazine and the carbazole.

In contrast, the following compounds of Comparative Examples are (i) compounds in which carbazole substitutes at the meta position based on the phenyl group, a linking group between triazine and the carbazole (RH-1 and RH-3), and (ii) compounds in which carbazole substitutes at the para position based on the phenyl group, a linking group between triazine and the carbazole (RH-2 and RH-4), and measurements were conducted thereon under the same condition.

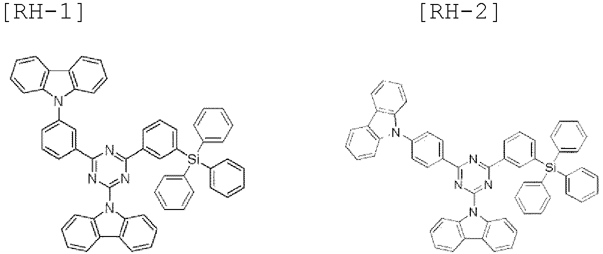

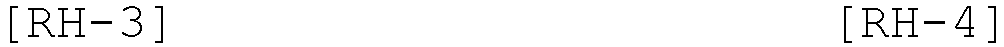

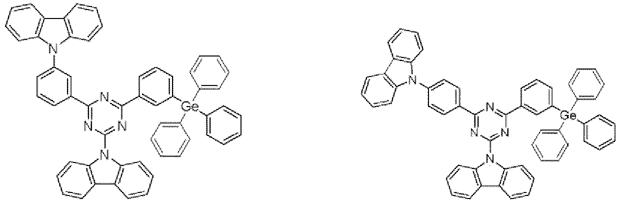

**[Table 3]**

| Compound | HOMO | LUMO | T₁ (eV) | PL max (nm) |
|---|---|---|---|---|
| Compound 1 of Present Invention | -5.256 | -1.828 | 2.78 | 446 |
| Compound 2 of Present Invention | -5.231 | -1.834 | 2.77 | 448 |
| RH-1 | -5.350 | -2.028 | 2.72 | 455 |
| RH-2 | -5.430 | -1.995 | 2.70 | 458 |
| RH-3 | -5.355 | -2.025 | 2.73 | 454 |
| RH-4 | -5.429 | -1.994 | 2.70 | 458 |

As shown in [Table 3], it may be identified that all the measured compounds have triplet energy values of 2.7 eV or greater. As the triplet energy value is higher, triplet excitons not quickly relaxed to light may be more quickly transferred in an OLED, and a device using a thermally activated delayed fluorescent dopant such as BD-1 therewith may prevent energy transferred from the host from being transferred back again. It may be identified that, for such reasons, RH-1 to RH-4 in [Table 1] and [Table 2] show lower external quantum efficiency and lifetime compared to the compounds of the present invention.

## Claims

1. An organic compound represented by the following [Formula 1]: 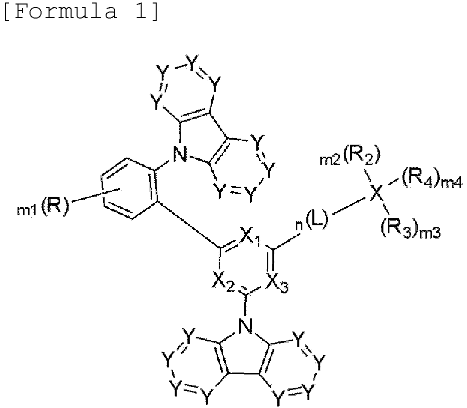 wherein, in [Formula 1],
X is Si or Ge;
X₁ to X₃ are the same as or different from each other and each independently N or CR₁, and at least one of X₁ to X₃ is N;
Ys are the same as or different from each other, and each independently N or CR₅;
R₂ to R₄ are the same as or different from each other, and each independently any one selected from substituted or unsubstituted C₁-C₃₀ alkyl, substituted or unsubstituted C₂-C₃₀ alkynyl, substituted or unsubstituted C₂-C₃₀ alkenyl, substituted or unsubstituted C₆-C₅₀ aryl, substituted or unsubstituted C₃-C₅₀ cycloalkyl, substituted or unsubstituted C₂-C₅₀ heterocycloalkyl, substituted or unsubstituted C₂-C₅₀ heteroaryl, and substituted or unsubstituted cyclic groups in which a C₃-C₃ₒ aliphatic ring and a C₅-C₃₀ aromatic ring are fused together;
R, R₁ and R₅ are the same as or different from each other, and each independently any one selected from hydrogen, deuterium, substituted or unsubstituted C₁-C₃₀ alkyl, substituted or unsubstituted C₂-C₃₀ alkynyl, substituted or unsubstituted C₂-C₃₀ alkenyl, substituted or unsubstituted C₆-C₅₀ aryl, substituted or unsubstituted C₃-C₅₀ cycloalkyl, substituted or unsubstituted C₂-C₅₀ heterocycloalkyl, substituted or unsubstituted C₂-C₅₀ heteroaryl, substituted or unsubstituted cyclic groups in which a C₃-C₃₀ aliphatic ring and a C₅-C₃₀ aromatic ring are fused together, substituted or unsubstituted C₁-C₃₀ alkoxy, substituted or unsubstituted C₆-C₃₀ aryloxy, substituted or unsubstituted C₁-C₃₀ alkylthioxy, substituted or unsubstituted C₅-C₃₀ arylthioxy, substituted or unsubstituted amine, substituted or unsubstituted silyl, substituted or unsubstituted germanium, nitro, cyano and halogen;
Ls are the same as or different from each other, and each independently a single bond, or any one selected from substituted or unsubstituted C₆-C₃₀ arylene, substituted or unsubstituted C₂-C₃₀ heteroarylene, and substituted or unsubstituted divalent cyclic groups in which a C₃-C₂₄ aliphatic ring and a C₅-C₂₄ aromatic ring are fused together;
n is an integer of 1 to 3, and when n is an integer of 2 or greater, Ls are the same as or different from each other;
m₁ is an integer of 4, and Rs are the same as or different from each other;
m₂ to m₄ are the same as or different from each other, and each independently an integer of 1 to 3, and when m₂ to m₄ are each an integer of 2 or greater, R₂s to R₄s are the same as or different from each other;
the plurality of adjacent Rs and R₅s are optionally linked to each other to further form an alicyclic or aromatic monocyclic or polycyclic ring; and
the term 'substituted' in the 'substituted or unsubstituted' in [Formula 1] means being substituted with one, or two or more substituents selected from the group consisting of deuterium, C₁-C₂₄ alkyl, C₁-C₂₄ haloalkyl, C₂-C₂₄ alkenyl, C₂-C₂₄ alkynyl, C₃-C₃₀ cycloalkyl, C₁-C₂₄ heteroalkyl, C₆-C₃₀ aryl, C₇-C₃₀ arylalkyl, C₇-C₃₀ alkylaryl, C₂-C₃₀ heteroaryl, C₂-C₃₀ heteroarylalkyl, cyclic groups in which a C₃-C₂₄ aliphatic ring and a C₅-C₂₄ aromatic ring are fused together, C₁-C₂₄ alkoxy, C₁-C₃₀ amine, C₁-C₃₀ silyl, C₁-C₃₀ germanium, C₆-C₂₄ aryloxy, C₃-C₂₄ arylthionyl, cyano, halogen, hydroxyl and nitro, or being substituted with a substituent in which two or more of the above-mentioned substituents are linked, and hydrogen atoms in the substituents are optionally substituted with one or more deuterium atoms, and two or more adjacent ones of the substituents are optionally linked to each other to further form an alicyclic or aromatic monocyclic or polycyclic ring.

2. The organic compound according to claim 1, wherein R₂ to R₄ are the same as or different from each other, and each independently any one selected from C₆-C₂₀ aryl unsubstituted or substituted with deuterium, C₅-C₂₀ heteroaryl unsubstituted or substituted with deuterium, and cyclic groups unsubstituted or substituted with deuterium in which a C₃-C₁₈ aliphatic ring and a C₅-C₁₈ aromatic ring are fused together.

3. The organic compound according to claim 1, wherein all of X₁ to X₃ are each N.

4. The organic compound according to claim 1, wherein all of Ys are each CR₅.

5. The organic compound according to claim 4, wherein each of R₅s is deuterium.

6. The organic compound according to claim 1, wherein Rs are the same as or different from each other, and each independently hydrogen or deuterium.

7. The organic compound according to claim 1, wherein X is Ge.

8. The organic compound according to claim 1, wherein n is an integer of 1, and L is C₆-C₂₀ arylene unsubstituted or substituted with deuterium.

9. The organic compound according to claim 1, wherein [Formula 1] is any one selected from compounds represented by the following formulae:

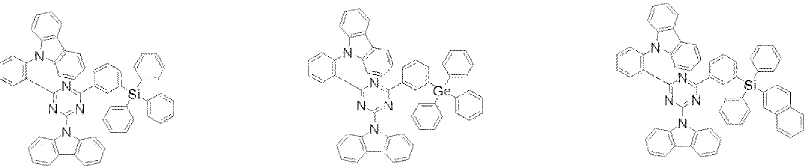

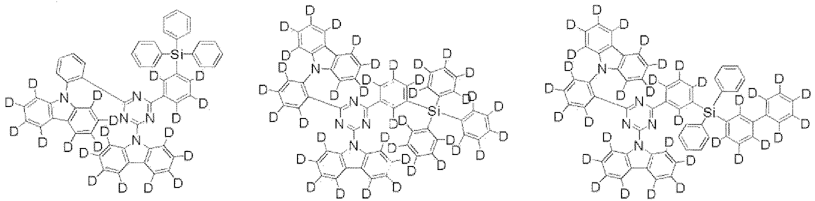

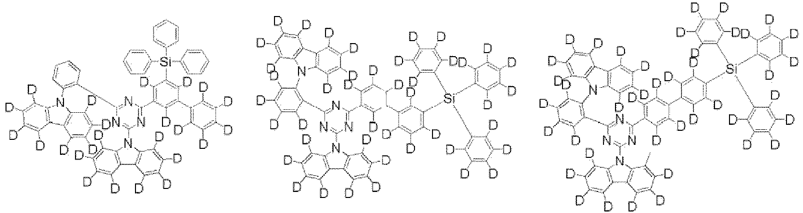

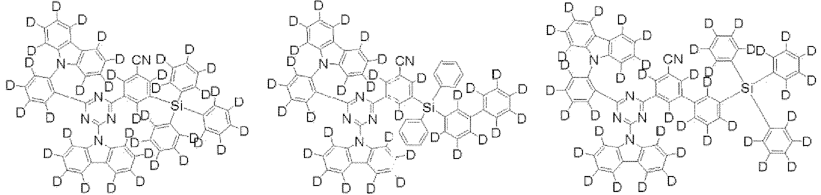

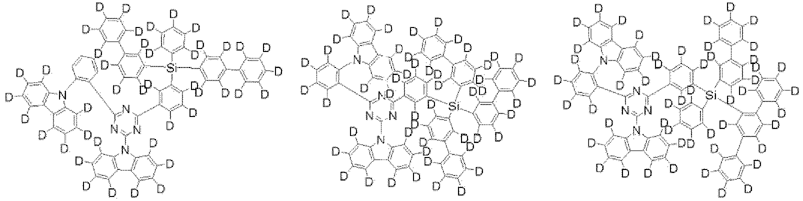

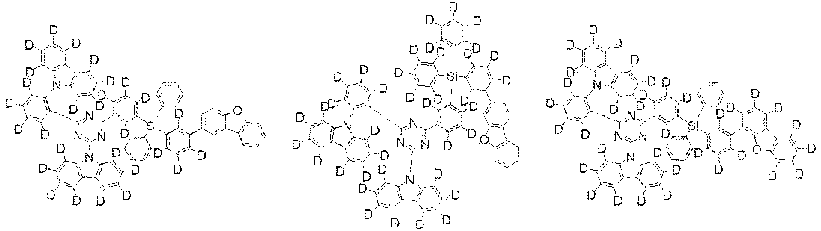

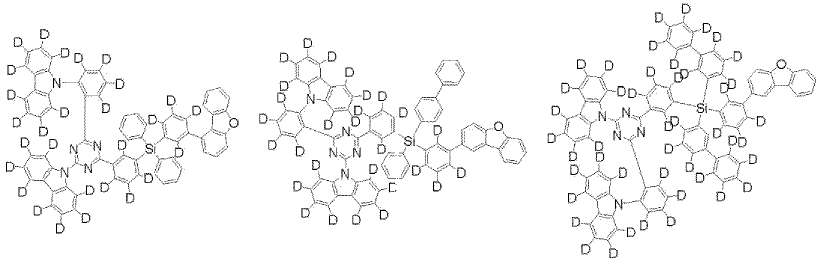

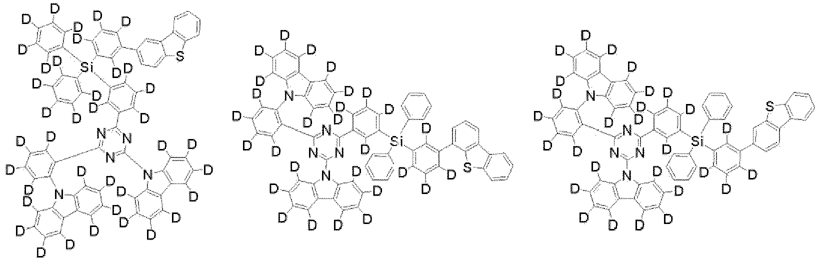

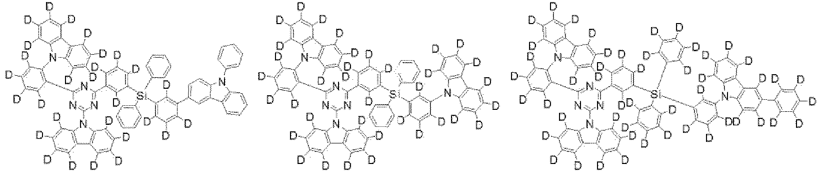

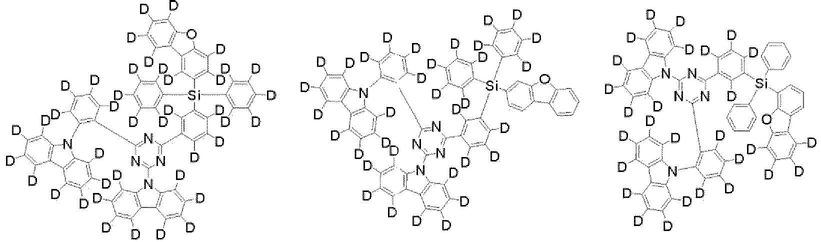

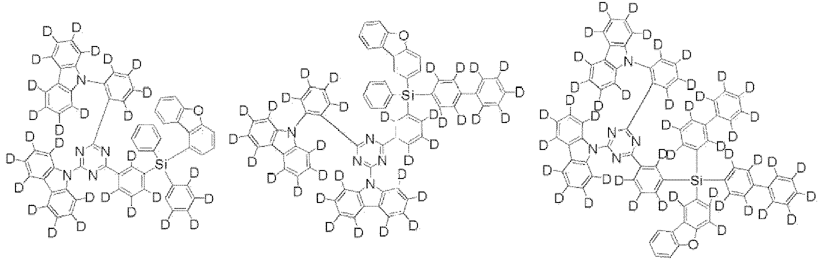

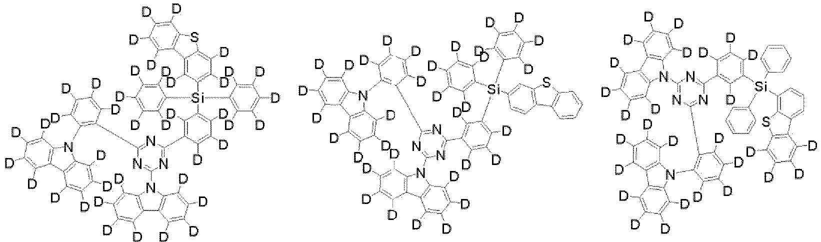

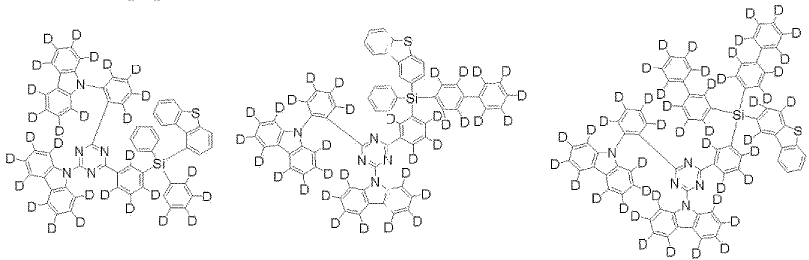

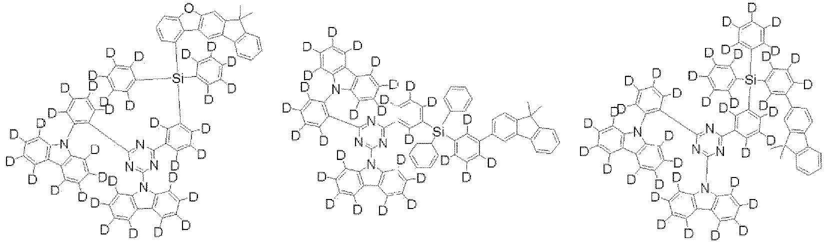

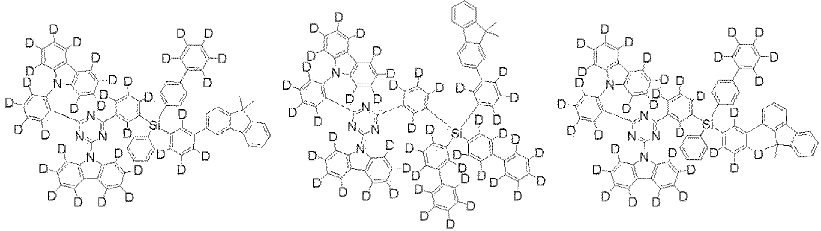

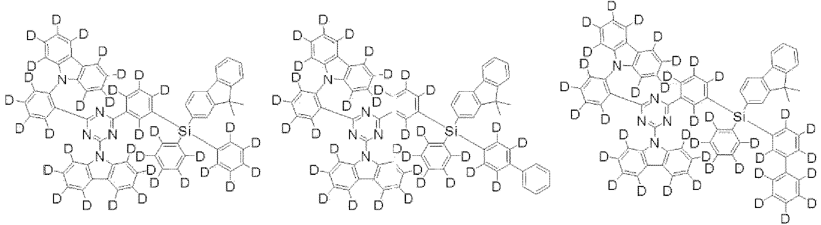

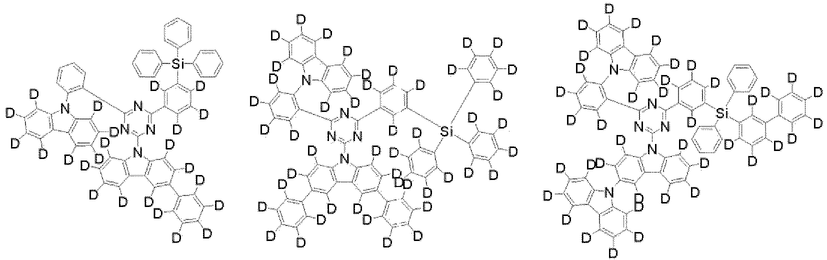

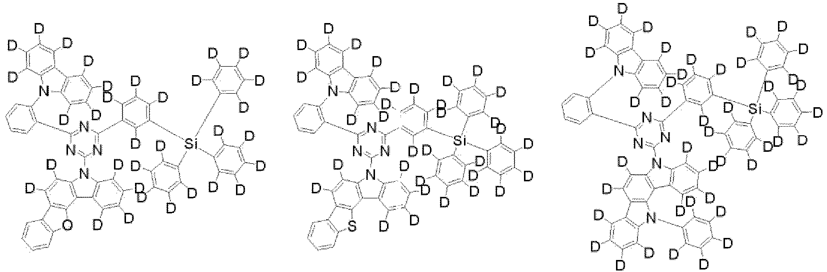

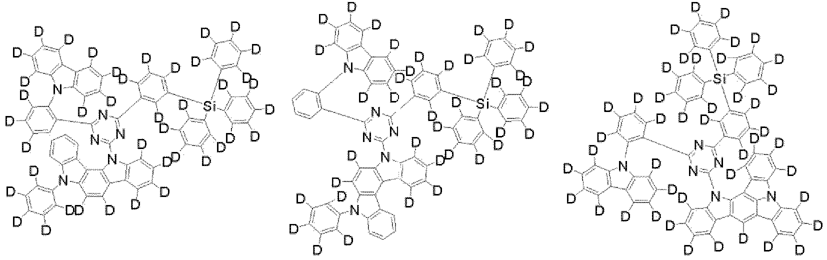

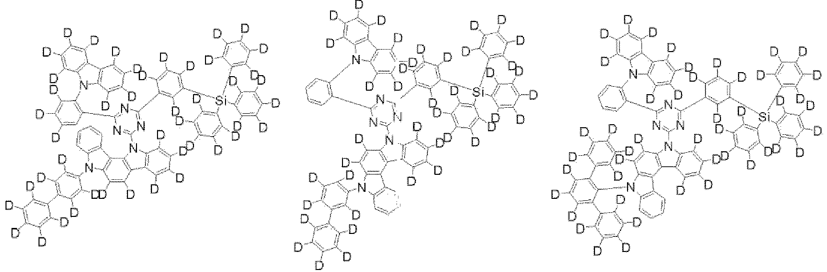

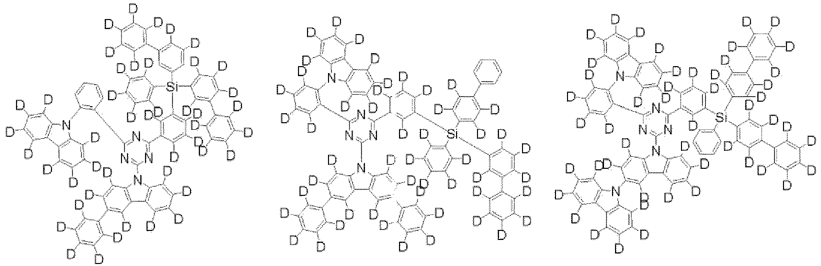

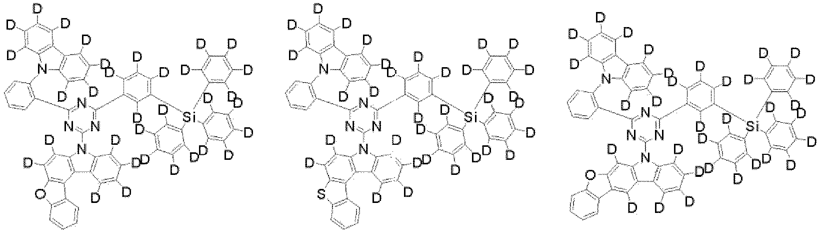

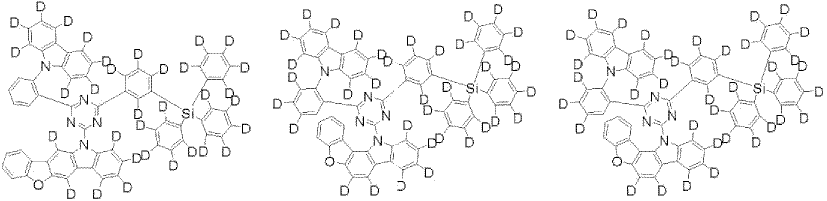

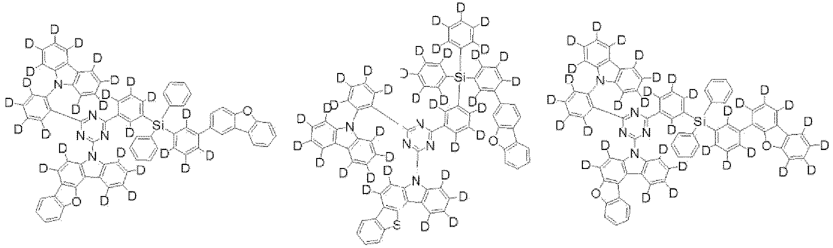

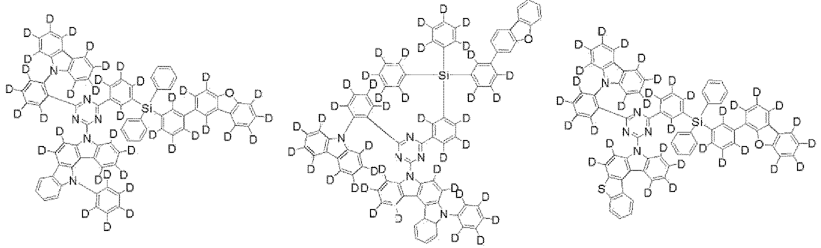

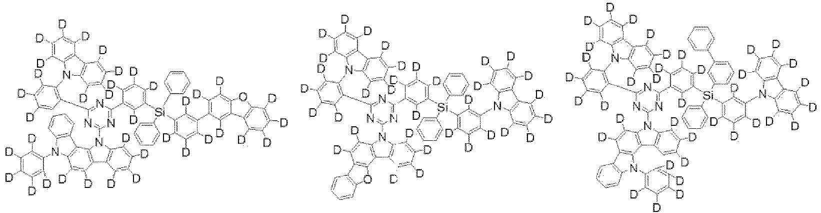

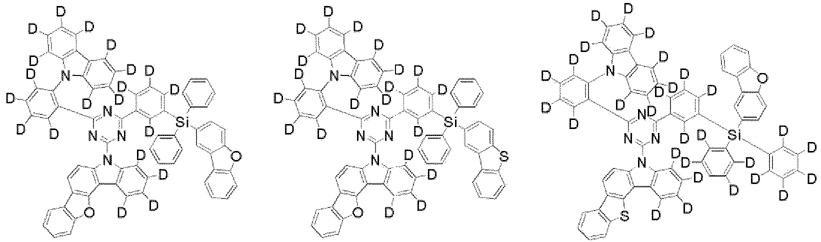

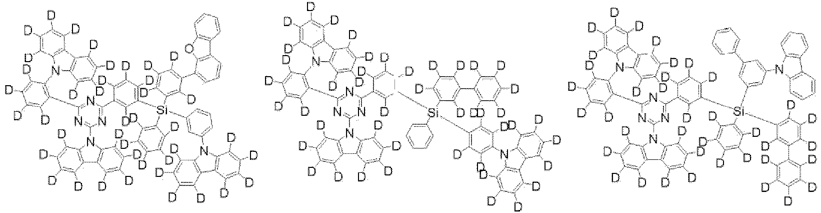

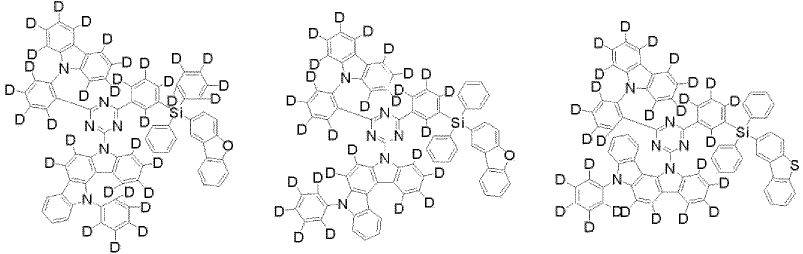

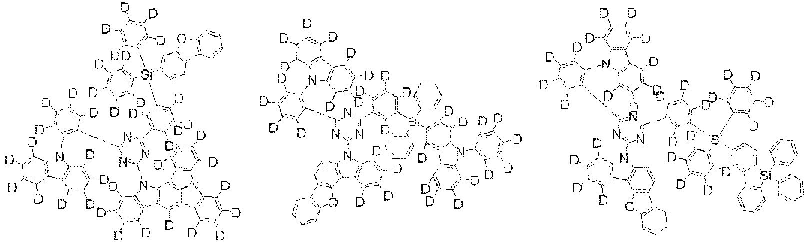

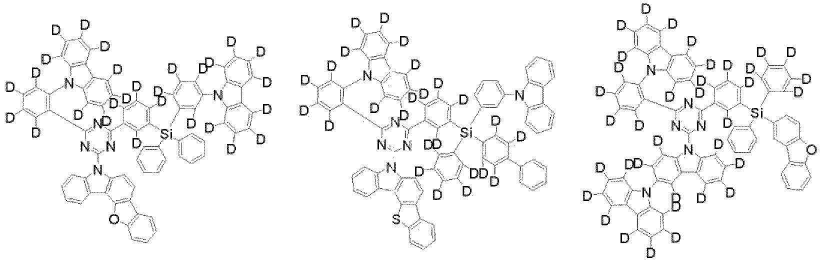

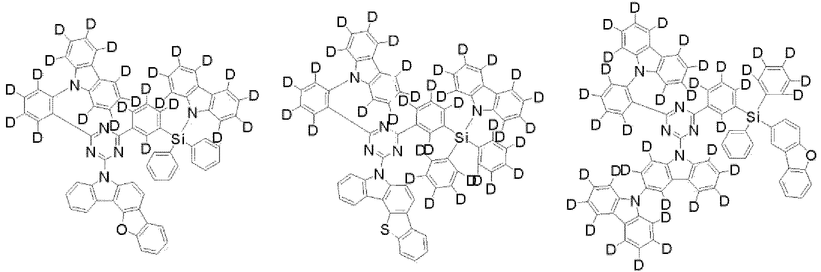

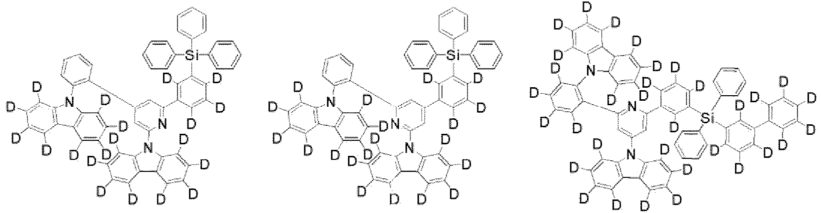

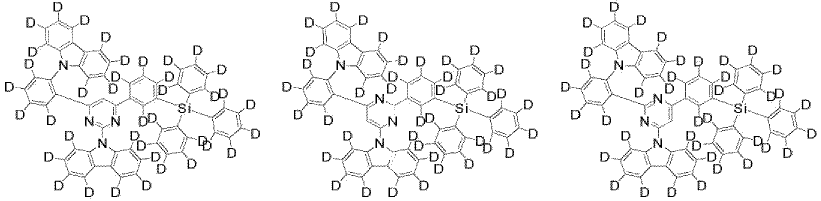

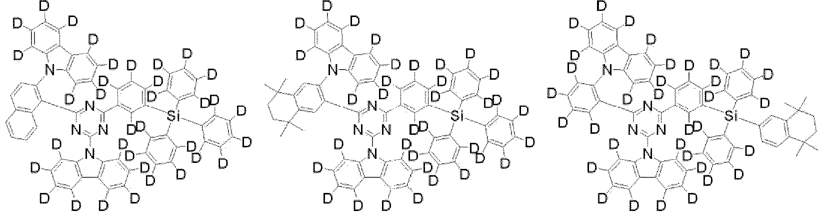

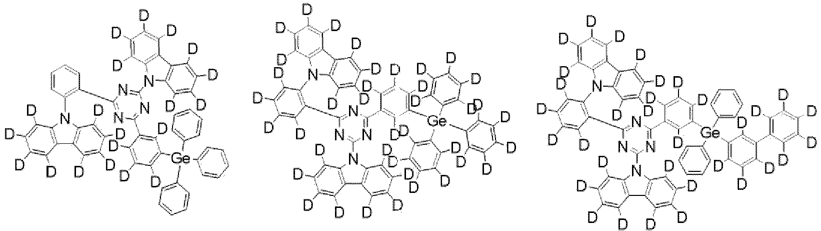

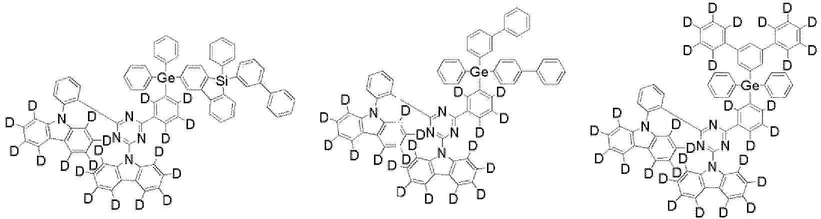

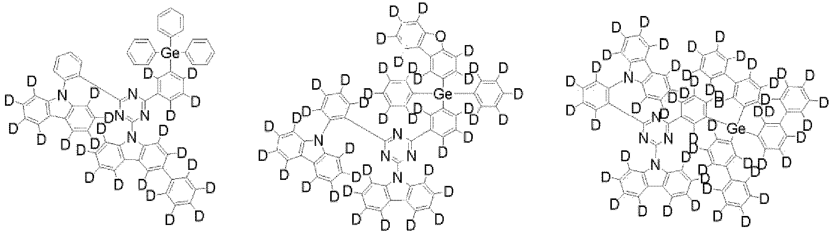

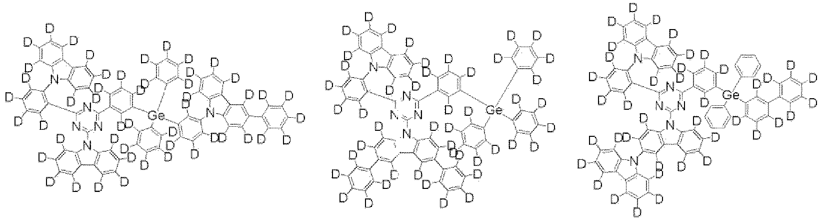

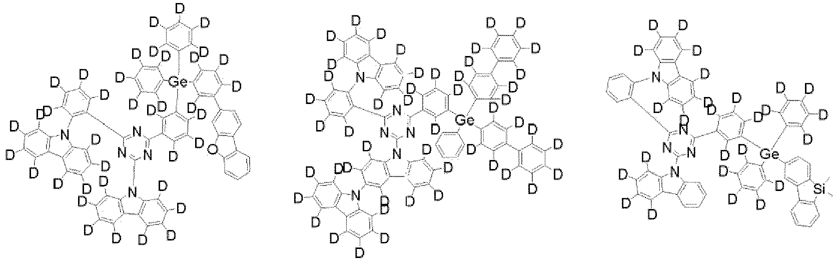

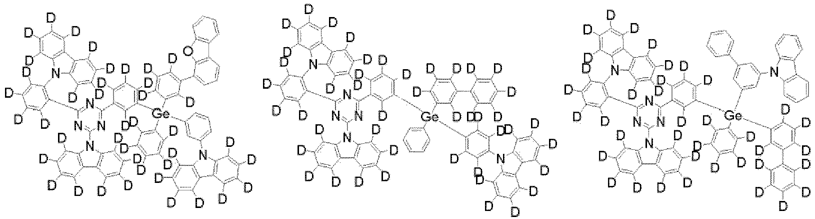

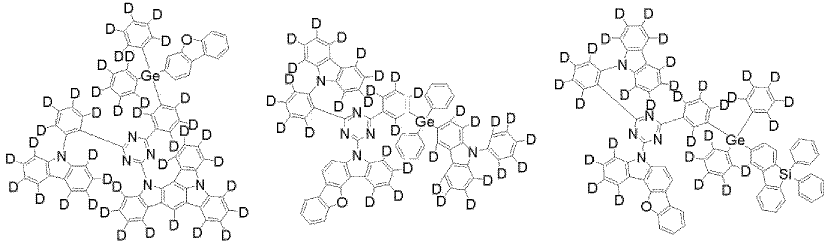

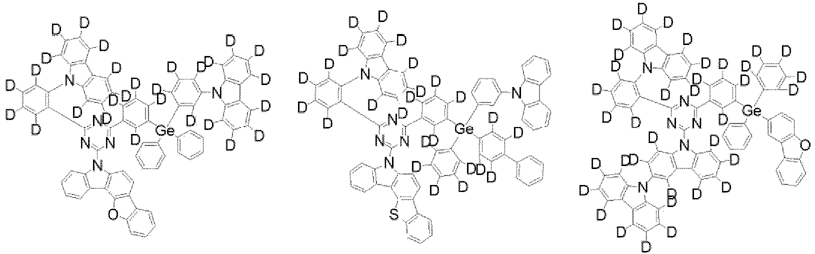

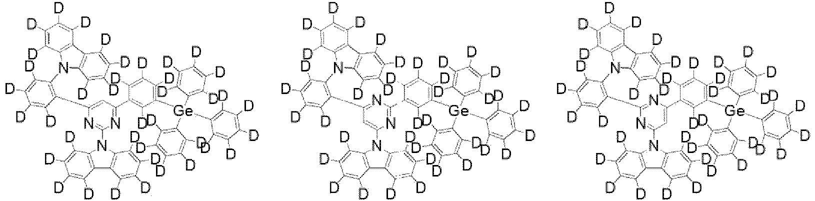

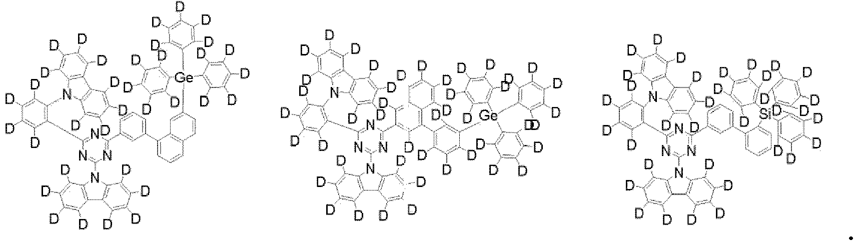

10. An organic light emitting device comprising:
a first electrode;
a second electrode opposite to the first electrode; and
an organic layer interposed between the first electrode and the second electrode,
wherein the organic layer includes a light emitting layer including a host and a dopant; and **characterized in that**
the host includes at least one type of the organic compound represented by [Formula 1] according to claim 1.

11. The organic light emitting device according to claim 10, wherein one or more types of other compounds in addition to the one type of organic compound represented by [Formula 1] is mixed or stacked and used as the host.

12. The organic light emitting device according to claim 10, wherein the organic compound represented by [Formula 1] used as the host is used as a blue phosphorescent host.

13. The organic light emitting device according to claim 10, wherein the dopant includes at least one organometallic compound.

14. The organic light emitting device according to claim 13, wherein a polycyclic ring compound represented by the following [Formula 2] is mixed or stacked and used in addition to the organometallic compound: 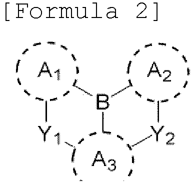 in [Formula 2],
Y₁ and Y₂ are the same as or different from each other, and each independently any one selected from O, S, NR₁₁, CR₁₂R₁₃, SiR₁₄R₁₅ and GeR₁₆R₁₇;
A₁ to A₃ are the same as or different from each other, and each independently any one selected from substituted or unsubstituted C₆-C₃₀ aromatic hydrocarbon rings, substituted or unsubstituted C₃-C₃₀ aliphatic hydrocarbon rings, substituted or unsubstituted C₂-C₃₀ aromatic heterocyclic rings, substituted or unsubstituted C₂-C₃₀ aliphatic heterocyclic rings, and substituted or unsubstituted cyclic groups in which a C₃-C₂₄ aliphatic ring and a C₅-C₂₄ aromatic ring are fused together;
R₁₁ to R₁₇ are the same as or different from each other, and each independently any one selected from hydrogen, deuterium, substituted or unsubstituted C₁-C₃₀ alkyl, substituted or unsubstituted C₂-C₃₀ alkynyl, substituted or unsubstituted C₂-C₃₀ alkenyl, substituted or unsubstituted C₆-C₅₀ aryl, substituted or unsubstituted C₃-C₅₀ cycloalkyl, substituted or unsubstituted C₂-C₅₀ heterocycloalkyl, substituted or unsubstituted C₂-C₅₀ heteroaryl, substituted or unsubstituted cyclic groups in which a C₃-C₃₀ aliphatic ring and a C₅-C₃₀ aromatic ring are fused together, substituted or unsubstituted C₁-C₃₀ alkoxy, substituted or unsubstituted C₆-C₃₀ aryloxy, substituted or unsubstituted C₁-C₃₀ alkylthioxy, substituted or unsubstituted C₅-C₃₀ arylthioxy, substituted or unsubstituted amine, substituted or unsubstituted silyl, substituted or unsubstituted germanium, nitro, cyano and halogen;
R₁₁ to R₁₇ are optionally linked to the rings A₁ to A₃ to further form an alicyclic or aromatic monocyclic or polycyclic ring;
R₁₂ and R₁₃, R₁₄ and R₁₅, and R₁₆ and R₁₇ are optionally linked to each other to further form an alicyclic or aromatic monocyclic or polycyclic ring; and
the term 'substituted' in the 'substituted or unsubstituted' in [Formula 2] means being substituted with one or more substituents selected from the group consisting of deuterium, C₁-C₂₄ alkyl, C₁-C₂₄ haloalkyl, C₂-C₂₄ alkenyl, C₂-C₂₄ alkynyl, C₃-C₃₀ cycloalkyl, C₁-C₂₄ heteroalkyl, C₆-C₃₀ aryl, C₇-C₃₀ arylalkyl, C₇-C₃₀ alkylaryl, C₂-C₃₀ heteroaryl, C₂-C₃₀ heteroarylalkyl, cyclic groups in which a C₃-C₂₄ aliphatic ring and a C₅-C₂₄ aromatic ring are fused together, C₁-C₂₄ alkoxy, C₁-C₃₀ amine, C₁-C₃₀ silyl, C₁-C₃₀ germanium, C₆-C₂₄ aryloxy, C₃-C₂₄ arylthionyl, cyano, halogen, hydroxyl and nitro, and when there are two or more substituents, they are the same as or different from each other, and one or more hydrogen atoms in each of the substituents are optionally substituted with deuterium atoms.

15. The organic light emitting device according to claim 9, wherein the organic light emitting device is used in a display or lighting system selected from flat panel displays, flexible displays, monochromatic flat panel lighting systems, white flat panel lighting systems, flexible monochromatic lighting systems, flexible white lighting systems, displays for automotive applications, displays for virtual reality, and displays for augmented reality.

## Patentansprüche

1. Eine organische Verbindung, dargestellt durch die folgende [Formel 1]: 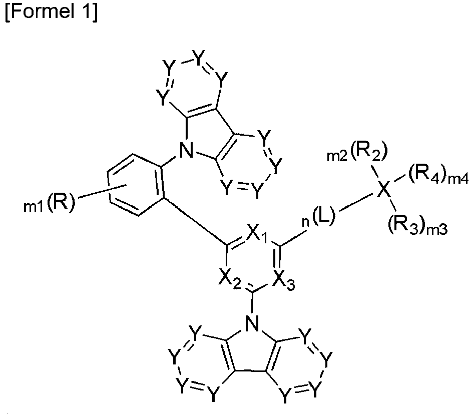 wobei, in [Formel 1],
X Si oder Ge ist;
X₁ bis X₃ gleich oder voneinander verschieden sind und jeweils unabhängig voneinander N oder CR₁ sind, und mindestens eine der Gruppen X₁ bis X₃ N ist;
die Gruppen Y gleich oder voneinander verschieden sind und jeweils unabhängig voneinander N oder CR₅ sind;
R₂ bis R₄ gleich oder voneinander verschieden sind und jeweils unabhängig voneinander ausgewählt sind aus substituiertem oder unsubstituiertem C₁-C₃₀-Alkyl, substituiertem oder unsubstituiertem C₂-C₃₀-Alkinyl, substituiertem oder unsubstituiertem C₂-C₃₀-Alkenyl, substituiertem oder unsubstituiertem C₆-C₅₀-Aryl, substituiertem oder unsubstituiertem C₃-C₅₀-Cycloalkyl, substituiertem oder unsubstituiertem C₂-C₅₀-Heterocycloalkyl, substituiertem oder unsubstituiertem C₂-C₅₀-Heteroaryl und substituierten oder unsubstituierten cyclischen Gruppen, in denen ein C₃-C₃₀-aliphatischer Ring und ein C₅-C₃₀-aromatischer Ring miteinander kondensiert sind;
R, R₁ und R₅ gleich oder voneinander verschieden sind und jeweils unabhängig voneinander ausgewählt sind aus Wasserstoff, Deuterium, substituiertem oder unsubstituiertem C1-C30-Alkyl, substituiertem oder unsubstituiertem C2-C30-Alkinyl, substituiertem oder unsubstituiertem C2-C30-Alkenyl, substituiertem oder unsubstituiertem C6-C50-Aryl, substituiertem oder unsubstituiertem C3-C50-Cycloalkyl, substituiertem oder unsubstituiertem C2-C50-Heterocycloalkyl, substituiertem oder unsubstituiertem C2-C50-Heteroaryl, substituierten oder unsubstituierten cyclischen Gruppen, in denen ein C3-C30-aliphatischer Ring und ein C5-C30-aromatischer Ring miteinander kondensiert sind, substituiertem oder unsubstituiertem C1-C30-Alkoxy, substituiertem oder unsubstituiertem C6-C30-Aryloxy, substituiertem oder unsubstituiertem C1-C30-Alkylthioxy, substituiertem oder unsubstituiertem C5-C30-Arylthioxy, substituiertem oder unsubstituiertem Amin, substituiertem oder unsubstituiertem Silyl, substituiertem oder unsubstituiertem Germanium, Nitro, Cyano und Halogen;
die Gruppen L gleich oder voneinander verschieden sind und jeweils unabhängig voneinander eine Einfachbindung sind oder eine beliebige Gruppe ausgewählt aus substituiertem oder unsubstituiertem C6-C30-Arylen, substituiertem oder unsubstituiertem C2-C30-Heteroarylen und substituierten oder unsubstituierten zweiwertigen cyclischen Gruppen, in denen ein C3-C24-aliphatischer Ring und ein C5-C24-aromatischer Ring miteinander kondensiert sind;
n eine ganze Zahl von 1 bis 3 ist, und wenn n eine ganze Zahl von 2 oder größer ist, sind die Gruppen L gleich oder voneinander verschieden;
m1 eine ganze Zahl von 4 ist, und die Gruppen R gleich oder voneinander verschieden sind;
m2 bis m4 gleich oder voneinander verschieden sind und jeweils unabhängig voneinander eine ganze Zahl von 1 bis 3 sind, und wenn m2 bis m4 jeweils eine ganze Zahl von 2 oder größer sind, sind R2 bis R4 gleich oder voneinander verschieden;
die Vielzahl benachbarter R- und R5-Gruppen optional miteinander verbunden sind, um einen alicyclischen oder aromatischen monocyclischen oder polycyclischen Ring zu bilden; und
der Begriff "substituiert" in "substituiert oder unsubstituiert" in [Formel 1] bedeutet substituiert zu sein mit einem, zwei oder mehreren Substituenten, die ausgewählt sind aus der Gruppe bestehend aus Deuterium, C₁-C₂₄-Alkyl, C₁-C₂₄-Halogenalkyl, C₂-C₂₄-Alkenyl, C₂-C₂₄-Alkinyl, C₃-C₃₀-Cycloalkyl, C₁-C₂₄-Heteroalkyl, C₆-C₃₀-Aryl, C₇-C₃₀-Arylalkyl, C₇-C₃₀-Alkylaryl, C₂-C₃₀-Heteroaryl, C₂-C₃₀-Heteroarylalkyl, cyclischen Gruppen, in denen ein C₃-C₂₄-aliphatischer Ring und ein C₃-C₂₄-aromatischer Ring miteinander kondensiert sind, C₁-C₂₄-Alkoxy, C₁-C₃₀-Amin, C₁-C₃₀-Silyl, C₁-C₃₀-Germanium, C₆-C₂₄-Aryloxy, C₆-C₂₄-Arylthionyl, Cyano, Halogen, Hydroxyl und Nitro, oder substituiert zu sein mit einem Substituenten, in dem zwei oder mehr der oben genannten Substituenten miteinander verbunden sind, und Wasserstoffatome in den Substituenten optional mit einem oder mehreren Deuteriumatomen ersetzt sind, und zwei oder mehr benachbarte Substituenten optional miteinander verbunden sind, um einen alicyclischen oder aromatischen monocyclischen oder polycyclischen Ring zu bilden.

2. Die organische Verbindung gemäß Anspruch 1, wobei R₂ bis R₄ gleich oder voneinander verschieden sind und jeweils unabhängig voneinander ausgewählt sind aus C₆-C₂₀-Aryl, das unsubstituiert oder mit Deuterium substituiert ist, C₅-C₂₀-Heteroaryl, das unsubstituiert oder mit Deuterium substituiert ist, und cyclischen Gruppen, die unsubstituiert oder mit Deuterium substituiert sind, in denen ein C₃-C₁₈-aliphatischer Ring und ein C₅-C₁₈-aromatischer Ring miteinander kondensiert sind.

3. Die organische Verbindung gemäß Anspruch 1, wobei alle X₁ bis X₃ jeweils N sind.

4. Die organische Verbindung gemäß Anspruch 1, wobei alle Ys jeweils CR₅ sind.

5. Die organische Verbindung gemäß Anspruch 4, wobei jedes R₅ Deuterium ist.

6. Die organische Verbindung gemäß Anspruch 1, wobei die Reste R gleich oder voneinander verschieden sind und jeweils unabhängig voneinander Wasserstoff oder Deuterium sind.

7. Die organische Verbindung gemäß Anspruch 1, wobei X Ge ist.

8. Die organische Verbindung gemäß Anspruch 1, wobei n die ganze Zahl 1 ist und L C₆-C₂₀-Arylen ist, das unsubstituiert oder mit Deuterium substituiert ist.

9. Die organische Verbindung gemäß Anspruch 1, wobei [Formel 1] eine beliebige Verbindung ausgewählt aus Verbindungen ist, die durch die folgenden Formeln dargestellt werden:

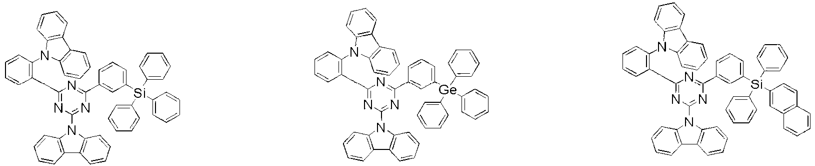

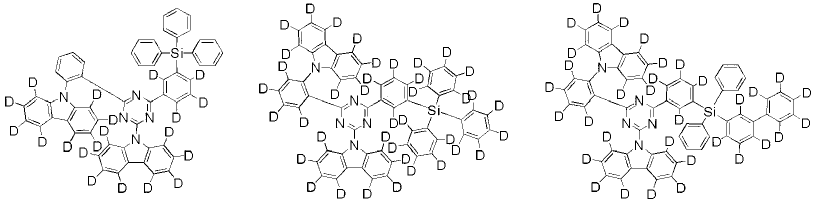

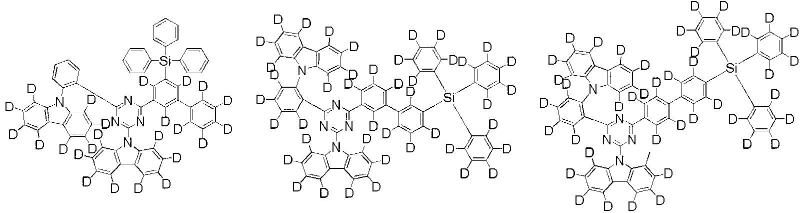

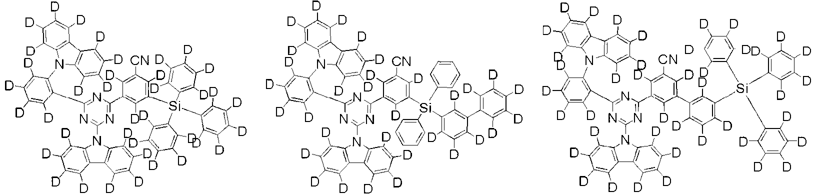

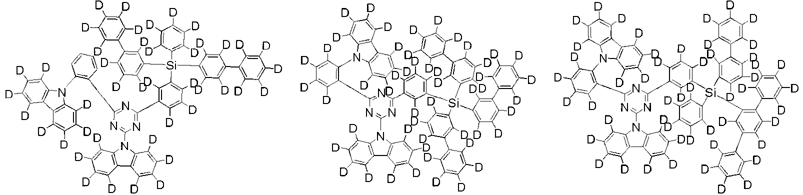

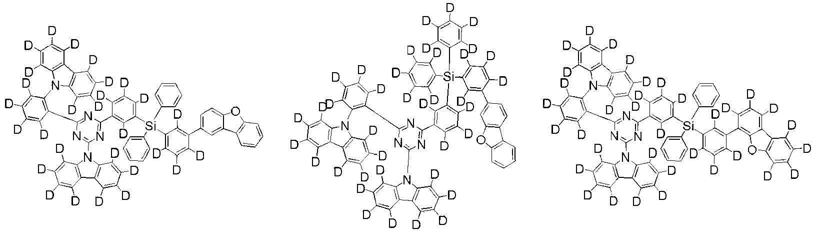

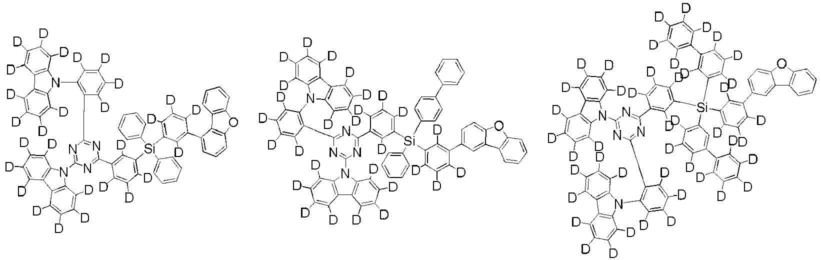

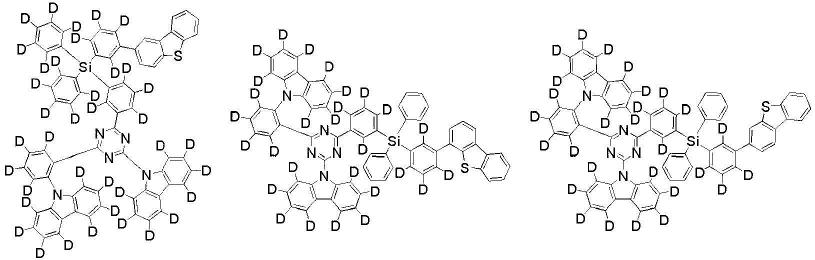

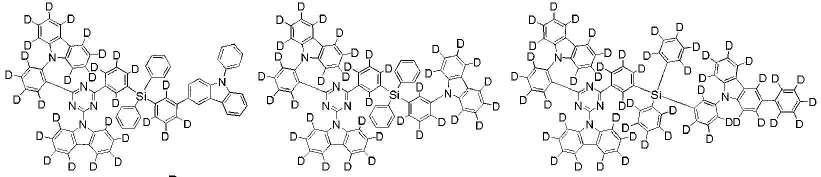

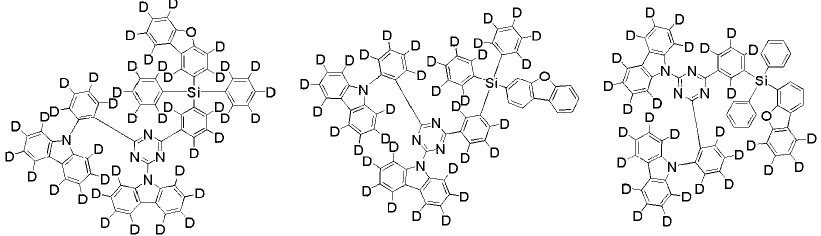

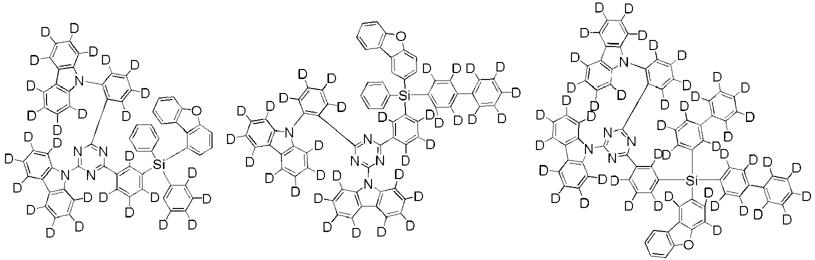

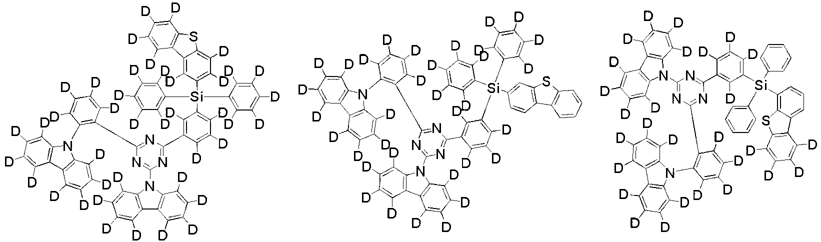

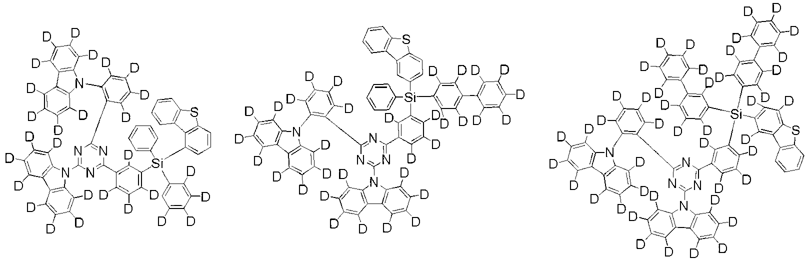

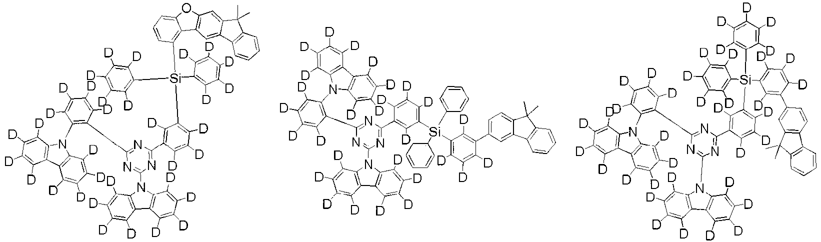

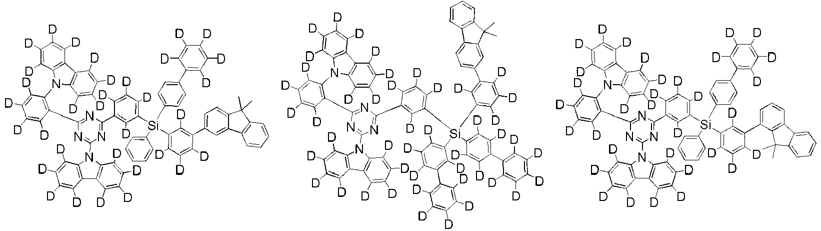

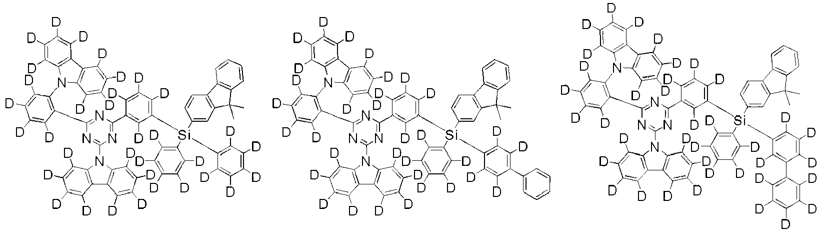

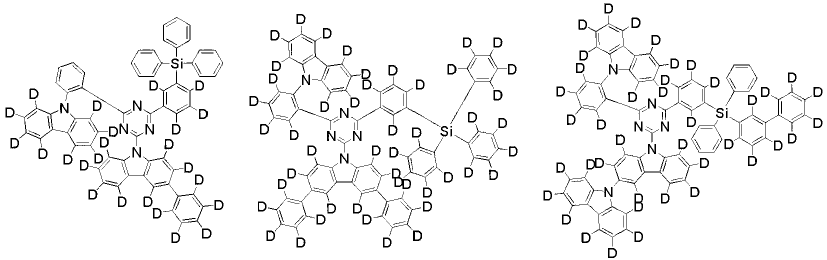

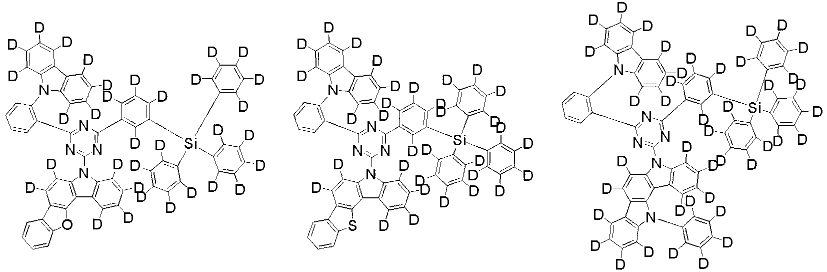

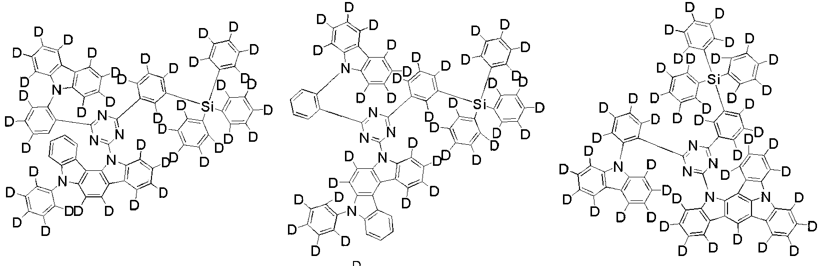

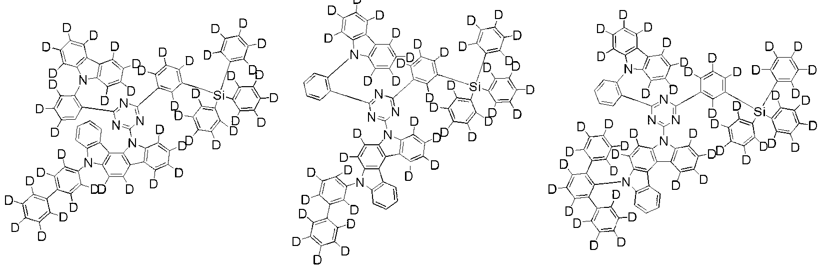

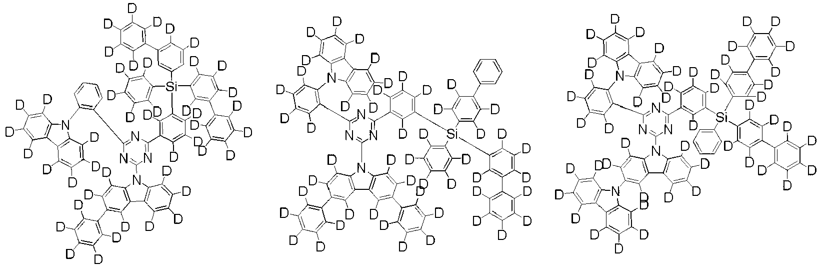

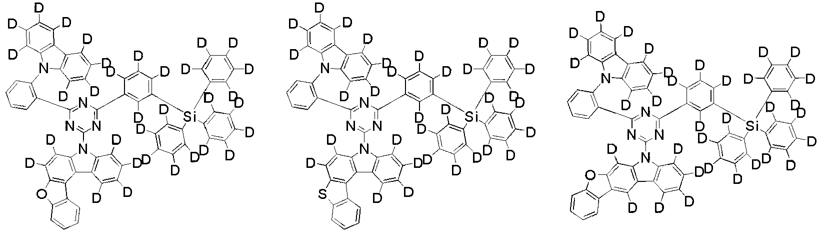

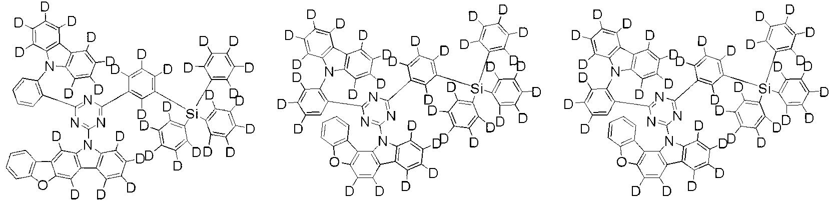

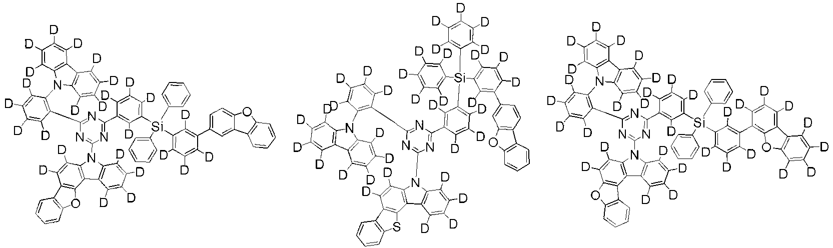

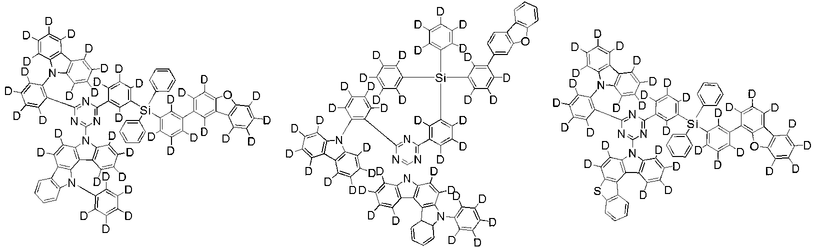

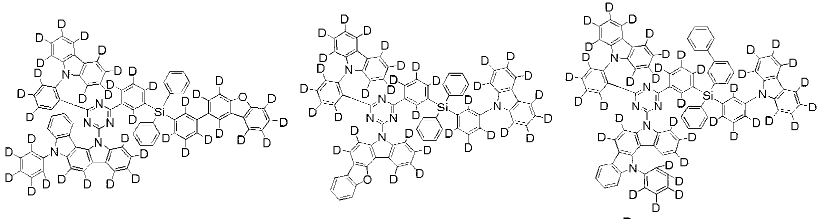

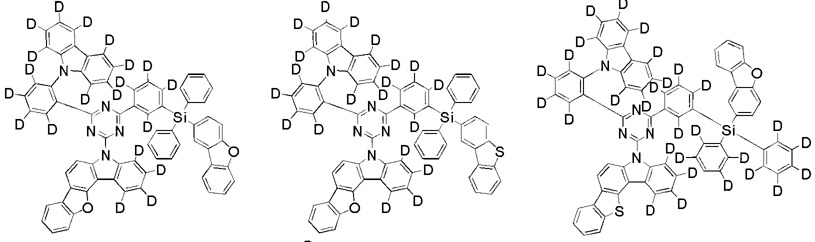

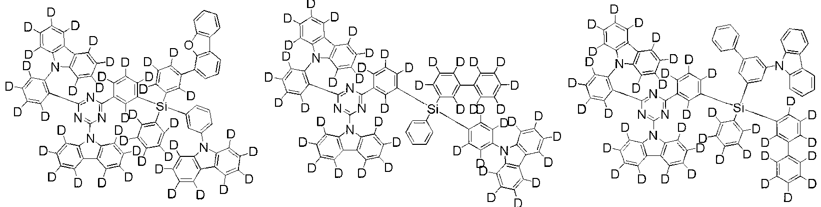

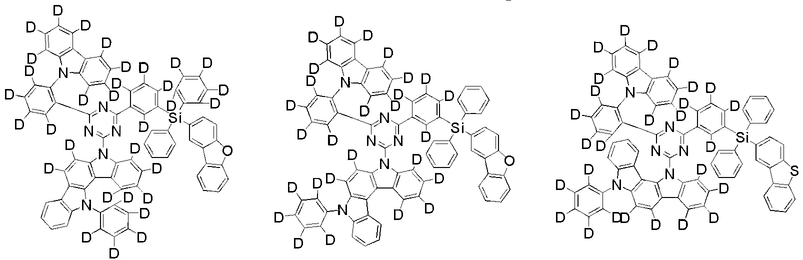

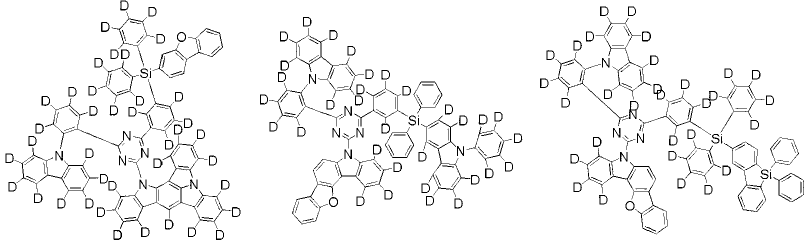

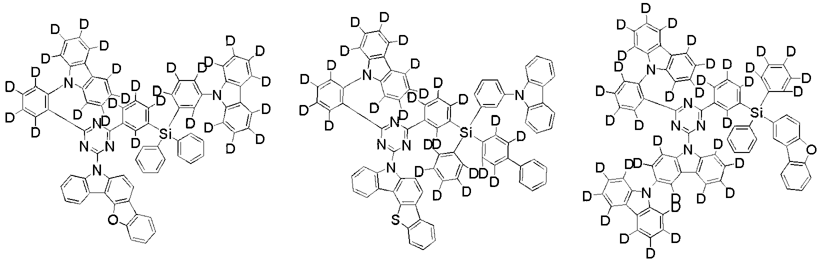

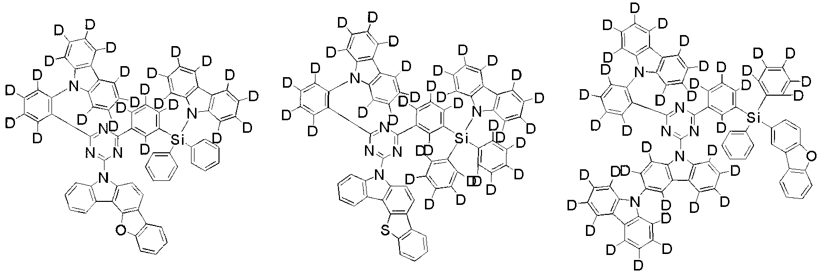

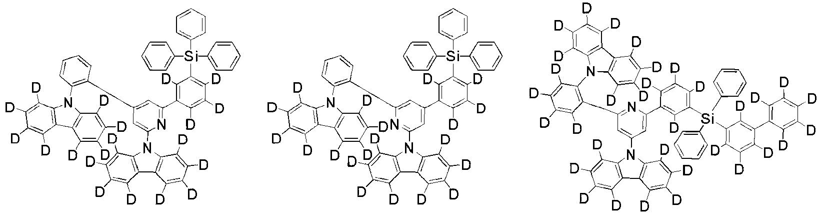

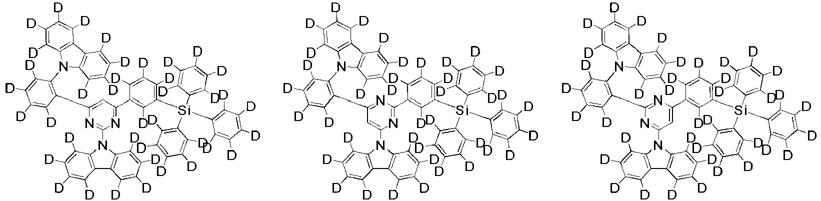

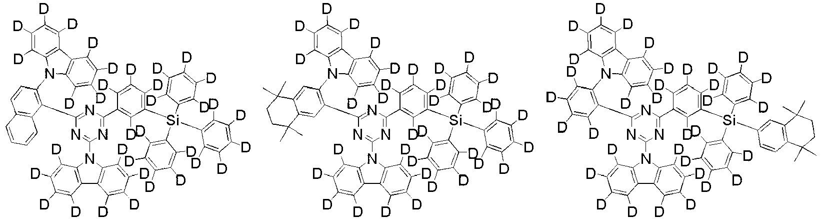

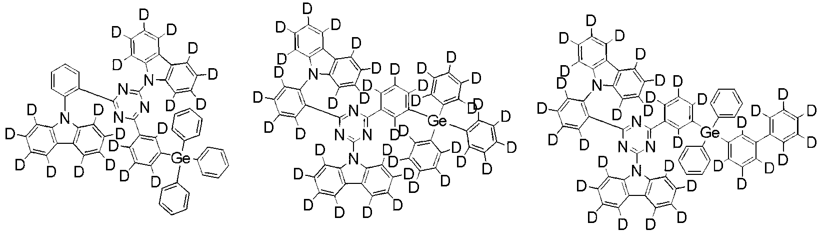

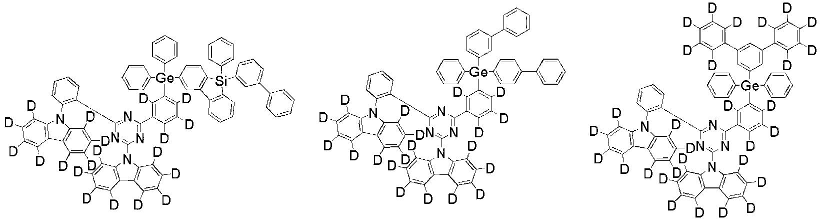

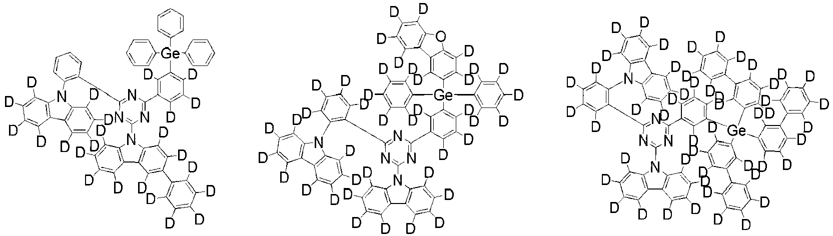

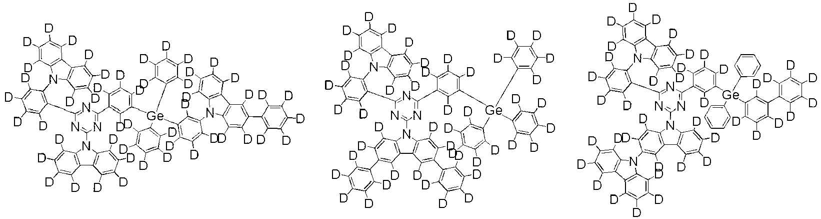

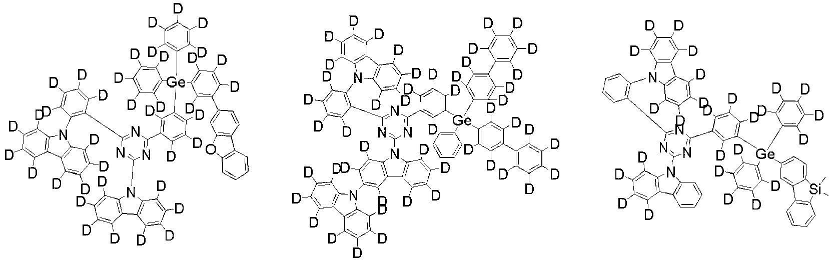

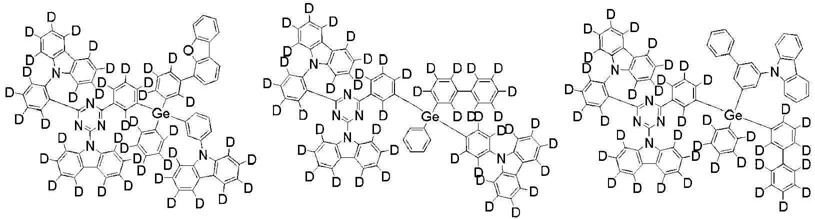

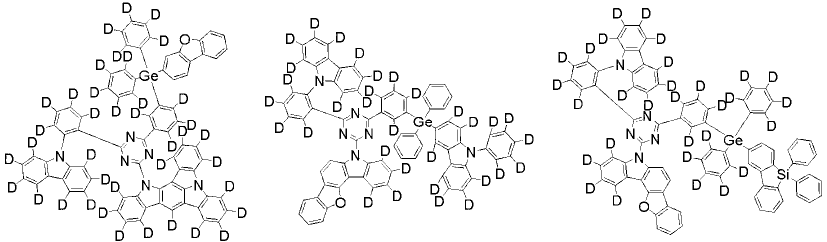

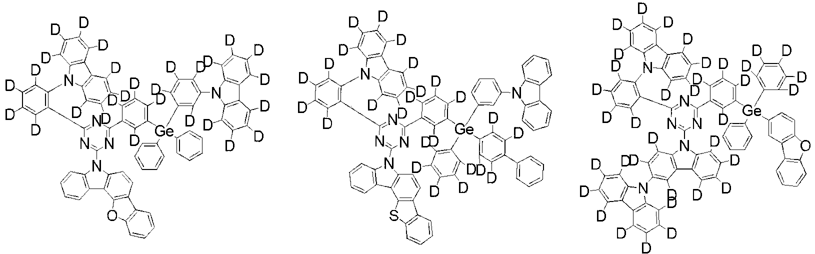

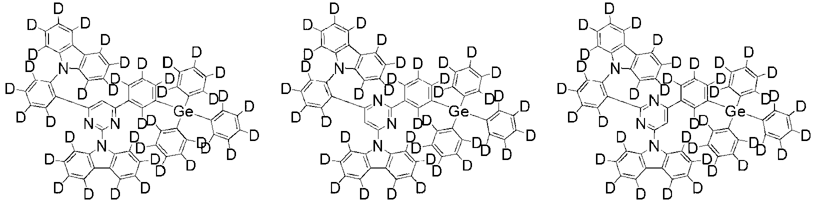

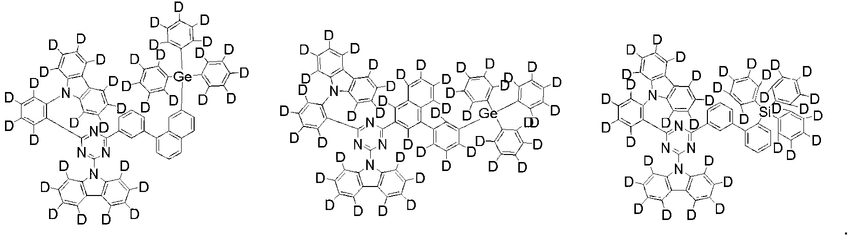

10. Eine organische lichtemittierende Vorrichtung, umfassend:
eine erste Elektrode;
eine zweite Elektrode, die der ersten Elektrode gegenüberliegt; und
eine organische Schicht, die zwischen der ersten Elektrode und der zweiten Elektrode angeordnet ist,
wobei die organische Schicht eine lichtemittierende Schicht
mit einem Wirtsmaterial und einem Dotierungsmittel umfasst; und **dadurch gekennzeichnet, dass**
das Wirtsmaterial mindestens einen Typ der organischen Verbindung umfasst, die durch [Formel 1] gemäß Anspruch 1 dargestellt ist.

11. Die organische lichtemittierende Vorrichtung gemäß Anspruch 10, wobei eine oder mehrere Typen anderer Verbindungen zusätzlich zu dem einen Typ der organischen Verbindung, dargestellt durch [Formel 1], gemischt oder gestapelt sind und als Wirtsmaterial dienen.

12. Die organische lichtemittierende Vorrichtung gemäß Anspruch 10, wobei die durch [Formel 1] dargestellte organische Verbindung, die als Wirtsmaterial verwendet wird, als blaues phosphoreszierendes Wirtsmaterial verwendet wird.

13. Die organische lichtemittierende Vorrichtung gemäß Anspruch 10, wobei das Dotierungsmittel mindestens eine metallorganische Verbindung enthält.

14. Die organische lichtemittierende Vorrichtung gemäß Anspruch 13, wobei eine polyzyklische Ringverbindung, dargestellt durch die folgende [Formel 2], gemischt oder gestapelt und zusätzlich zu der metallorganischen Verbindung zur Anwendung kommt: 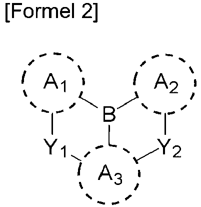 wobei in [Formel 2],
Y₁ und Y₂ gleich oder voneinander verschieden sind und jeweils unabhängig voneinander ausgewählt sind aus O, S, NR₁₁, CR₁₂R₁₃, SiR₁₄R₁₅ und GeR₁₆R₁₇;
A₁ bis A₃ gleich oder voneinander verschieden sind und jeweils unabhängig voneinander ausgewählt sind aus substituierten oder unsubstituierten aromatischen C₆-C₃₀-Kohlenwasserstoffringen, substituierten oder unsubstituierten aliphatischen C₃-C₃₀-Kohlenwasserstoffringen, substituierten oder unsubstituierten aromatischen C₂-C₃₀- Heterozyklen, substituierten oder unsubstituierten aliphatischen C₂-C₃₀-Heterozyklen und substituierten oder unsubstituierten cyclischen Gruppen, in denen ein aliphatischer C₃-C₂₄-Ring und ein aromatischer C₅-C₂₄-Ring miteinander kondensiert sind;
R₁₁ bis R₁₇ gleich oder voneinander verschieden sind und jeweils unabhängig voneinander ausgewählt sind aus Wasserstoff, Deuterium, substituiertem oder unsubstituiertem C₁-C₃₀-Alkyl, substituiertem oder unsubstituiertem C₂-C₃₀-Alkinyl, substituiertem oder unsubstituiertem C₂-C₃₀-Alkenyl, substituiertem oder unsubstituiertem C₆-C₅₀-Aryl, substituiertem oder unsubstituiertem C₃-C₅₀-Cycloalkyl, substituiertem oder unsubstituiertem C₂-C₅₀-Heterocycloalkyl, substituiertem oder unsubstituiertem C₂-C₅₀-Heteroaryl, substituierten oder unsubstituierten cyclischen Gruppen, in denen ein aliphatischer C₃-C₃₀-Ring und ein aromatischer C₅-C₃₀-Ring miteinander kondensiert sind, substituiertem oder unsubstituiertem C₁-C₃₀-Alkoxy, substituiertem oder unsubstituiertem C₆-C₃₀-Aryloxy, substituiertem oder unsubstituiertem C₁-C₃₀-Alkylthioxy, substituiertem oder unsubstituiertem C₅-C₃₀-Arylthioxy, substituiertem oder unsubstituiertem Amin, substituiertem oder unsubstituiertem Silyl, substituiertem oder unsubstituiertem Germanium, Nitro, Cyano und Halogen;
R₁₁ bis R₁₇ optional mit den Ringen A₁ bis A₃ verbunden sind, um einen alicyclischen oder aromatischen monocyclischen oder polycyclischen Ring zu bilden;
R₁₂ und R₁₃, R₁₄ und R₁₅ sowie R₁₆ und R₁₇ optional miteinander verbunden sind, um einen alicyclischen oder aromatischen monocyclischen oder polycyclischen Ring zu bilden; und
der Begriff "substituiert" in "substituiert oder unsubstituiert" in [Formel 2] bedeutet substituiert zu sein mit einem oder mehreren Substituenten, die ausgewählt sind aus der Gruppe bestehend aus Deuterium, C1-C24-Alkyl, C1-C24-Halogenalkyl, C2-C24-Alkenyl, C2-C24-Alkinyl, C3-C30-Cycloalkyl, C1-C24-Heteroalkyl, C6-C30-Aryl, C7-C30-Arylalkyl, C7-C30-Alkylaryl, C2-C30-Heteroaryl, C2-C30-Heteroarylalkyl, cyclischen Gruppen, in denen ein aliphatischer C3-C24-Ring und ein aromatischer C5-C24-Ring miteinander kondensiert sind, C1-C24-Alkoxy, C1-C30-Amin, C1-C30-Silyl, C1-C30-Germanium, C6-C24-Aryloxy, C6-C24-Arylthionyl, Cyano, Halogen, Hydroxyl und Nitro, und bei zwei oder mehr Substituenten sind diese gleich oder voneinander verschieden, und ein oder mehrere Wasserstoffatome in jedem der Substituenten sind optional durch Deuteriumatome ersetzt.

15. Die organische lichtemittierende Vorrichtung gemäß Anspruch 9, wobei die organische lichtemittierende Vorrichtung in einem Anzeigegerät oder Beleuchtungssystem zum Einsatz kommt, ausgewählt aus Flachbildschirmen, flexiblen Anzeigegeräten, monochromatischen Flachbildschirm-Beleuchtungssystemen, weißen Flachbildschirm-Beleuchtungssystemen, flexiblen monochromatischen Beleuchtungssystemen, flexiblen weißen Beleuchtungssystemen, Anzeigegeräten für Automobilanwendungen, Anzeigegeräten für virtuelle Realität und Anzeigegeräten für erweiterte Realität.

## Revendications

1. Composé organique représenté par la [formule 1] suivante : 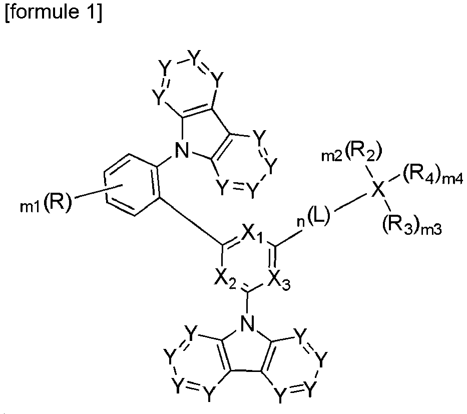 dans la [formule 1],
X étant Si ou Ge ;
X₁ à X₃ étant identiques ou différents les uns des autres et étant chacun indépendamment N ou CR₁, et au moins un des X₁ à X₃ étant N ;
les Ys étant identiques ou différents les uns des autres, et étant chacun indépendamment N ou CR₅ ;
R₂ à R₄ étant identiques ou différents les uns des autres, et étant chacun indépendamment un quelconque choisi parmi alkyle en C₁-C₃₀ substitué ou non substitué, alcynyle en C₂-C₃₀ substitué ou non substitué, alcényle en C₂-C₃₀ substitué ou non substitué, aryle en C₆-C₅₀ substitué ou non substitué, cycloalkyle en C₃-C₅₀ substitué ou non substitué, hétérocycloalkyle en C₂-C₅₀ substitué ou non substitué, hétéroaryle en C₂-C₅₀ substitué ou non substitué, et des groupes cycliques substitués ou non substitués dans lesquels un cycle aliphatique en C₃-C₃₀ et un cycle aromatique en C₅-C₃₀ sont fusionnés ;
R, R₁ et R₅ étant identiques ou différents les uns des autres, et étant chacun indépendamment un quelconque choisi parmi hydrogène, deutérium, alkyle en C₁-C₃₀ substitué ou non substitué, alcynyle en C₂-C₃₀ substitué ou non substitué, alcényle en C₂-C₃₀ substitué ou non substitué, aryle en C₆-C₅₀ substitué ou non substitué, cycloalkyle en C₃-C₅₀ substitué ou non substitué, hétérocycloalkyle en C₂-C₅₀ substitué ou non substitué, hétéroaryle en C₂-C₅₀ substitué ou non substitué, des groupes cycliques substitués ou non substitués dans lesquels un cycle aliphatique en C₃-C₃₀ et un cycle aromatique en C₅-C₃₀ sont fusionnés, alkoxy en C₁-C₃₀ substitué ou non substitué, aryloxy en C₆-C₃₀ substitué ou non substitué, alkylthioxy en C₁-C₃₀ substitué ou non substitué, arylthioxy en C₅-C₃₀ substitué ou non substitué, amine substituée ou non substituée, silyle substitué ou non substitué, germanium substitué ou non substitué, nitro, cyano et halogène ;
les Ls étant identiques ou différents les uns des autres, et étant chacun indépendamment une liaison simple, ou un quelconque choisi parmi arylène en C₆-C₃₀ substitué ou non substitué, hétéroarylène en C₂-C₃₀ substitué ou non substitué, et des groupes cycliques divalents substitués ou non substitués dans lesquels un cycle aliphatique en C₃-C₂₄ et un cycle aromatique en C₅-C₂₄ sont fusionnés ;
n étant un entier de 1 à 3, et lorsque n est un entier égal ou supérieur à 2, les Ls étant identiques ou différents les uns des autres ;
m₁ étant un entier de 4, et les Rs étant identiques ou différents les uns des autres ;
m₂ à m₄ étant identiques ou différents les uns des autres, et étant chacun indépendamment un entier de 1 à 3, et lorsque m₂ à m₄ sont chacun un entier égal ou supérieur à 2, les R₂s à R₄s sont identiques ou différents les uns des autres ;
la pluralité de Rs et R₅s adjacents étant optionnellement liés entre eux pour former en outre un monocycle ou polycycle alicyclique ou aromatique ; et
le terme 'substitué' dans 'substitué ou non substitué' dans la [formule 1] signifie étant substitué par un, ou deux ou plus substituants choisis dans le groupe constitué de deutérium, alkyle en C₁-C₂₄, haloalkyle en C₁-C₂₄, alcényle en C₂-C₂₄, alcynyl en C₂-C₂₄, cycloalkyle en C₃-C₃₀, hétéroalkyle en C₁-C₂₄, aryle en C₆-C₃₀, arylalkyle en C₇-C₃₀, alkylaryle en C₇-C₃₀, hétéroaryle en C₂-C₃₀, hétéroarylalkyle en C₂-C₃₀, des groupes cycliques dans lesquels un cycle aliphatique en C₃-C₂₄ et un cycle aromatique en C₅-C₂₄ sont fusionnés, alkoxy en C₁-C₂₄, amine en C₁-C₃₀, silyle en C₁-C₃₀, germanium en C₁-C₃₀, aryloxy en C₆-C₂₄, arylthionyle en C₆-C₂₄, cyano, halogène, hydroxyle et nitro, ou étant substitué par un substituant dans lequel deux ou plus des substituants mentionnés ci-dessus sont liés, et des atomes d'hydrogène dans les substituants étant optionnellement substitués par un ou plusieurs atomes de deutérium, et deux ou plus adjacents substituants des substituants étant optionnellement liés entre eux pour former en outre un monocycle ou polycycle alicyclique ou aromatique.

2. Composé organique selon la revendication 1, dans lequel R₂ à R₄ étant identiques ou différents les uns des autres, et étant chacun indépendamment un quelconque choisi parmi aryle en C₆-C₂₀ substitué ou non substitué par deutérium, hétéroaryle en C₅-C₂₀ substitué ou non substitué par deutérium, et des groupes cycliques substitués ou non substitués par deutérium dans lesquels un cycle aliphatique en C₃-C₁₈ et un cycle aromatique en C₅-C₁₈ sont fusionnés.

3. Composé organique selon la revendication 1, dans lequel tous les X₁ à X₃ sont chacun N.

4. Composé organique selon la revendication 1, dans lequel tous les Ys sont chacun CR_{5.}

5. Composé organique selon la revendication 4, dans lequel chacun des R₅s est deutérium.

6. Composé organique selon la revendication 1, dans lequel les Rs sont identiques ou différents les uns des autres, et sont chacun indépendamment hydrogène ou deutérium.

7. Composé organique selon la revendication 1, dans lequel X est Ge.

8. Composé organique selon la revendication 1, dans lequel n est un entier égal à 1, et L est arylène en C₆-C₂₀ substitué ou non substitué par deutérium

9. Composé organique selon la revendication 1, dans lequel la [formule 1] est une quelconque choisie parmi des composés représentés par les formules suivantes :

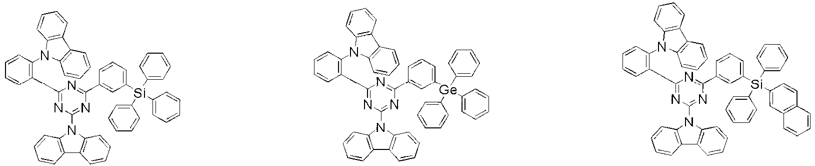

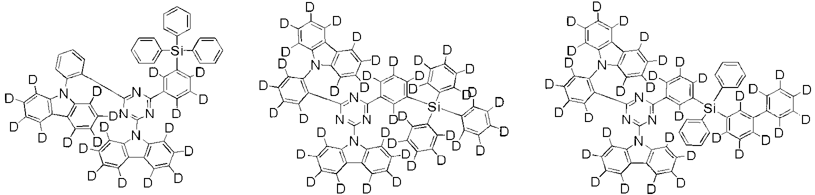

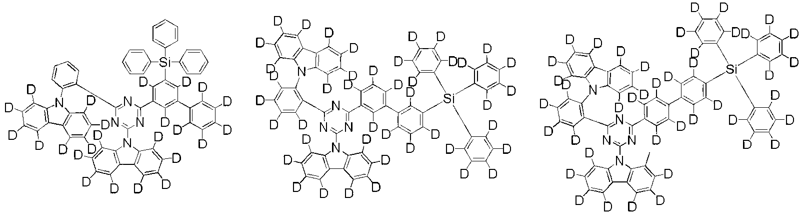

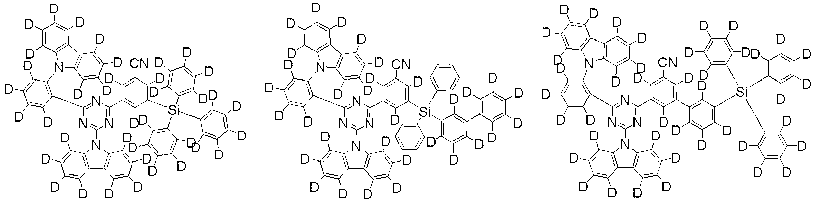

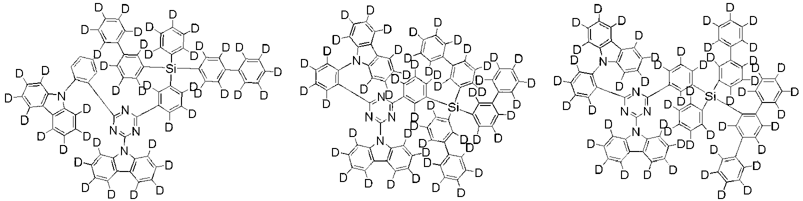

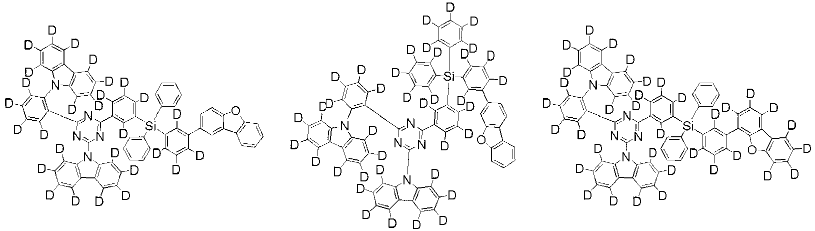

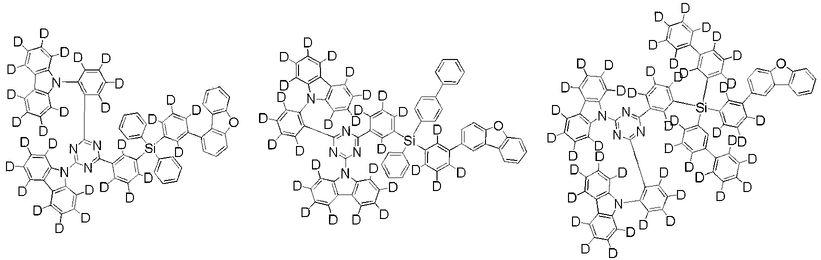

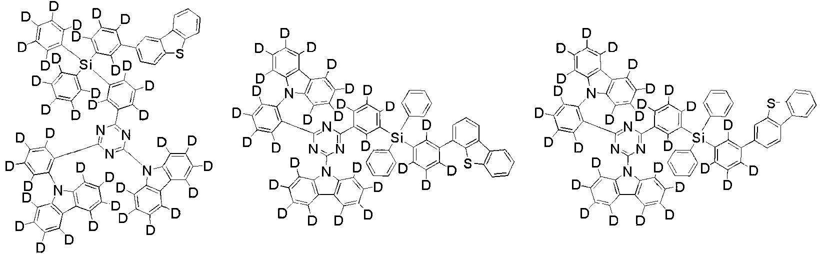

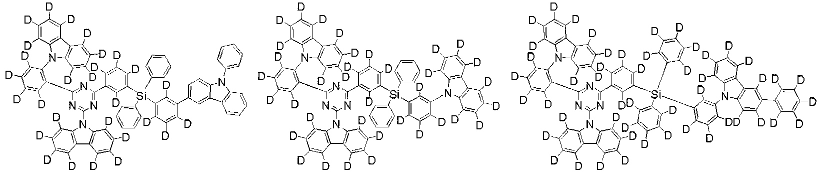

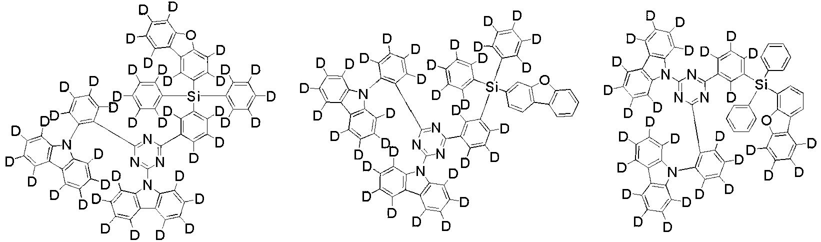

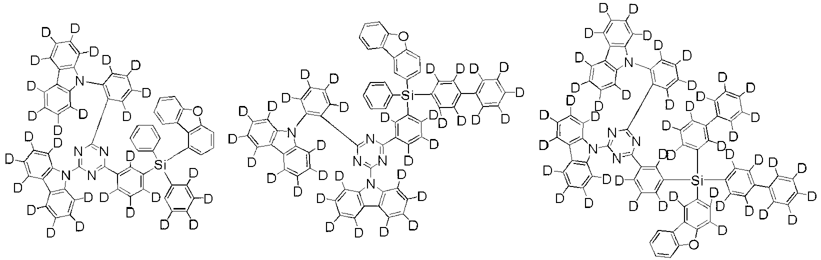

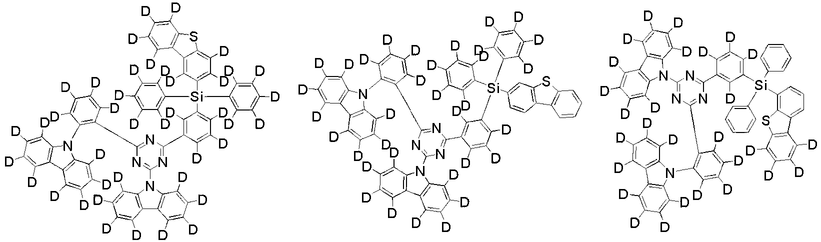

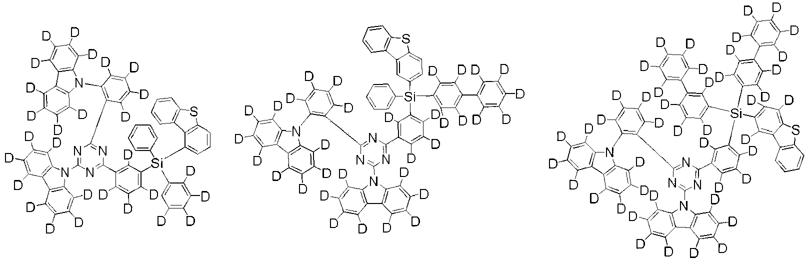

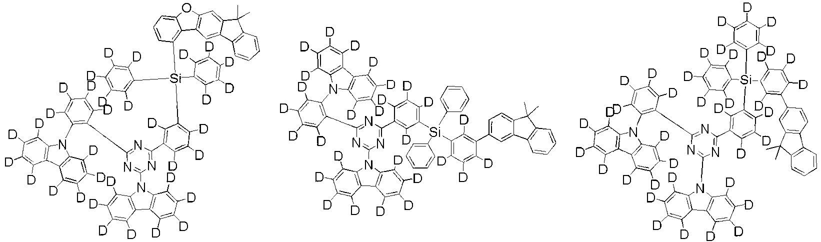

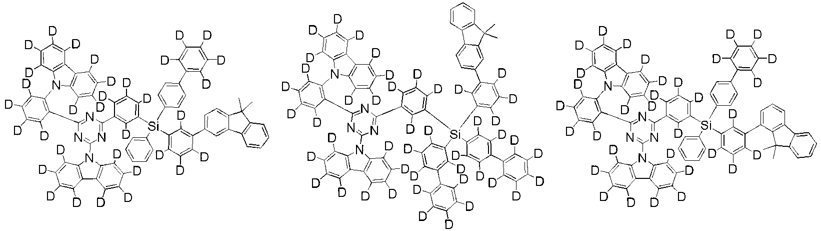

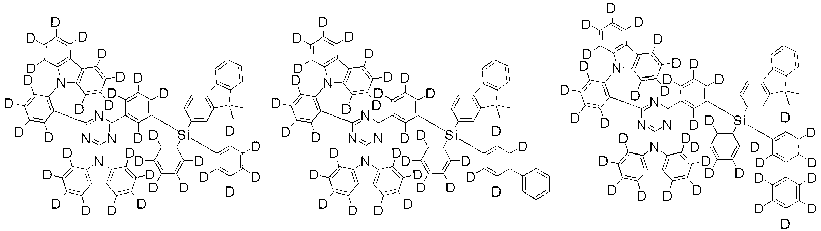

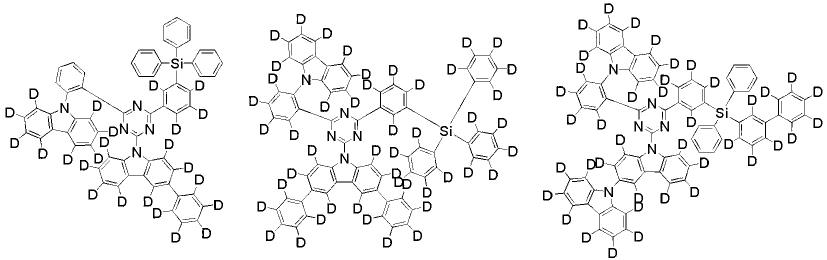

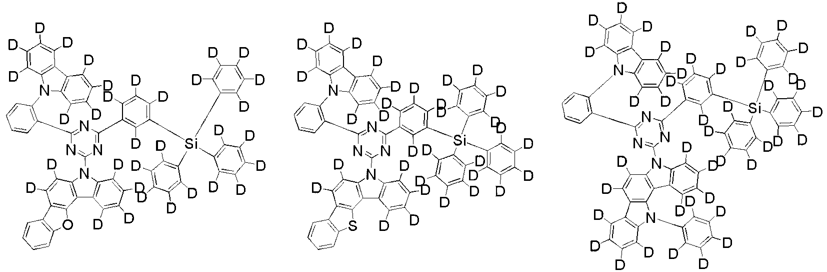

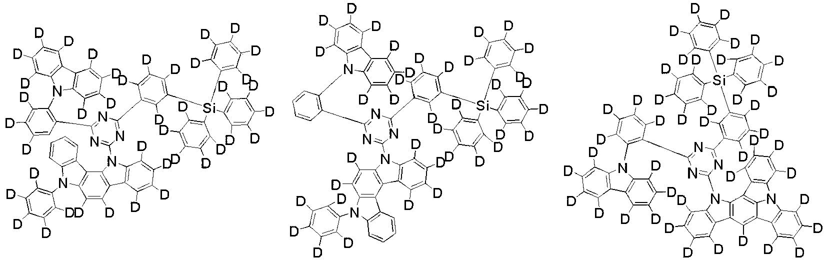

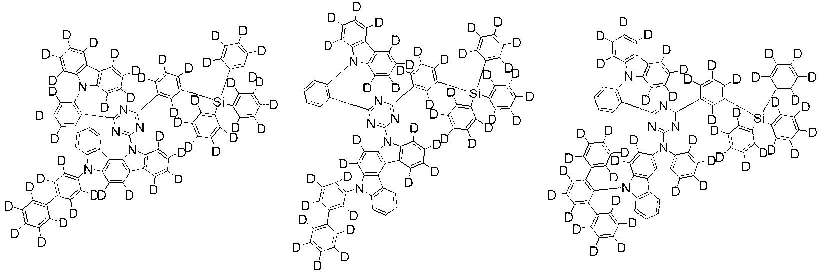

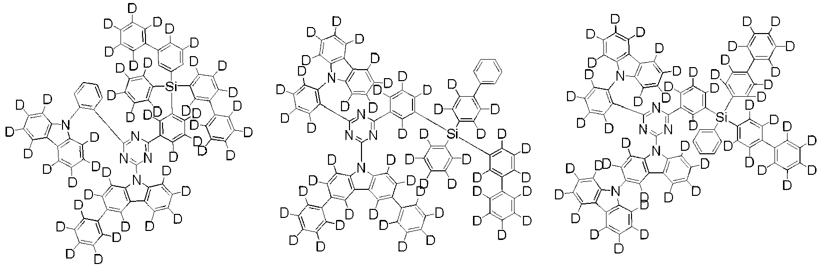

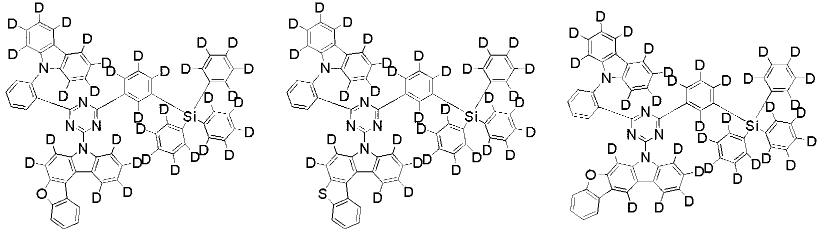

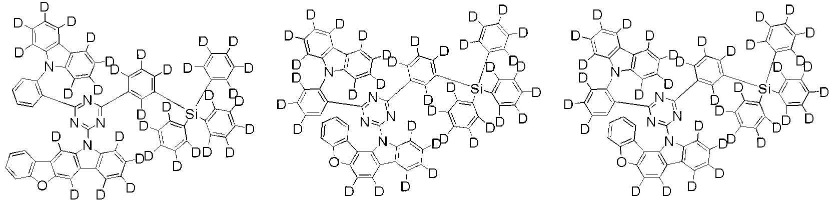

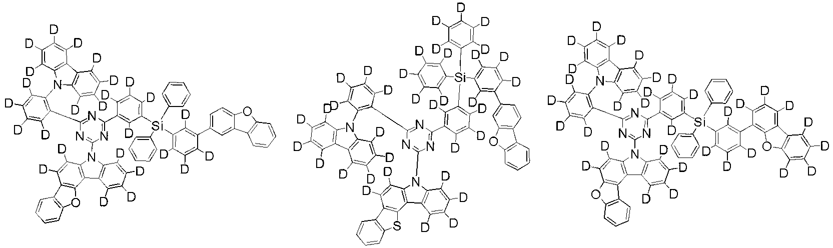

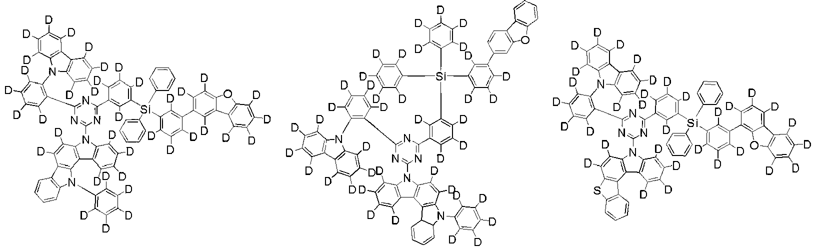

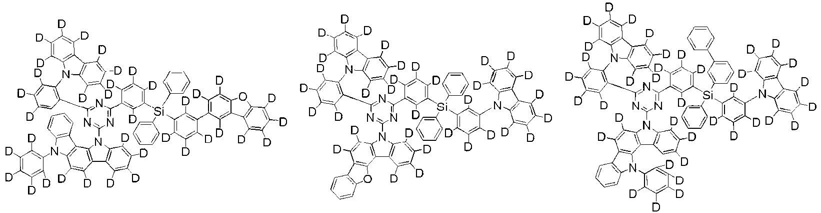

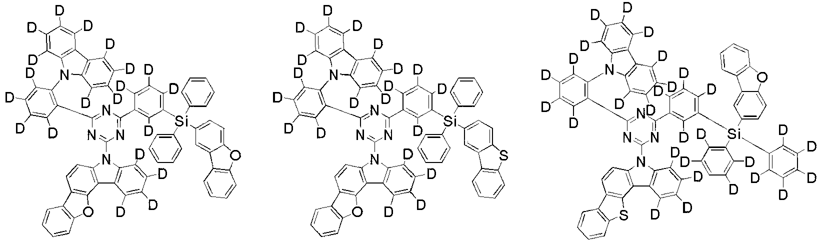

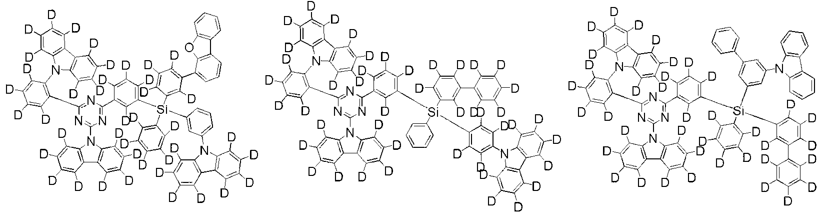

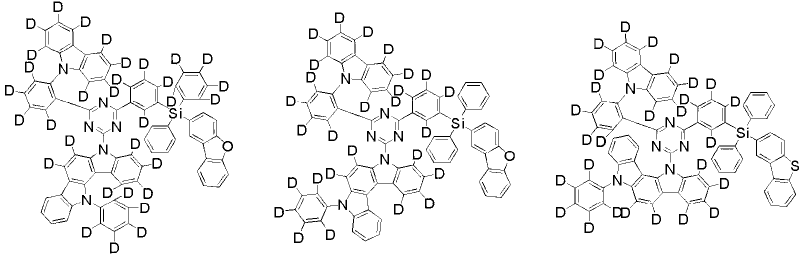

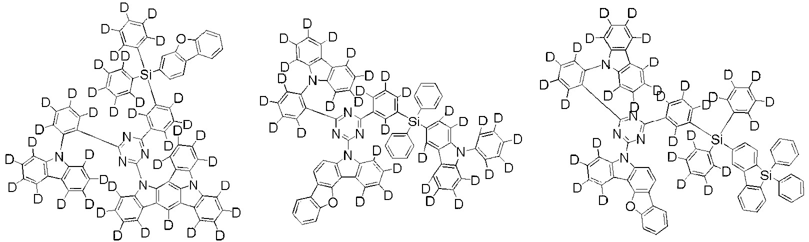

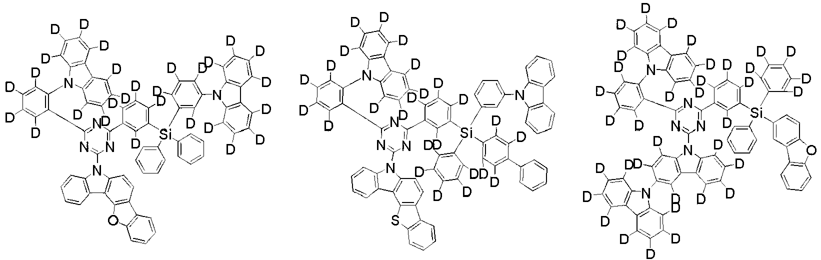

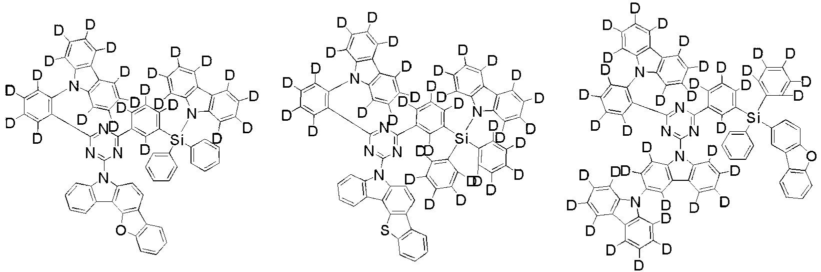

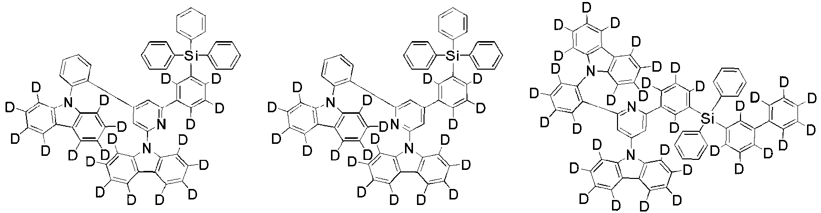

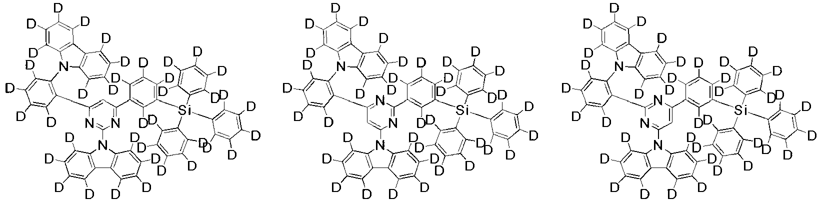

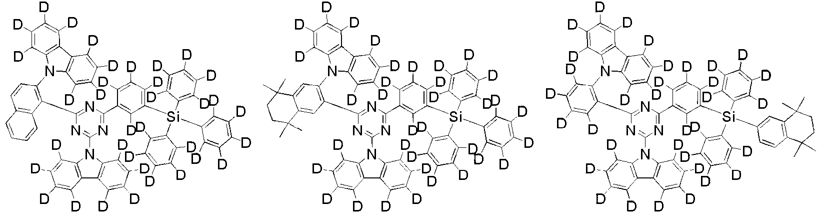

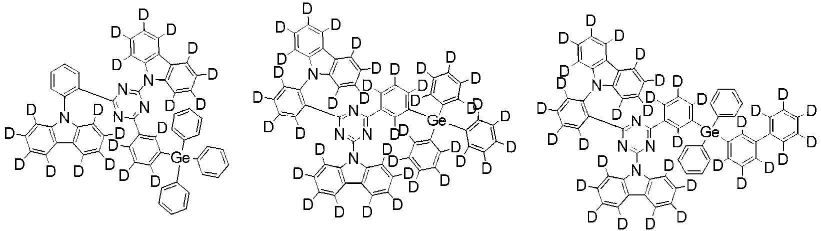

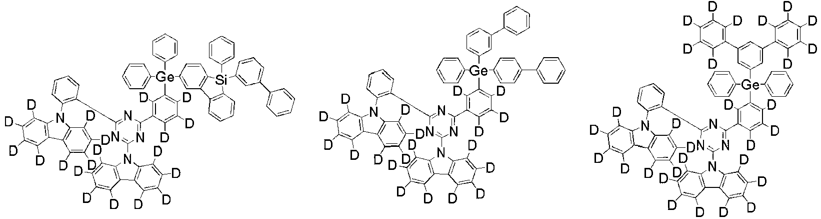

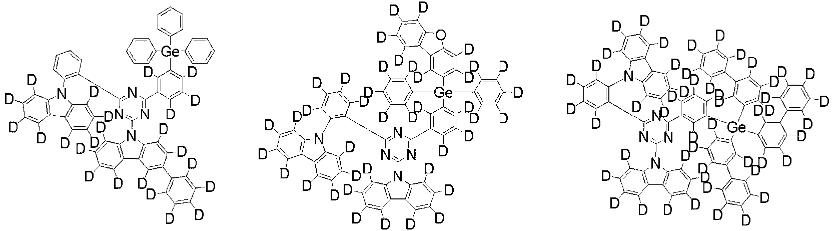

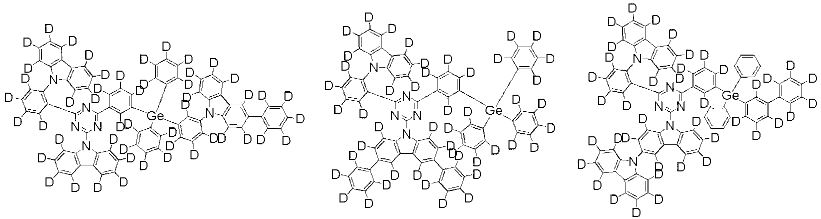

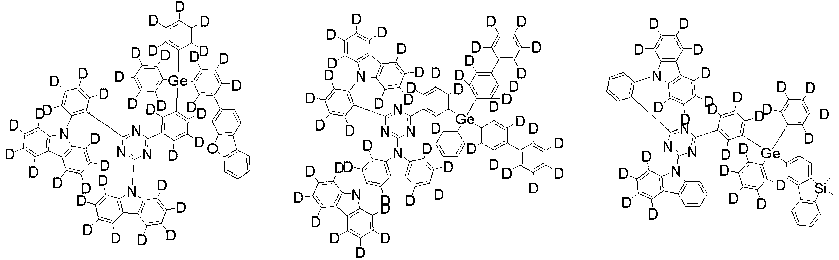

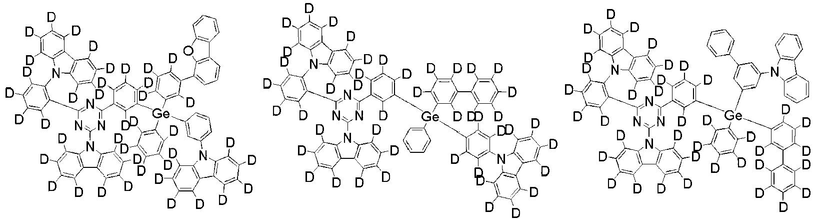

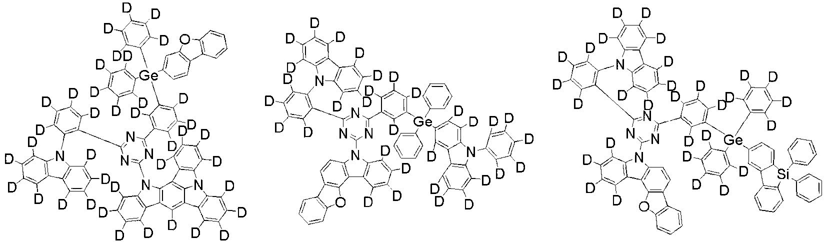

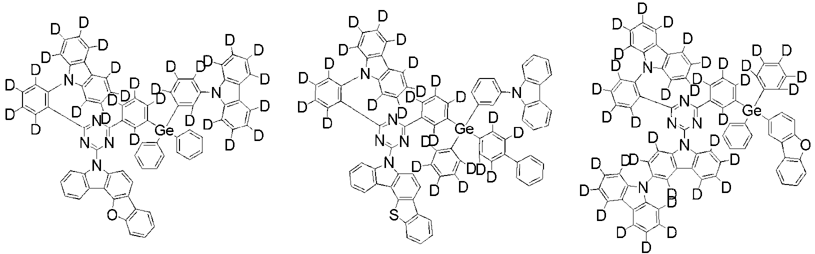

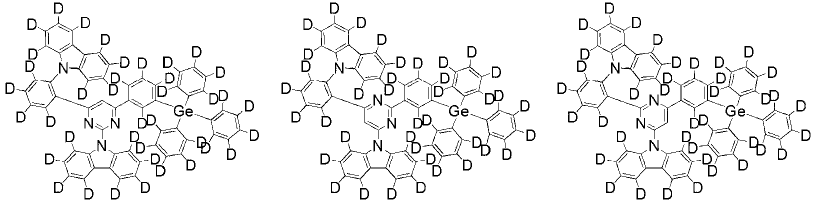

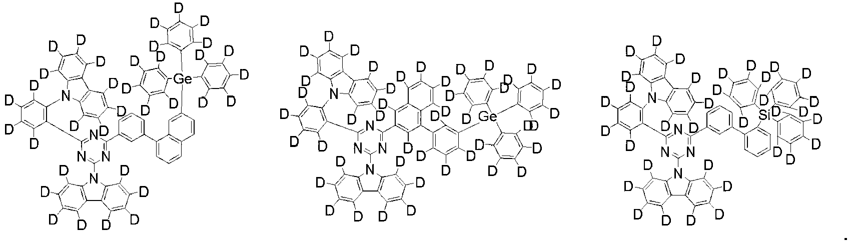

10. Dispositif électroluminescent organique comprenant :
une première électrode ;
une deuxième électrode opposée à la première électrode ; et
une couche organique interposée entre la première électrode et la deuxième électrode,
la couche organique comprenant une couche d'émission de lumière comprenant un hôte et un dopant ; et
**caractérisé en ce que**
l'hôte comprend au moins un type de composé organique représenté par la [formule 1] selon la revendication 1.

11. Dispositif électroluminescent organique selon la revendication 10, dans lequel un ou plusieurs types d'autres composés outre ledit un type de composé organique représenté par la [formule 1] est mélangé ou empilé et utilisé comme l'hôte.

12. Dispositif électroluminescent organique selon la revendication 10, dans lequel le composé organique représenté par la [formule 1] utilisé comme l'hôte est utilisé comme un hôte phosphorescent bleu.

13. Dispositif électroluminescent organique selon la revendication 10, dans lequel le dopant comprend au moins un composé organométallique.

14. Dispositif électroluminescent organique selon la revendication 13, dans lequel un composé à cycle polycyclique représenté par la [formule 2] suivante est mélangé ou empilé et utilisé outre le composé organométallique : 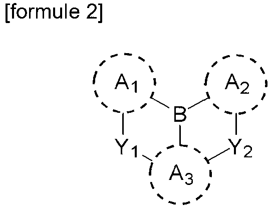 dans la [formule 2],
Y₁ et Y₂ étant identiques ou différents les uns des autres, et étant chacun indépendamment un quelconque choisi parmi O, S, NR₁₁, CR₁₂R₁₃, SiR₁₄R₁₅ et GeR₁₆R_{17 ;}
A₁ à A₃ étant identiques ou différents les uns des autres, et étant chacun indépendamment un quelconque choisi parmi des cycles d'hydrocarbures aromatiques en C₆-C₃₀ substitués ou non substitués, des cycles d'hydrocarbures aliphatiques en C₃-C₃₀ substitués ou non substitués, des hétérocycles aromatiques en C₂-C₃₀ substitués ou non substitués, des hétérocycles aliphatiques en C₂-C₃₀ substitués ou non substitués, et des groupes cycliques substitués ou non substitués dans lesquels un cycle aliphatique en C₃-C₂₄ et un cycle aromatique en C₅-C₂₄ sont fusionnés ;
R₁₁ to R₁₇ étant identiques ou différents les uns des autres, et étant chacun indépendamment un quelconque choisi parmi hydrogène, deutérium, alkyle en C₁-C₃₀ substitué ou non substitué, alcynyle en C₂-C₃₀ substitué ou non substitué, alcényle en C₂-C₃₀ substitué ou non substitué, aryle en C₆-C₅₀ substitué ou non substitué, cycloalkyle en C₃-C₅₀ substitué ou non substitué, hétérocycloalkyle en C₂-C₅₀ substitué ou non substitué, hétéroaryle en C₂-C₅₀ substitué ou non substitué, des groupes cycliques substitués ou non substitués dans lesquels un cycle aliphatique en C₃-C₃₀ et un cycle aromatique en C₅-C₃₀ sont fusionnés, alkoxy en C₁-C₃₀ substitué ou non substitué, aryloxy en C₅-C₃₀ substitué ou non substitué, alkylthioxy en C₁-C₃₀ substitué ou non substitué, arylthioxy en C₅-C₃₀ substitué ou non substitué, amine substituée ou non substituée, silyle substitué ou non substitué, germanium substitué ou non substitué, nitro, cyano et halogène;
R₁₁ à R₁₇ étant optionnellement liés aux cycles A₁ à A₃ pour former en outre un monocycle ou polycycle alicyclique ou aromatique ;
R₁₂ et R₁₃, R₁₄ et R₁₅, et R₁₆ et R₁₇ étant optionnellement liés entre eux pour former en outre un monocycle ou polycycle alicyclique ou aromatique ; et
le terme 'substitué' dans 'substitué ou non substitué' dans la [formule 2] signifie étant substitué par un ou plusieurs substituants choisis dans le groupe constitué de deutérium, alkyle en C₁-C₂₄, haloalkyle en C₁-C₂₄, alcényle en C₂-C₂₄, alcynyl en C₂-C₂₄, cycloalkyle en C₃-C₃₀, hétéroalkyle en C₁-C₂₄, aryle en C₆-C₃₀, arylalkyle en C₇-C₃₀, alkylaryle en C₇-C₃₀, hétéroaryle en C₂-C₃₀, hétéroarylalkyle en C₂-C₃₀, des groupes cycliques dans lesquels un cycle aliphatique en C₃-C₂₄ et un cycle aromatique en C₅-C₂₄ sont fusionnés, alkoxy en C₁-C₂₄, amine en C₁-C₃₀, silyle en C₁-C₃₀, germanium en C₁-C₃₀, aryloxy en C₆-C₂₄, arylthionyle en C₆-C₂₄, cyano, halogène, hydroxyle et nitro, et lorsqu'il y a deux ou plus de substituants, ceux-ci étant identiques ou différents les uns des autres, et un ou plusieurs des atomes d'hydrogène dans chacun des substituants étant optionnellement substitués par des atomes de deutérium.

15. Dispositif électroluminescent organique selon la revendication 9, ledit dispositif électroluminescent organique étant utilisé dans un système d'affichage ou d'éclairage choisi parmi des écrans plats, des écrans flexibles, des systèmes d'éclairage monochromatique à panneau plat, des systèmes d'éclairage blanc à panneau plat, des systèmes flexibles d'éclairage monochromatique, des systèmes flexibles d'éclairage blanc, des écrans pour applications automobiles, des écrans pour la réalité virtuelle, et des écrans pour la réalité augmentée.
